# EUROPEAN PATENT APPLICATION

(11) **EP 4 198 630 A1**
(43) Date of publication of application: **21.06.2023**
(21) Application number: 22214424.8
(22) Date of filing: 19.12.2022
(51) Int. Cl.: G03F 7/039

(54) **CHEMICALLY AMPLIFIED POSITIVE RESIST COMPOSITION AND RESIST PATTERN FORMING PROCESS**

(30) Priority: 20.12.2021 JP 2021206280
(71) Applicant: Shin-Etsu Chemical Co., Ltd., Tokyo (JP)
(72) Inventor: MASUNAGA, Keiichi, Joetsu-shi (JP); HATAKEYAMA, Jun, Joetsu-shi (JP); WATANABE, Satoshi, Joetsu-shi (JP); FUNATSU, Kenji, Joetsu-shi (JP); KOTAKE, Masaaki, Joetsu-shi (JP); FUKUSHIMA, Masahiro, Joetsu-shi (JP)
(74) Representative: Ter Meer Steinmeister & Partner

(57) **Abstract**

A chemically amplified positive resist composition is provided comprising a base polymer which contains a polymer comprising a phenolic hydroxy group-containing unit, a unit containing a phenolic hydroxy group protected with an acid labile group, and a unit containing a carboxy group protected with an acid labile group. The aromatic ring-containing repeat units account for at least 65 mol% of the overall repeat units of the polymer. A resist pattern with a very high resolution, reduced LER, improved rectangularity, and minimized influence of develop loading can be formed.

## Description

### CROSS-REFERENCE TO RELATED APPLICATION

This non-provisional application claims priority under 35 U.S.C. §119(a) on Patent Application No. 2021-206280 filed in Japan on December 20, 2021, the entire contents of which are hereby incorporated by reference.

### TECHNICAL FIELD

This invention relates to a chemically amplified positive resist composition and a resist pattern forming process using the same.

### BACKGROUND ART

To meet the recent demand for higher integration in integrated circuits, pattern formation to a smaller feature size is required. Acid-catalyzed chemically amplified resist compositions are most often used in forming resist patterns with a feature size of 0.2 µm or less. High-energy radiation such as UV, deep-UV, EUV or EB is used as the energy source for exposure of these resist compositions. In particular, the EB lithography, which is utilized as the ultra-fine microfabrication technique, is also indispensable in processing a photomask blank into a photomask for use in the fabrication of semiconductor devices.

In general, the EB lithography is by writing an image with EB, without using a mask. In the case of positive resist, those regions of a resist film other than the regions to be retained are successively irradiated with EB having a minute area. In the case of negative resist, those regions of a resist film to be retained are successively irradiated with EB. The operation of successively scanning all finely divided regions on the work surface takes a long time as compared with full wafer exposure through a photomask. To prevent any throughput decline, a resist film having a high sensitivity is required. One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. A low line edge roughness (LER) is another important performance factor.

The control of resist sensitivity and pattern profile as mentioned above has been improved by a proper selection and combination of resist material-constituting components and processing conditions. One improvement is directed to the diffusion of acid that largely affects the resolution of a resist film. In the processing of photomasks, it is required that the profile of a resist pattern formed as above do not change with a lapse of time from the end of exposure to PEB. The major cause of such a change with time is diffusion of an acid generated upon exposure. The problem of acid diffusion has been widely studied not only in terms of photomask processing, but also in terms of general resist compositions because the acid diffusion has a significant impact on sensitivity and resolution.

Patent Documents 1 and 2 describe acid generators capable of generating bulky acids for controlling acid diffusion and reducing LER. Since these acid generators are still insufficient to control acid diffusion, it is desired to have an acid generator with more controlled diffusion.

Patent Document 3 discloses a resist composition comprising a base polymer having bound thereto an acid generator capable of generating a sulfonic acid upon light exposure whereby acid diffusion is controlled. This approach of controlling acid diffusion by binding repeat units capable of generating acid upon exposure to a base polymer is effective in forming a pattern with reduced LER. However, the base polymer having bound therein repeat units capable of generating acid upon exposure encounters a problem with respect to its solubility in organic solvent, depending on the structure and proportion of the relevant units.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography since they exhibit strong absorption at a wavelength of around 200 nm. These polymers, however, are expected to form useful resist materials for the EB and EUV lithography for forming patterns of smaller size than the processing limit of ArF excimer laser because they offer high etching resistance.

Often used as the base polymer in positive resist compositions for EB and EUV lithography is a polymer having an acidic functional group on phenol side chain masked with an acid labile group. Upon exposure to high-energy radiation, the acid labile group is deprotected by the catalysis of an acid generated from a photoacid generator so that the polymer may turn soluble in alkaline developer. Typical of the acid labile group are tertiary alkyl, tert-butoxycarbonyl, and acetal groups. The use of acid labile groups (e.g., acetal groups) requiring a relatively low level of activation energy for deprotection offers the advantage that a resist film having a high sensitivity is obtainable. However, if the diffusion of generated acid is not fully controlled, deprotection reaction can occur even in the unexposed region of the resist film, giving rise to problems like degradations of resolution and LER.

It is known that a develop loading phenomenon arises in the development step of the photomask fabrication process. That is, the finish size of pattern features differs between a grouped region and an isolated region on a photomask. Due to the develop loading, the distribution of pattern finish size becomes non-uniform depending on the surrounding pattern feature distribution. This is caused by a difference in elimination reaction during acid generation due to an energy difference of EB and a difference of dissolution rate in alkaline developer between grouped and isolated images. As one solution, Patent Document 4 discloses a beam dose computing method of an EB writing apparatus comprising the steps of adjusting an input dose in the EB writing apparatus so as to correct develop loading effects, and irradiating EB in the adjusted dose for thereby writing a pattern on a photomask. However, since the prior art correcting method has not fully taken into account the develop loading phenomenon for correction, the accuracy of correcting develop loading effects is not so high. To solve such problems, Patent Document 5 discloses an imaging method and Patent Document 6 discloses a method of improving a development mode after patterning. These methods are insufficient for establishing a uniform distribution of grouped and isolated features in the advanced generation of lithography. An improvement in resist compositions is desired.

### Citation List

Patent Document 1: JP-A 2009-053518
Patent Document 2: JP-A 2010-100604
Patent Document 3: JP-A 2011-022564
Patent Document 4: JP-A 2007-150243 (USP 7,740,991)
Patent Document 5: JP 5443548
Patent Document 6: JP 6281244

### SUMMARY OF INVENTION

An object of the invention is to provide a chemically amplified positive resist composition which is lithographically processed into a resist pattern with a very high resolution, reduced LER, improved rectangularity, and minimized influence of develop loading, and a pattern forming process using the same.

The inventors have found that when a base polymer of specific structure is blended in a resist composition, a resist pattern with a satisfactory resolution, profile and LER can be formed while controlling the influence of develop loading.

In one aspect, the invention provides a chemically amplified positive resist composition comprising a base polymer protected with an acid labile group and adapted to turn alkali soluble under the action of acid. The base polymer contains a polymer comprising a phenolic hydroxy group-containing unit, a unit containing a phenolic hydroxy group protected with an acid labile group, and a unit containing a carboxy group protected with an acid labile group, or a polymer comprising a phenolic hydroxy group-containing unit and a unit containing a phenolic hydroxy group protected with an acid labile group and a polymer comprising a phenolic hydroxy group-containing unit and a unit containing a carboxy group protected with an acid labile group. The phenolic hydroxy group-containing unit is a repeat unit having the following formula (A1), the unit containing a phenolic hydroxy group protected with an acid labile group is a repeat unit having the following formula (A2), and the unit containing a carboxy group protected with an acid labile group is a repeat unit having the following formula (A3). The aromatic ring-containing repeat units account for at least 65 mol% of the overall repeat units of the polymer in the base polymer. 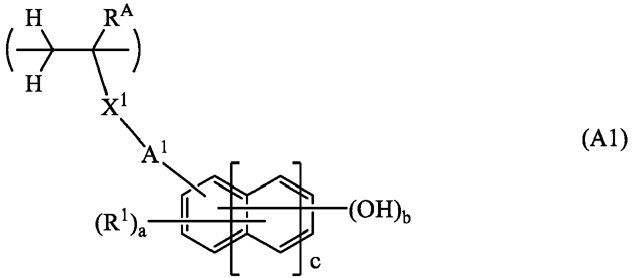
Herein a is an integer satisfying 0 ≤ a ≤ 5+2c-b, b is an integer of 1 to 3, c is an integer of 0 to 2,
   R^{A} is hydrogen, fluorine, methyl or trifluoromethyl,
   X¹ is a single bond, *-C(=O)-O- or *-C(=O)-NH-, * designates a point of attachment to the carbon atom in the backbone,
   A¹ is a single bond or a C₁-C₁₀ saturated hydrocarbylene group in which some constituent -CH₂- may be replaced by -O-,
   R¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group. 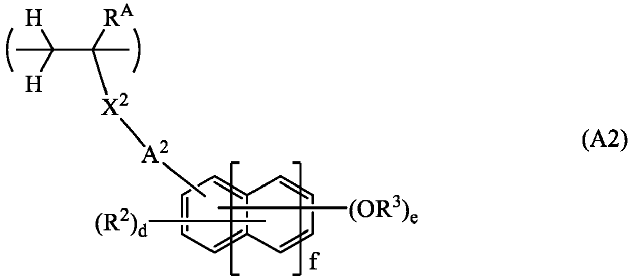
Herein R^{A} is as defined above,
   d is an integer satisfying 0 ≤ d ≤ 5+2f-e, e is an integer of 1 to 3, f is an integer of 0 to 2,
   X² is a single bond, *-C(=O)-O- or *-C(=O)-NH-, * designates a point of attachment to the carbon atom in the backbone,
   A² is a single bond or a C₁-C₁₀ saturated hydrocarbylene group in which some constituent -CH₂- may be replaced by -O-,
   R² is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
   R³ is an acid labile group when e is 1, or hydrogen or an acid labile group, at least one R³ being an acid labile group, when e is 2 or 3. 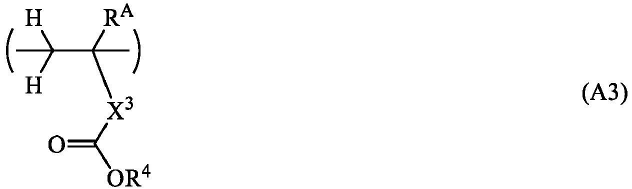
Herein R^{A} is as defined above,
   X³ is a single bond, phenylene group, naphthylene group or ^{∗}-C(=O)-O-X^{3A}-, wherein X^{3A} is a C₁-C₂₀ saturated hydrocarbylene group which may contain a hydroxy moiety, ether bond, ester bond or lactone ring, or a phenylene or naphthylene group, * designates a point of attachment to the carbon atom in the backbone, and
   R⁴ is an acid labile group.

In a preferred embodiment, the phenolic hydroxy group-containing unit is a repeat unit having the following formula (A1-1): 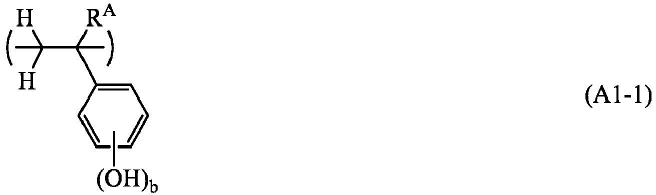 wherein R' and b are as defined above.

In a preferred embodiment, the unit containing a phenolic hydroxy group protected with an acid labile group is a repeat unit having the following formula (A2-1): 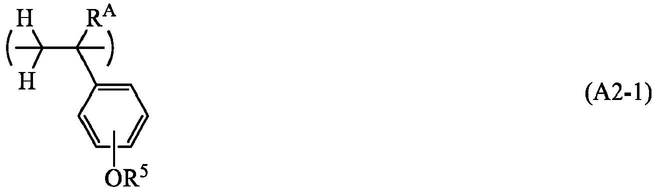 wherein R^{A} is as defined above, and R⁵ is an acid labile group having a C₆-C₂₀ aromatic hydrocarbon moiety and/or C₅-C₂₀ alicyclic hydrocarbon moiety.

In a preferred embodiment, the unit containing a carboxy group protected with an acid labile group is a repeat unit having the following formula (A3-1): 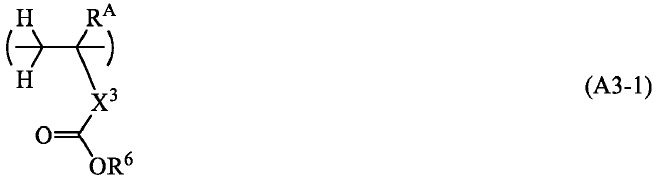 wherein R^{A} and X³ are as defined above, and R⁶ is an acid labile group having a C₆-C₂₀ aromatic hydrocarbon moiety and/or C₅-C₂₀ alicyclic hydrocarbon moiety.

In a preferred embodiment, the unit containing a carboxy group protected with an acid labile group is a repeat unit having the following formula (A3-2): 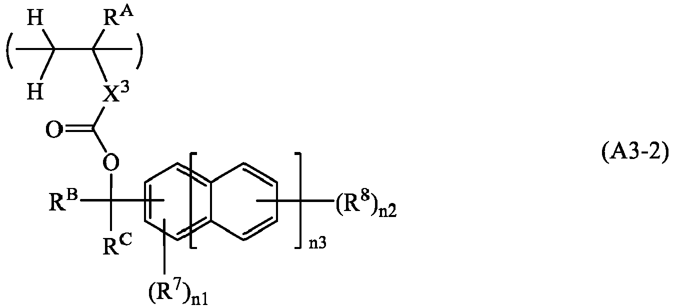 wherein R^{A} and X³ are as defined above, R^{B} and R^{C} are each independently a C₁-C₁₀ hydrocarbyl group which may contain a heteroatom, R^{B} and R^{C} may bond together to form a ring with the carbon atom to which they are attached, R' is each independently fluorine, a C₁-C₅ fluorinated alkyl group or C₁-C₅ fluorinated alkoxy group, R⁸ is each independently a C₁-C₁₀ hydrocarbyl group which may contain a heteroatom, n1 is 1 or 2, n2 is an integer of 0 to 5, and n3 is an integer of 0 to 2.

In a preferred embodiment, the repeat unit having formula (A3-2) has the following formula (A3-3): 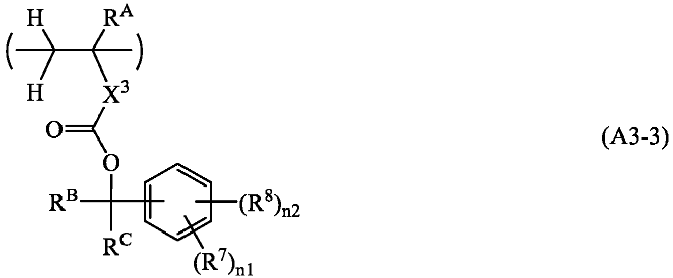 wherein R^{A}, R^{B}, R^{C}, X³, R⁷, R⁸, n1 and n2 are as defined above.

More preferably, R⁷ is fluorine, trifluoromethyl or trifluoromethoxy.

In a preferred embodiment, the polymer in the base polymer further comprises a repeat unit having any one of the following formulae (B 1) to (B3). 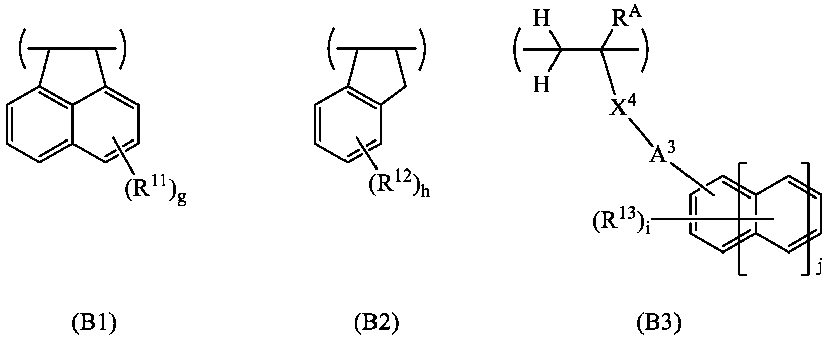 Herein R^{A} is as defined above,
g and h are each independently an integer of 0 to 4, i is an integer of 0 to 5, j is an integer of 0 to 2,
R¹¹ and R¹² are each independently a hydroxy group, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group,
R¹³ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group, R¹³ may also be hydroxy when j is 1 or 2,
X⁴ is a single bond, ^{∗}-C(=O)-O- or ^{∗}-C(=O)-NH-, ^{∗} designates a point of attachment to the carbon atom in the backbone,
A³ is a single bond or a C₁-C₁₀ saturated hydrocarbylene group in which some constituent -CH₂- may be replaced by -O-.

More preferably, the total of the repeat unit having formula (A1) and the repeat unit having any one of formulae (B1) to (B3) is at least 50 mol% of the overall repeat units of the polymer in said base polymer.

In a preferred embodiment, the positive resist composition further comprises a fluorinated polymer comprising repeat units of at least one type selected from repeat units having the following formula (C1), repeat units having the following formula (C2), repeat units having the following formula (C3), and repeat units having the following formula (C4) and optionally repeat units of at least one type selected from repeat units having the following formula (C5) and repeat units having the following formula (C6). 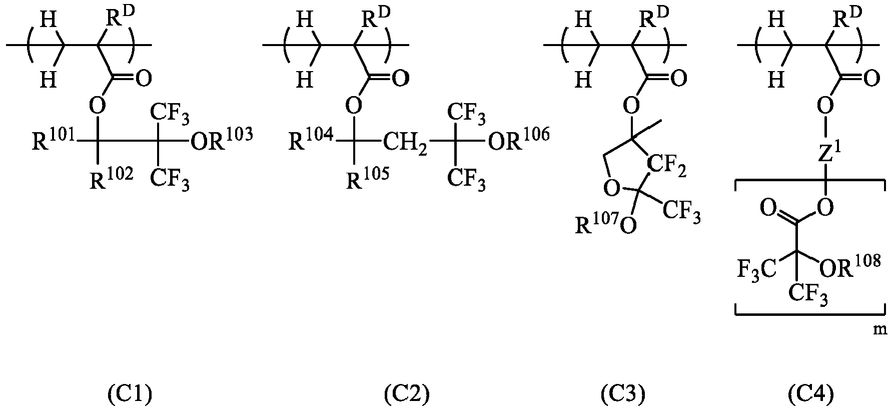 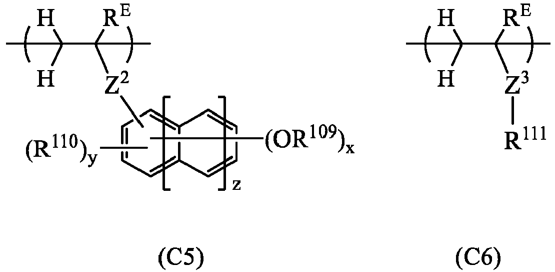 Herein R^{D} is each independently hydrogen, fluorine, methyl or trifluoromethyl,
R^{E} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen atom is substituted by fluorine and in which some constituent -CH₂- may be replaced by an ester bond or ether bond,
x is an integer of 1 to 3, y is an integer satisfying 0 ≤ y ≤ 5+2z-x, z is 0 or 1, m is an integer of 1 to 3,
Z¹ is a C₁-C₂₀ (m+1)-valent hydrocarbon group or C₁-C₂₀ (m+1)-valent fluorinated hydrocarbon group,
Z² is a single bond, ^{∗}-C(=O)-O- or ^{∗}-C(=O)-NH-, ^{∗} designates a point of attachment to the carbon atom in the backbone,
Z³ is a single bond, -O-, ^{∗}-C(=O)-O-Z³¹-Z³²- or ^{∗}-C(=O)-NH-Z³¹-Z³²-, Z³¹ is a single bond or a C₁-C₁₀ saturated hydrocarbylene group, Z³² is a single bond, ester bond, ether bond or sulfonamide bond, ^{∗} designates a point of attachment to the carbon atom in the backbone.

The positive resist composition may further comprise an organic solvent and/or a photoacid generator.

Preferably, the photoacid generator contains an anion having an acid strength pKa of -2.0 or more.

In a preferred embodiment, a resist film formed of the composition has a dissolution rate of at least 50 nm/sec in an over-exposed region.

In another aspect, the invention provides a resist pattern forming process comprising the steps of:
applying the chemically amplified positive resist composition defined herein onto a substrate to form a resist film thereon,
exposing the resist film patternwise to high-energy radiation, and
developing the exposed resist film in an alkaline developer.

Typically, the high-energy radiation is EUV or EB.

In a preferred embodiment, the substrate has the outermost surface of a material containing at least one element selected from chromium, silicon, tantalum, molybdenum, cobalt, nickel, tungsten, and tin. The substrate is typically a photomask blank.

In a further aspect, the invention provides a photomask blank which is coated with the chemically amplified positive resist composition defined herein.

### ADVANTAGEOUS EFFECTS OF INVENTION

The chemically amplified positive resist composition can be processed to form a resist pattern of good rectangular profile with a high resolution and reduced LER while controlling the influence of develop loading. It is thus suited as a resist composition for forming a resist film which is sensitive to high-energy radiation such as UV, deep UV, EB, EUV, X-ray, γ-ray or synchrotron radiation and useful in the processing of semiconductor substrates and photomask blanks. The pattern forming process using the positive resist composition can form a resist pattern with a high resolution, reduced LER, etch resistance, and controlled influence of develop loading and is thus best suited in the micropatterning technology, typically EUV or EB lithography.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. The terms "group" and "moiety" are interchangeable. In chemical formulae, the broken line designates a valence bond.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator
LER: line edge roughness
CDU: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

The high-energy radiation encompasses UV, deep UV, EB, EUV, X-ray, γ-ray and synchrotron radiation.

### Positive resist composition

One embodiment of the invention is a chemically amplified positive resist composition comprising a base polymer which is protected with an acid labile group and adapted to turn alkali soluble under the action of acid.

The base polymer contains a polymer comprising a phenolic hydroxy group-containing unit, a unit containing a phenolic hydroxy group protected with an acid labile group, and a unit containing a carboxy group protected with an acid labile group; or a polymer comprising a phenolic hydroxy group-containing unit and a unit containing a phenolic hydroxy group protected with an acid labile group and a polymer comprising a phenolic hydroxy group-containing unit and a unit containing a carboxy group protected with an acid labile group.

The phenolic hydroxy group-containing unit is a repeat unit having the following formula (A1), which is also referred to as repeat unit A1, hereinafter.

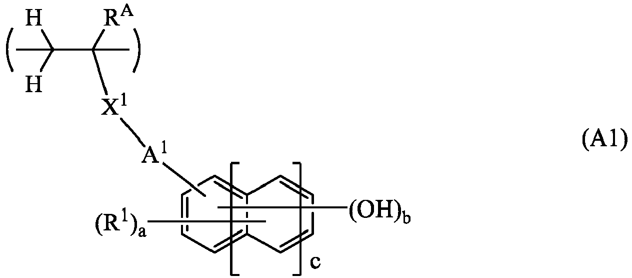

In formula (A1), "a" is an integer satisfying 0 ≤ a ≤ 5+2c-b, "b" is an integer of 1 to 3, "c" is an integer of 0 to 2.

In formula (A1), R^{A} is hydrogen, fluorine, methyl or trifluoromethyl,

In formula (A1), X¹ is a single bond, *-C(=O)-O- or *-C(=O)-NH-. The asterisk (*) designates a point of attachment to the carbon atom in the backbone.

In formula (A1), A¹ is a single bond or a C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof.

In formula (A1), R¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group. The saturated hydrocarbyl group and saturated hydrocarbyl moiety in the saturated hydrocarbylcarbonyloxy group and saturated hydrocarbyloxy group may be straight, branched or cyclic, and examples thereof include alkyl groups such as methyl, ethyl, n-propyl, isopropyl, butyl, pentyl, and hexyl, cycloalkyl groups such as cyclopropyl, cyclobutyl, cyclopentyl and cyclohexyl, and combinations thereof. A carbon count within the upper limit ensures good solubility in alkaline developer. Groups R¹ may be identical or different when "a" is 2 or more.

Preferred examples of the repeat unit A1 wherein both X¹ and A¹ are a single bond include units derived from 3-hydroxystyrene, 4-hydroxystyrene, 5-hydroxy-2-vinylnaphthalene, and 6-hydroxy-2-vinylnaphthalene. Of these, repeat units having the formula (A1-1) are more preferred. 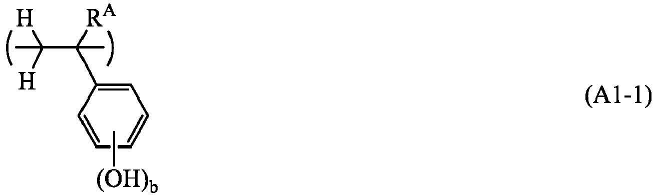 Herein R^{A} and b are as defined above.

Preferred examples of the repeat unit A1 wherein X¹ is other than a single bond are shown below, but not limited thereto. Herein R^{A} is as defined above.

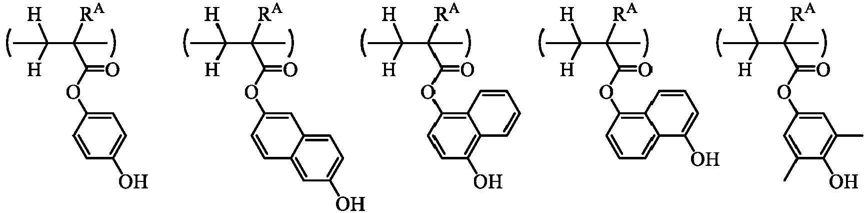

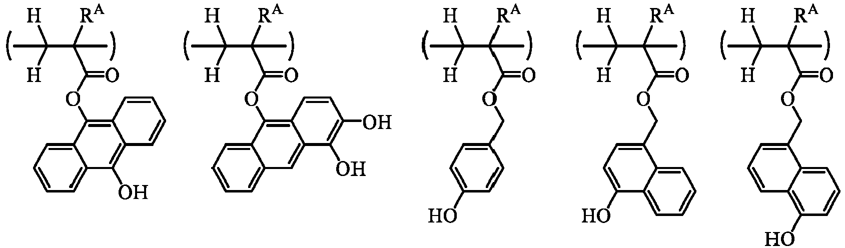

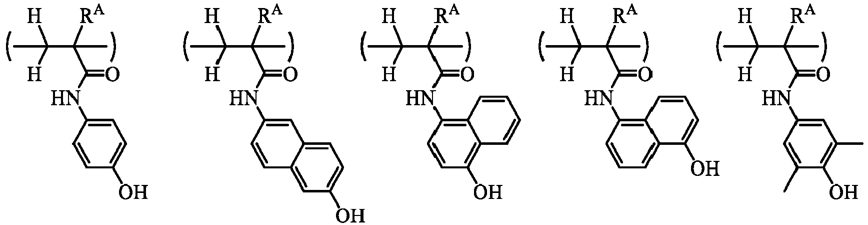

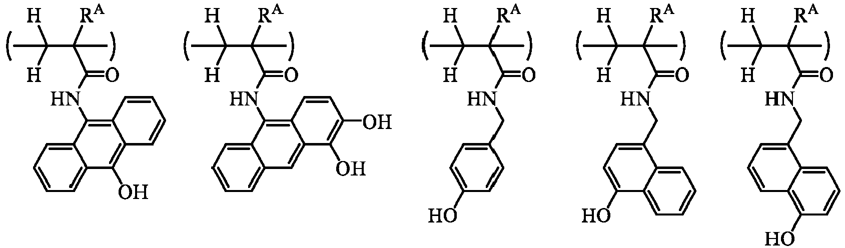

The repeat units A1 are preferably incorporated in a range of 10 to 95 mol%, more preferably 30 to 85 mol% based on the overall repeat units of the polymer in the base polymer. It is noted that when the polymer contains additional repeat units of at least one type selected from repeat units having formulae (B1) and (B2) contributing to high etching resistance, the additional repeat units having a phenolic hydroxy group as a substituent group, the sum of repeat units A1 and additional repeat units preferably falls in the above range. The repeat units A1 used herein may be of one type or a mixture of two or more types.

The unit containing a phenolic hydroxy group protected with an acid labile group is a repeat unit having the following formula (A2), also referred to as repeat unit A2, hereinafter.

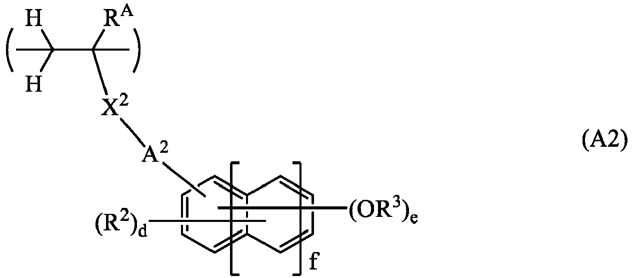

In formula (A2), R^{A} is as defined above, d is an integer satisfying 0 ≤ d ≤ 5+2f-e, e is an integer of 1 to 3, and f is an integer of 0 to 2.

In formula (A2), X² is a single bond, *-C(=O)-O- or *-C(=O)-NH-. The asterisk (*) designates a point of attachment to the carbon atom in the backbone.

In formula (A2), A² is a single bond or a C₁-C₁₀ saturated hydrocarbylene group in which any constituent -CH₂- may be replaced by -O-. The saturated hydrocarbylene group may be straight, branched or cyclic, and examples thereof are as exemplified above for A¹ in formula (A1).

In formula (A2), R² is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group. The saturated hydrocarbyl group and saturated hydrocarbyl moiety in the saturated hydrocarbylcarbonyloxy group and saturated hydrocarbyloxy group may be straight, branched or cyclic, and examples thereof are as exemplified above for R¹ in formula (A1). A carbon count within the upper limit ensures good solubility in alkaline developer. Groups R² may be identical or different when d is 2 or more.

In formula (A2), R³ is an acid labile group when e=1. R³ is hydrogen or an acid labile group, at least one being an acid labile group, when e=2 or 3.

The unit containing a carboxy group protected with an acid labile group is a repeat unit having the following formula (A3), also referred to as repeat unit A3, hereinafter.

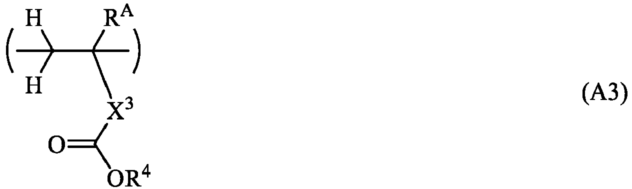

In formula (A3), R^{A} is as defined above. X³ is a single bond, phenylene group, naphthylene group or ^{∗}-C(=O)-O-X^{3A}-. X^{3A} is a C₁-C₂₀ saturated hydrocarbylene group which may contain a hydroxy moiety, ether bond, ester bond or lactone ring, or a phenylene or naphthylene group, and ^{∗} designates a point of attachment to the carbon atom in the backbone. R⁴ is an acid labile group.

The repeat unit A2 is a unit having a phenolic hydroxy group whose hydrogen is substituted by an acid labile group, preferably a unit derived from hydroxystyrene or hydroxyphenyl (meth)acrylate in which the hydrogen atom of the hydroxy group is substituted by an acid labile group. Preferred examples of the repeat unit A2 are shown below, but not limited thereto. Herein R^{A} and R³ are as defined above.

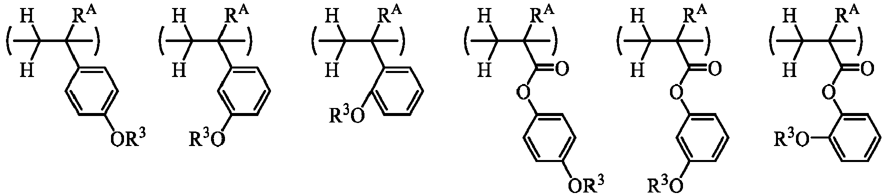

The repeat unit A3 is a unit having a carboxy group whose hydrogen is substituted by an acid labile group, preferably a (meth)acrylate unit in which the hydrogen atom of the carboxy group is substituted by an acid labile group. Preferred examples of the repeat unit A3 are shown below, but not limited thereto. Herein R^{A} and R⁴ are as defined above.

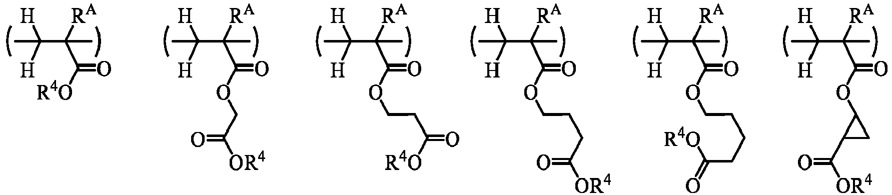

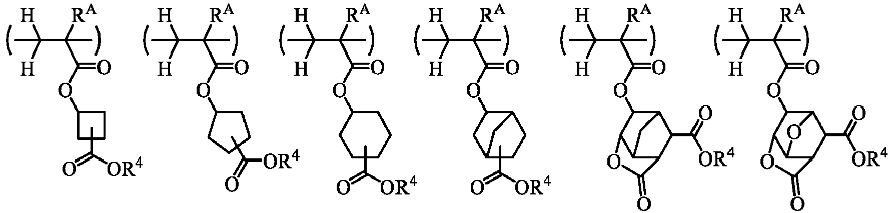

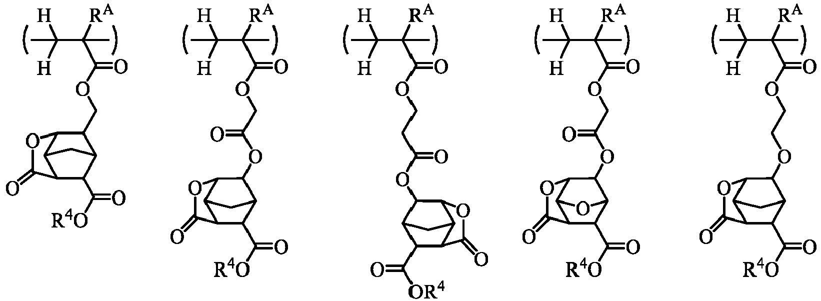

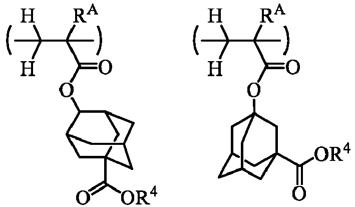

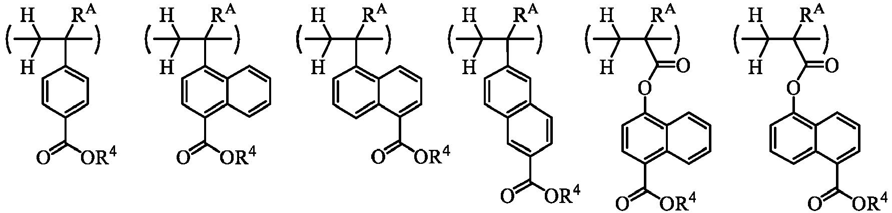

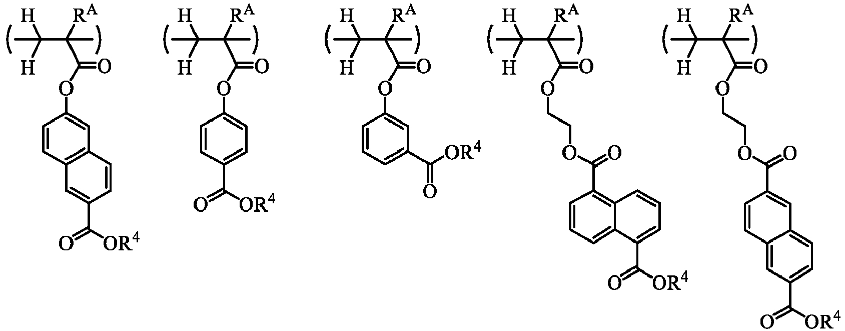

The acid labile groups R³ and R⁴ are not particularly limited as long as they are commonly used in well-known chemically amplified resist compositions and eliminated under the action of acid to restore an acidic group. Examples include those described in USP 9,164,392 (JP-A 2014-219657, paragraphs [0030]-[0082]).

Of the acid labile groups, groups having the following formulae (AL-1) to (AL-19) are preferred.

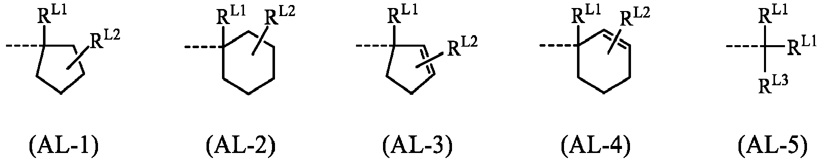

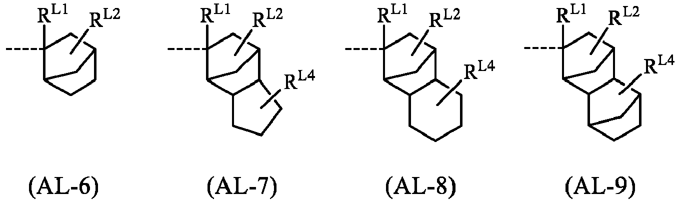

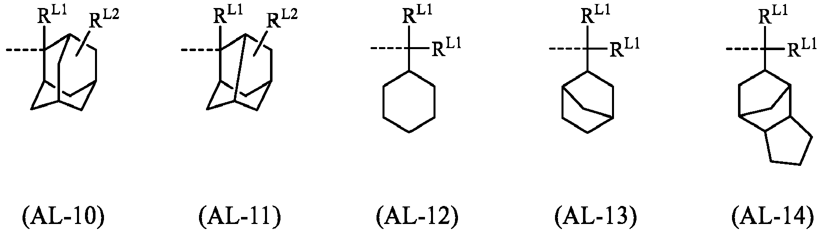

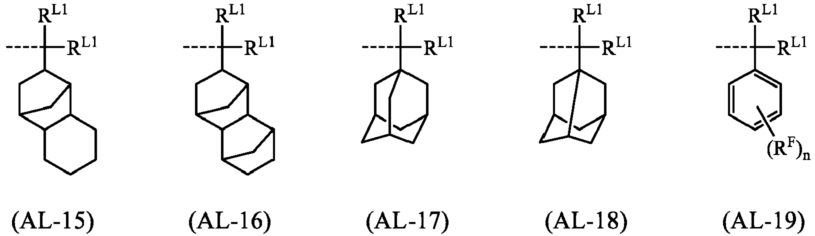

In formulae (AL-1) to (AL-19), R^{L1} is each independently a saturated hydrocarbyl group or C₆-C₂₀ aryl group. R^{L2} and R^{L4} are each independently hydrogen or a C₁-C₂₀ saturated hydrocarbyl group. R^{L3} is a C₆-C₂₀ aryl group. The saturated hydrocarbyl group may be straight, branched or cyclic. Typical of the aryl group is phenyl. R^{F} is fluorine or trifluoromethyl. The subscript n is an integer of 1 to 5. Of these groups, those groups of formulae (AL-1), (AL-2) and (AL-19) are preferred because the swell during alkaline development is controlled and the resolution is thus improved.

It is preferred to select a tertiary hydrocarbyl group as the acid labile group because a pattern with reduced LER is obtained even when a resist film is formed to a thickness of 10 to 100 nm and exposed to a small size pattern of radiation so as to provide a line width of 45 nm or less. The tertiary hydrocarbyl group is preferably of 4 to 18 carbon atoms because a monomer for polymerization is collectable through distillation. The group attached to the tertiary carbon atom in the tertiary hydrocarbyl group is typically a C₁-C₂₀ saturated hydrocarbyl group which may contain an oxygen-containing functional group such as an ether bond or carbonyl group while the groups attached to the tertiary carbon atom may bond together to form a ring.

Examples of the group attached to the tertiary carbon atom include methyl, ethyl, propyl, adamantyl, norbornyl, tetrahydrofuran-2-yl, 7-oxanorbornan-2-yl, cyclopentyl, 2-tetrahydrofuryl, tricyclo[5.2.1.0^{2,6}]decyl, tetracyclo[4.4.0.1^{2,5}.1^{7,10}]dodecyl, and 3-oxo-1-cyclohexyl.

Examples of the tertiary hydrocarbyl group include tert-butyl, tert-pentyl, 1-ethyl-1-methylpropyl, 1,1-diethylpropyl, 1,1,2-trimethylpropyl, 1-adamantyl-1-methylethyl, 1-methyl-1-(2-norbornyl)ethyl, 1-methyl-1-(tetrahydrofuran-2-yl)ethyl, 1-methyl-1-(7-oxanorbornan-2-yl)ethyl, 1-methylcyclopentyl, 1-ethylcyclopentyl, 1-propylcyclopentyl, 1-isopropylcyclopentyl, 1-cyclopentylcyclopentyl, 1-cyclohexylcyclopentyl, 1-(2-tetrahydrofuryl)cyclopentyl, 1-(7-oxanorbornan-2-yl)cyclopentyl, 1-methylcyclohexyl, 1-ethylcyclohexyl, 1-isopropylcyclohexyl, 1-cyclopentylcyclohexyl, 1-cyclohexylcyclohexyl, 2-methyl-2-norbornyl, 2-ethyl-2-norbornyl, 8-methyl-8-tricyclo[5.2.1.0^{2,6}]decyl, 8-ethyl-8-tricyclo[5.2.1.0^{2,6}]decyl, 3-methyl-3-tetracyclo[4.4.0.1^{2,5}.1^{7,10}]dodecyl, 3-ethyl-3-tetracyclo[4.4.0.1^{2,5}.1^{7,10}]dodecyl, 3-isopropyl-3-tetracyclo[4.4.0.1^{2,5}.1^{7,10}]dodecyl, 2-methyl-2-adamantyl, 2-ethyl-2-adamantyl, 2-isopropyl-2-adamantyl, 1-methyl-3-oxo-1-cyclohexyl, 1-methyl-1-(tetrahydrofuran-2-yl)ethyl, 5-hydroxy-2-methyl-2-adamantyl, 5-hydroxy-2-ethyl-2-adamantyl, and 2-(4-fluorophenyl)-2-propyl.

Also, an acetal group having the formula (AL-20) is often used as the acid labile group. It is a good choice of acid labile group that ensures to form a pattern having a relatively rectangular interface between pattern features and the substrate.

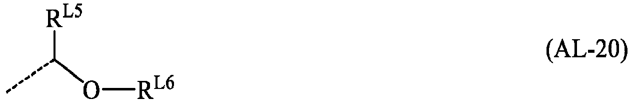

In formula (AL-20), R^{L5} is hydrogen or a C₁-C₁₀ saturated hydrocarbyl group. R^{L6} is a C₁-C₃₀ saturated hydrocarbyl group.

R^{L5} is selected in accordance with how to design the sensitivity of the labile group to acid. For example, hydrogen is selected for the design that the group having a relatively high stability is decomposed with a strong acid. A straight alkyl group is selected for the design that utilizes a relatively high reactivity to provide a high sensitivity relative to pH changes. Depending on a combination with an acid generator and a basic compound blended in a resist composition, a hydrocarbyl group in which the carbon attached to the acetal carbon is a secondary carbon atom is preferably selected as R^{L5} for the design that is substituted at an end with a relatively higher alkyl group as R^{L6} and experiences a large solubility change upon decomposition. Examples of the group R^{L5} attached to the acetal carbon via a secondary carbon atom include isopropyl, sec-butyl, cyclopentyl and cyclohexyl.

Of the acetal groups, those groups wherein R^{L6} is a C₇-C₃₀ polycyclic alkyl group are preferred in order to gain a higher resolution. When R^{L6} is a polycyclic alkyl group, it is preferred that the secondary carbon in the polycyclic structure form a bond with the acetal oxygen. A polymer relying on an attachment on the secondary carbon atom in the cyclic structure is stable as compared with an attachment on the tertiary carbon atom, ensuring that the resist composition is improved in shelf stability and not degraded in resolution. The polymer has a high glass transition temperature (Tg) as compared with the case wherein R^{L6} is attached on the primary carbon atom via a straight alkyl group of at least one carbon atom, so that the resist pattern after development may not undergo geometrical failure during bake.

Preferred examples of the group having formula (AL-20) are shown below, but not limited thereto. Herein R^{L5} is as defined above.

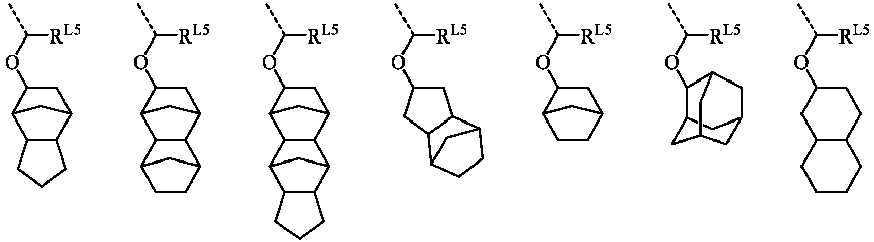

Of the repeat units A2, units having the formula (A2-1) are preferred. Of the repeat units A3, units having the formula (A3-1) are preferred.

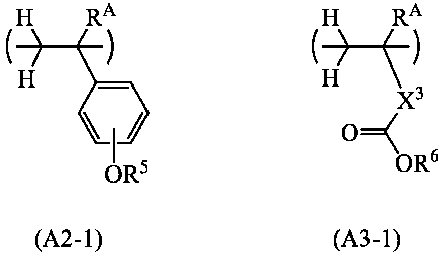

Herein R^{A} and X³ are as defined above. R⁵ and R⁶ are each independently an acid labile group having a C₆-C₂₀ aromatic hydrocarbon moiety and/or C₅-C₂₀ alicyclic hydrocarbon moiety.

Of the repeat units A3, units having the formula (A3-2) are also preferred.

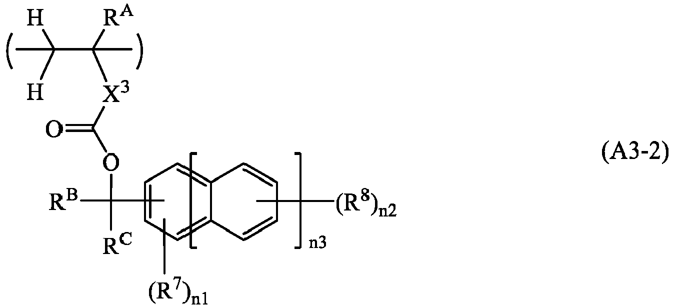

Herein R^{A} and X³ are as defined above. R^{B} and R^{C} are each independently a C₁-C₁₀ hydrocarbyl group which may contain a heteroatom. The hydrocarbyl group may be saturated or unsaturated and straight, branched or cyclic. Examples thereof include C₁-C₁₀ alkyl groups such as methyl, ethyl, n-propyl, isopropyl, n-butyl, sec-butyl, tert-butyl, 2-ethylhexyl, and n-octyl, and C₃-C₁₀ cyclic saturated hydrocarbyl groups such as cyclopentyl, cyclohexyl, norbornyl, tricyclodecanyl, and adamantyl.

R^{B} and R^{C} may bond together to form a ring with the carbon atom to which they are attached. Exemplary rings include cyclopropane, cyclobutane, cyclopentane, and cyclohexane. Of these, cyclopentane and cyclohexane are preferred.

In formula (A3-2), R⁷ is each independently fluorine, a C₁-C₅ fluorinated alkyl group or C₁-C₅ fluorinated alkoxy group. Suitable fluorinated alkyl groups include fluoromethyl, difluoromethyl, trifluoromethyl, 2,2,2-trifluoroethyl, pentafluoroethyl, pentafluoropropyl, 1,1,1,3,3,3-hexafluoro-2-propyl, and nonafluorobutyl. Suitable fluorinated alkoxy groups include fluoromethoxy, difluoromethoxy, trifluoromethoxy, 2,2,2-trifluoroethoxy, pentafluoroethoxy, pentafluoropropoxy, 1,1,1,3,3,3-hexafluoro-2-propoxy, and nonafluorobutoxy. Inter alia, R⁷ is preferably fluorine or a C₁-C₅ fluorinated alkyl group, most preferably fluorine.

In formula (A3-2), R⁸ is each independently a C₁-C₁₀ hydrocarbyl group which may contain a heteroatom. The hydrocarbyl group may be saturated or unsaturated and straight, branched or cyclic. Examples thereof are as exemplified above for the hydrocarbyl groups R^{B} and R^{C}.

In formula (A3-2), n1 is 1 or 2; n2 is an integer of 0 to 5, preferably 0 or 1; and n3 is an integer of 0 to 2. The relevant structure is a benzene ring in case of n3=0, a naphthalene ring in case of n3=1, and an anthracene ring in case of n3=2. Of these, a benzene ring with n3=0 is preferred for solvent solubility.

Of the repeat units A3-2, units having the formula (A3-3) are preferred.

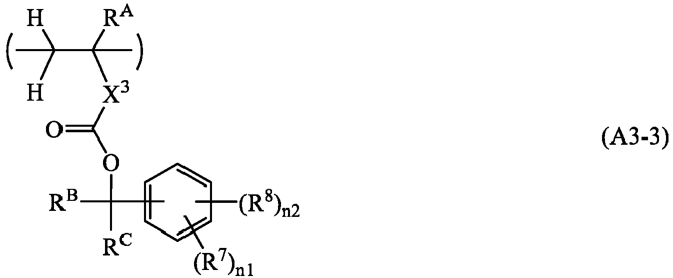

Herein R^{A}, R^{B}, R^{C}, X³, R⁷, R⁸, n1 and n2 are as defined above.

Examples of the repeat unit having formula (A3-2) are shown below, but not limited thereto. Herein R^{A} is as defined above.

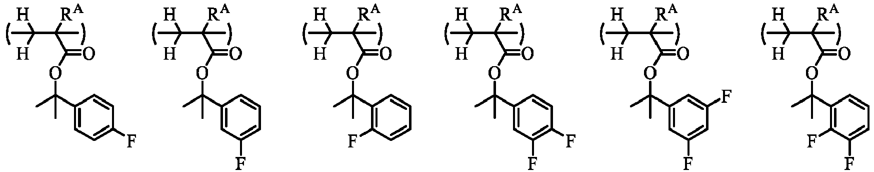

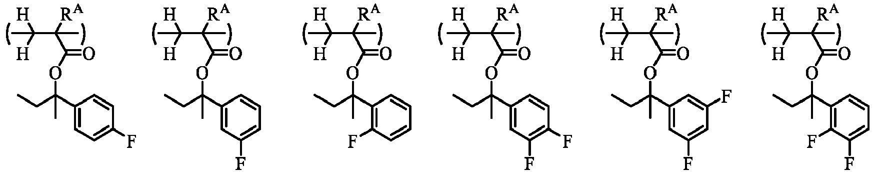

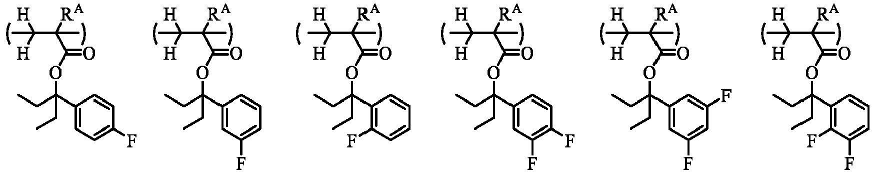

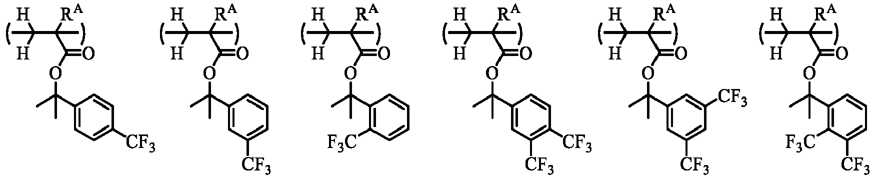

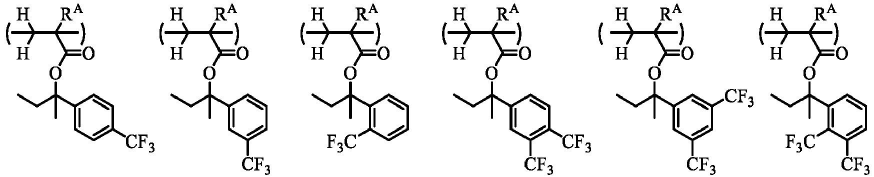

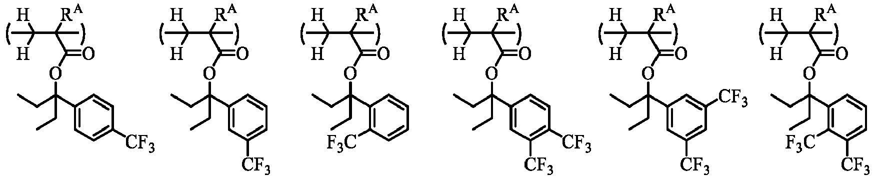

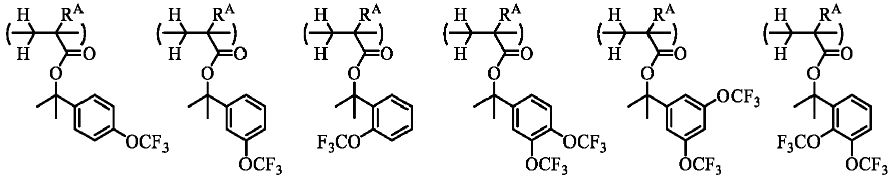

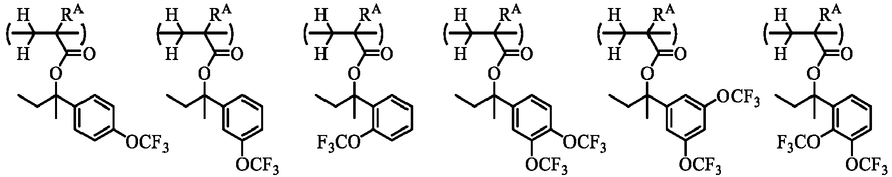

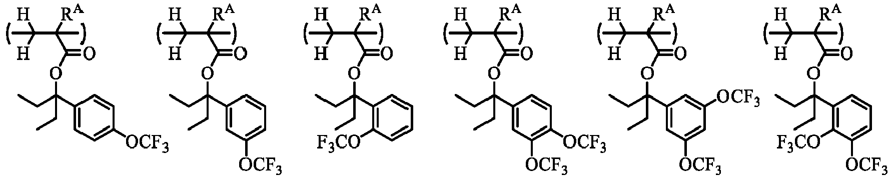

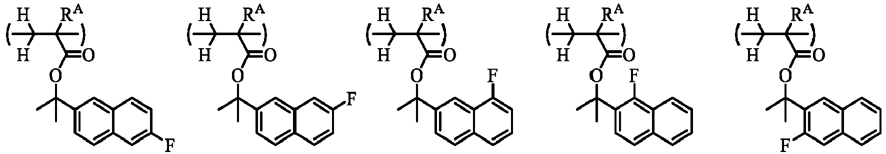

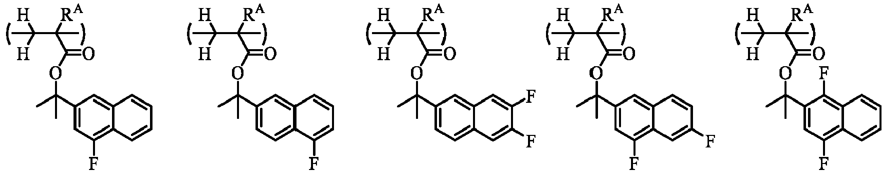

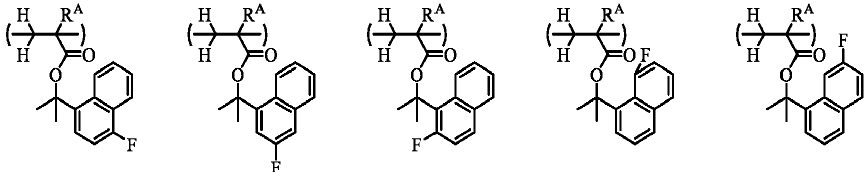

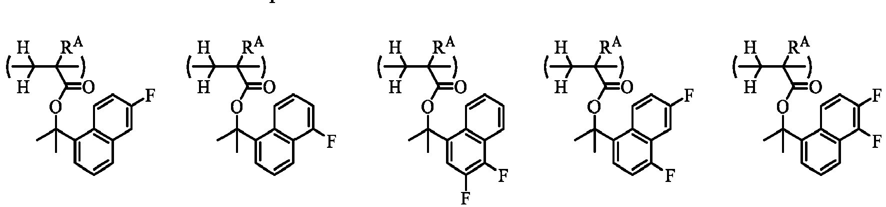

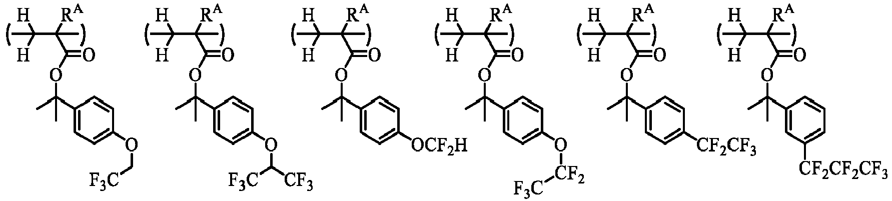

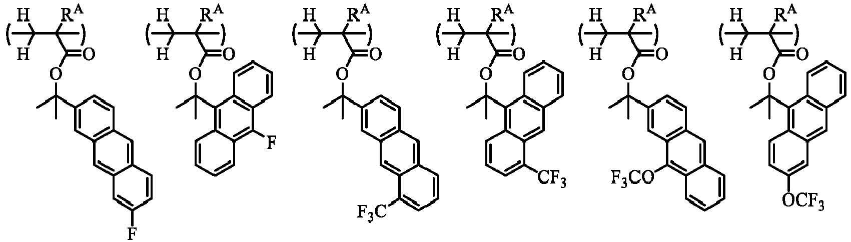

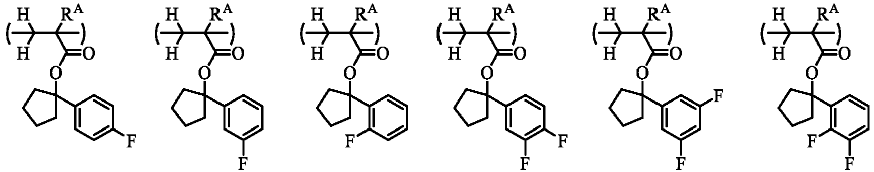

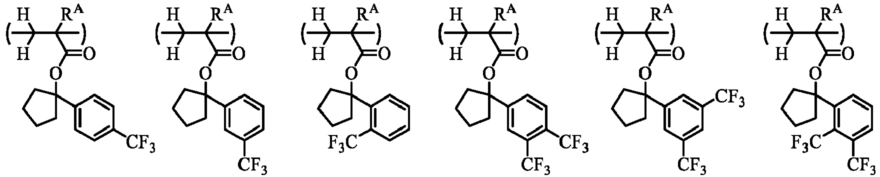

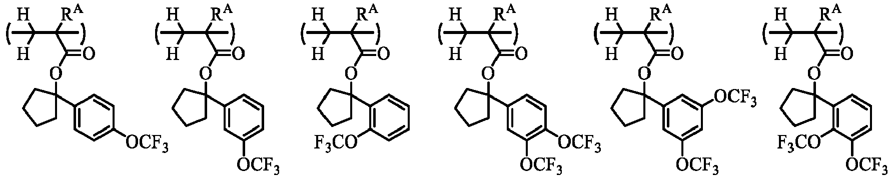

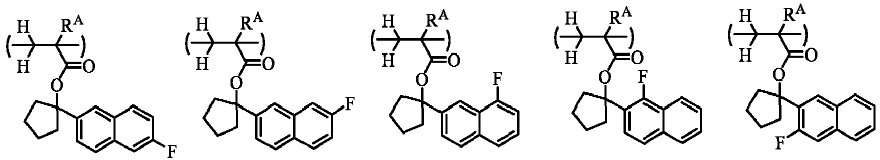

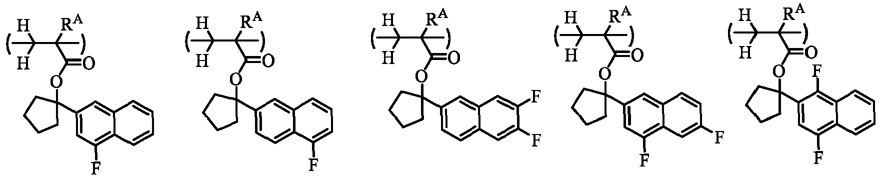

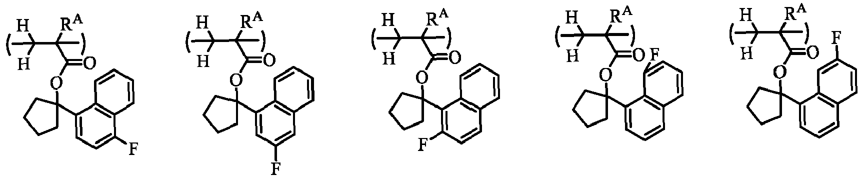

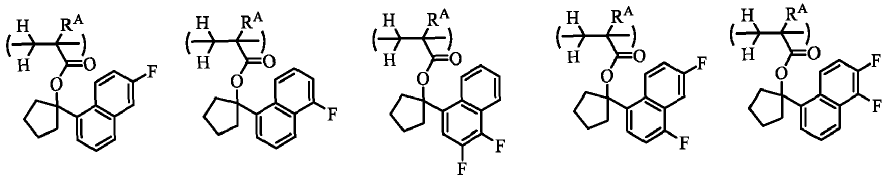

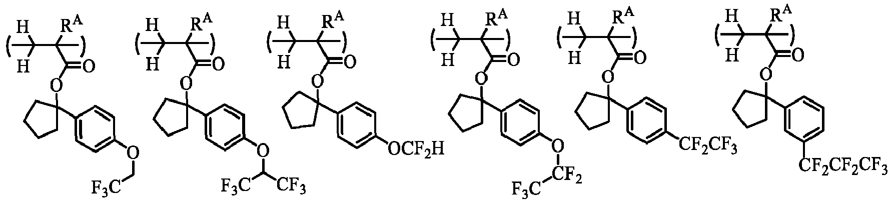

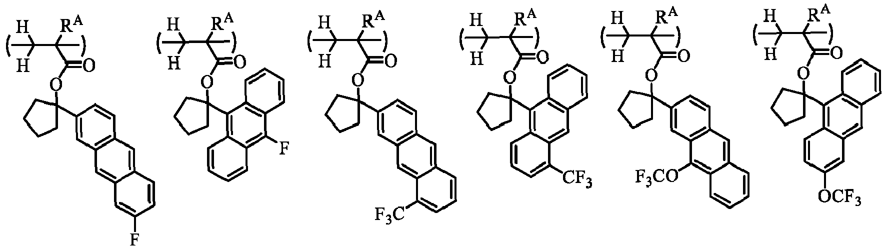

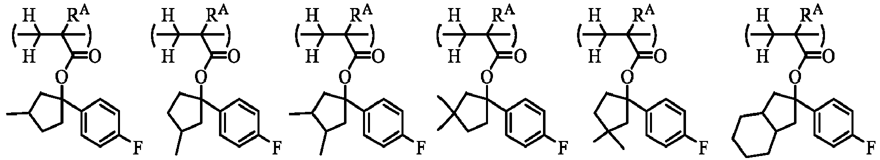

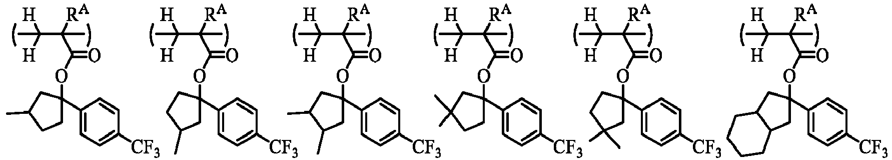

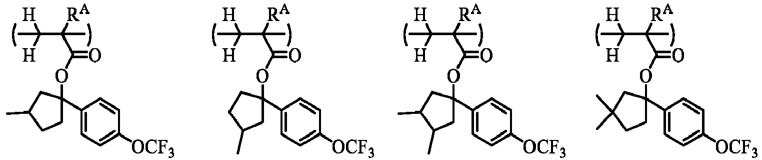

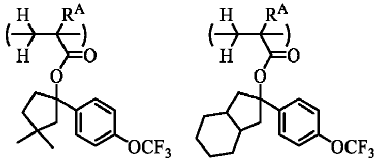

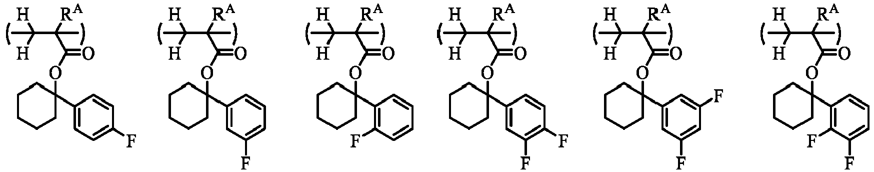

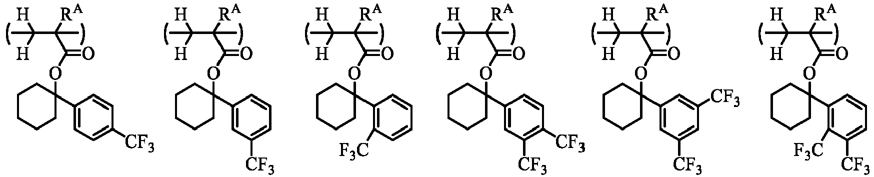

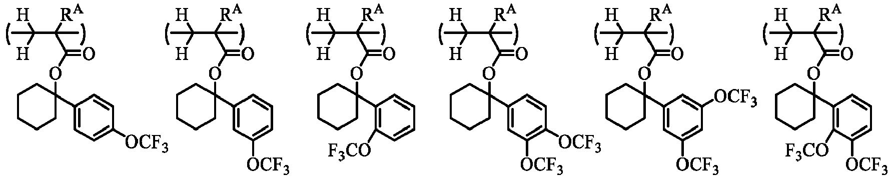

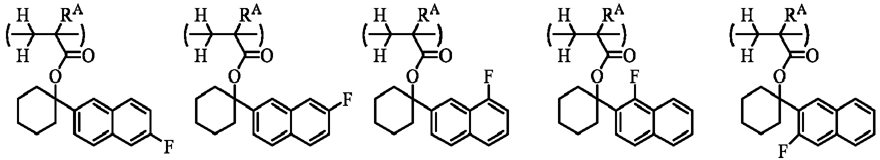

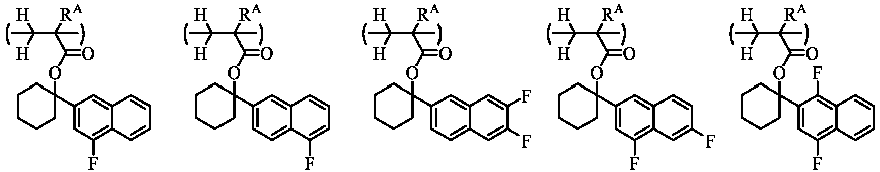

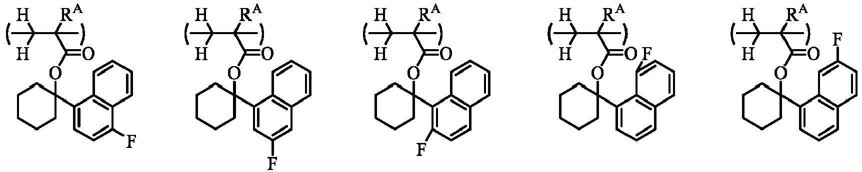

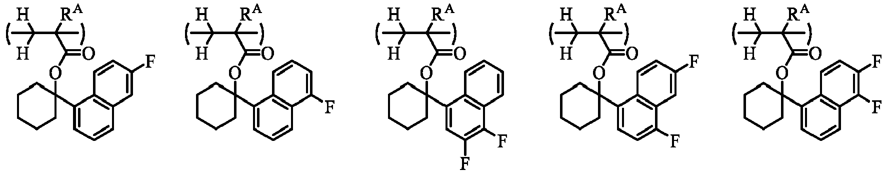

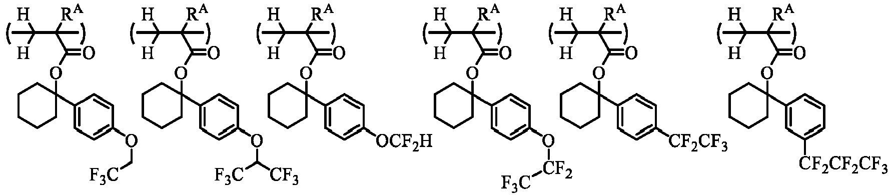

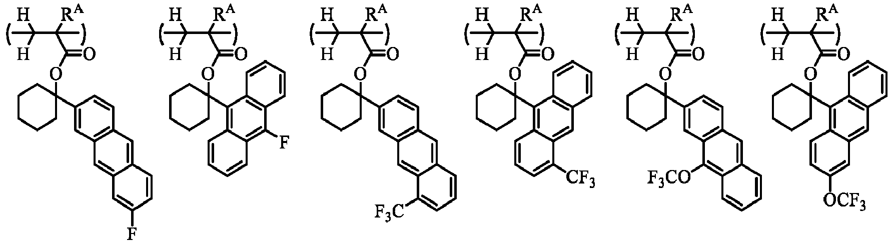

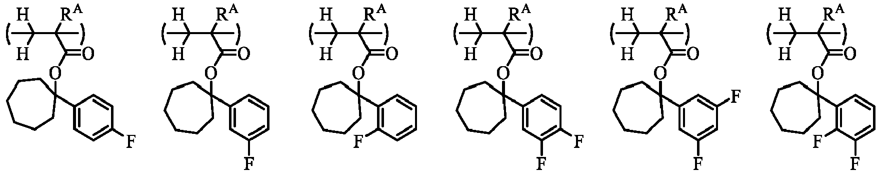

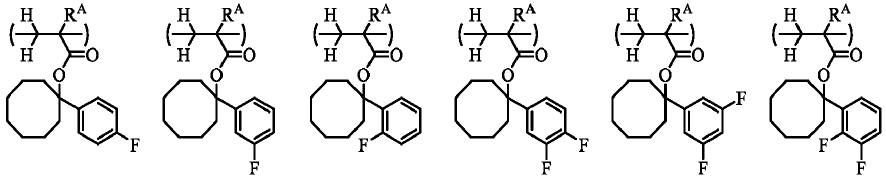

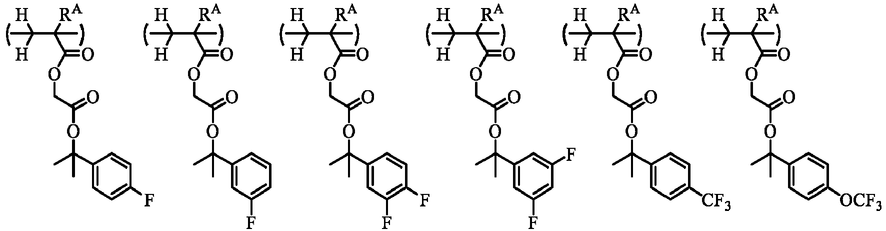

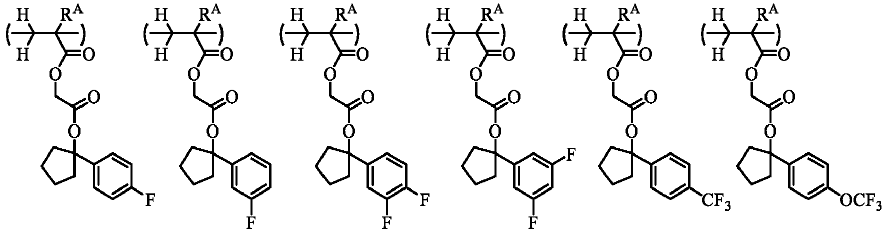

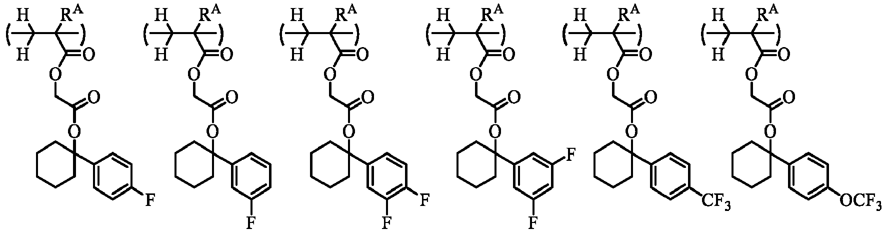

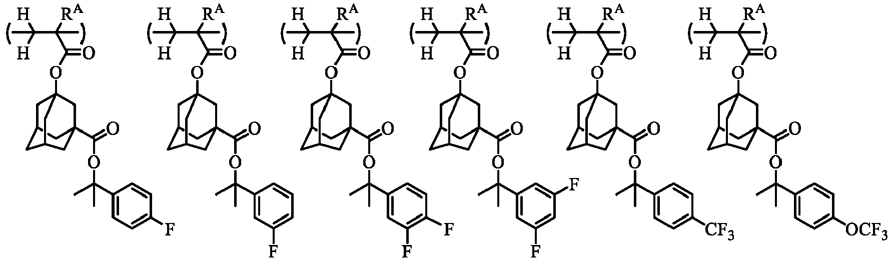

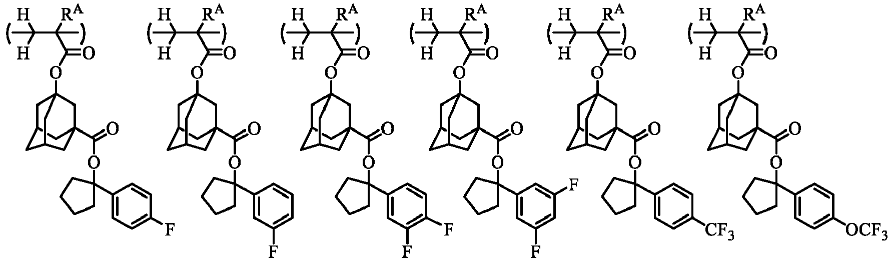

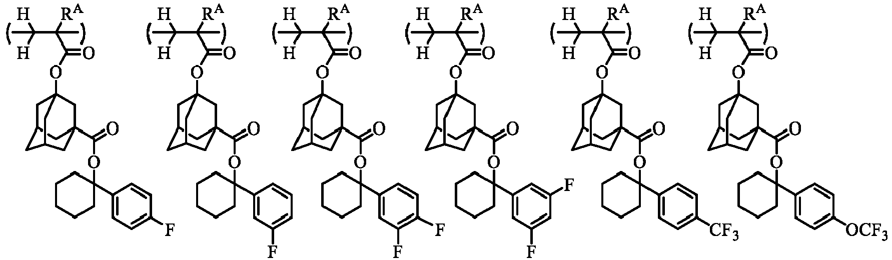

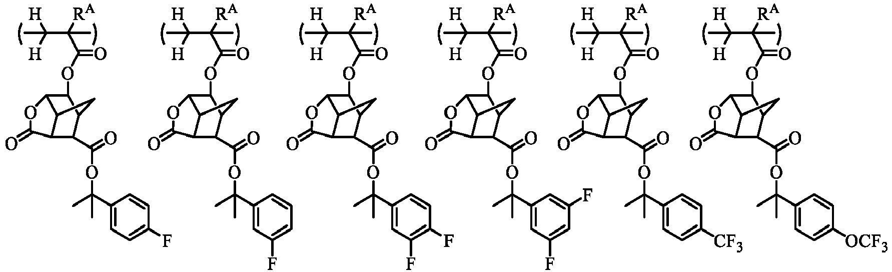

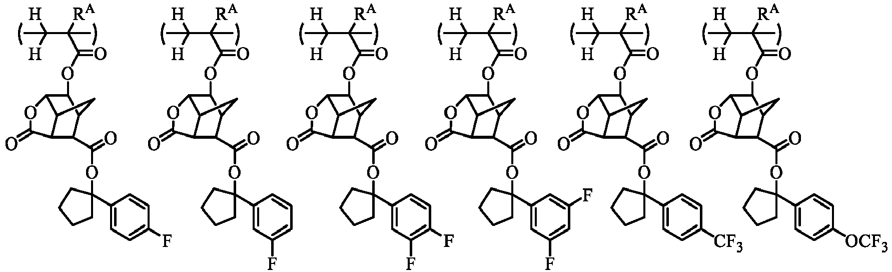

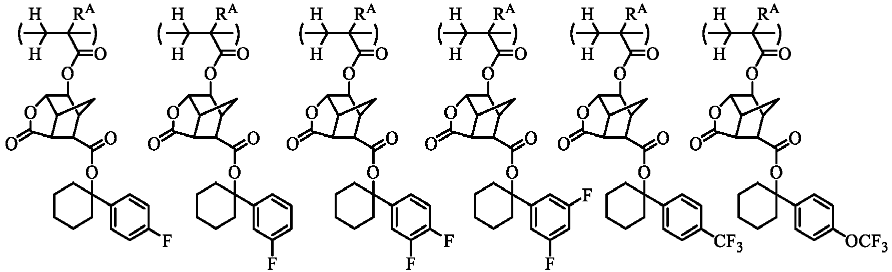

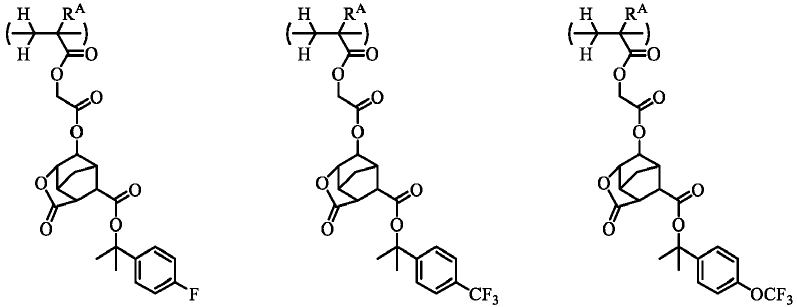

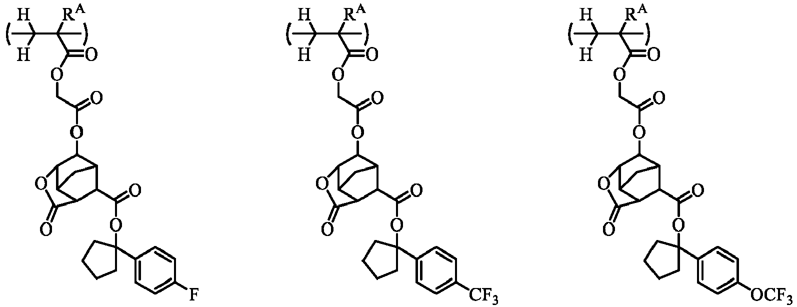

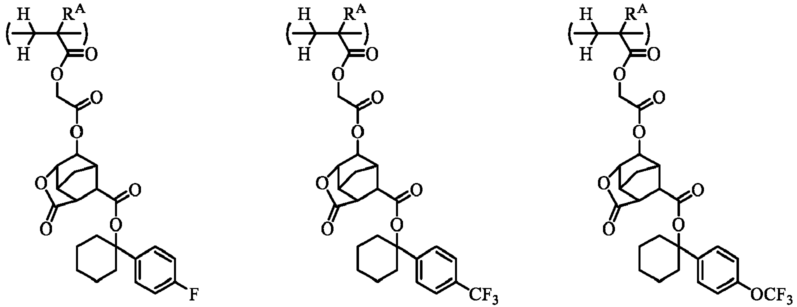

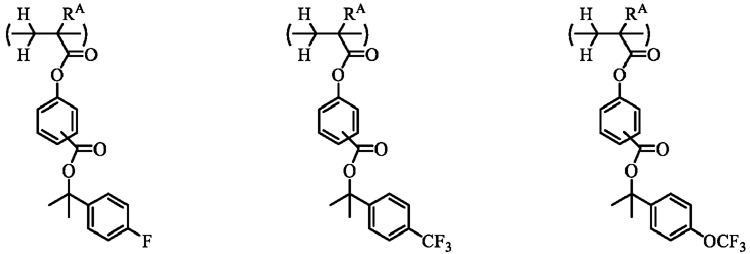

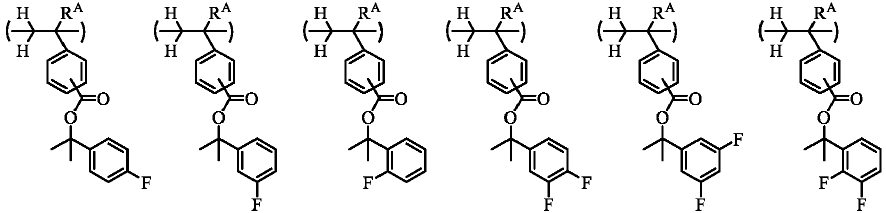

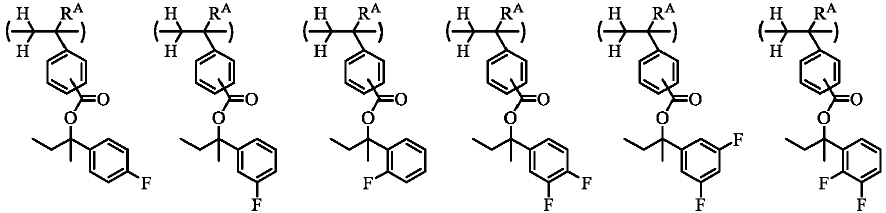

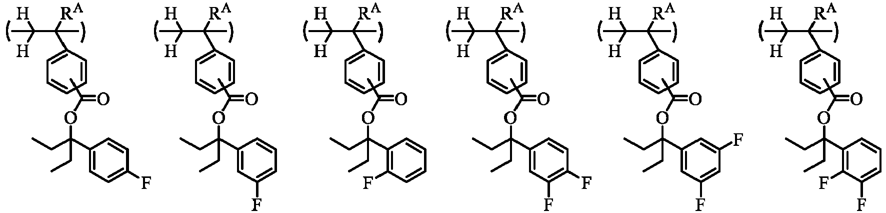

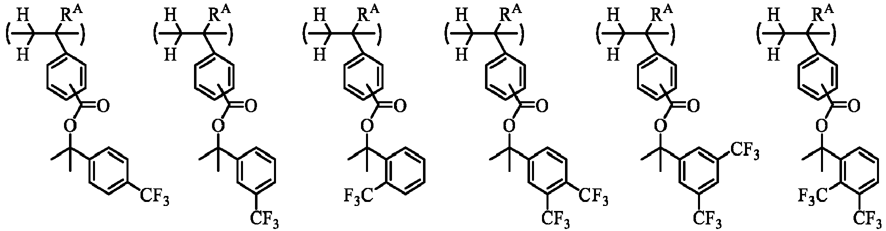

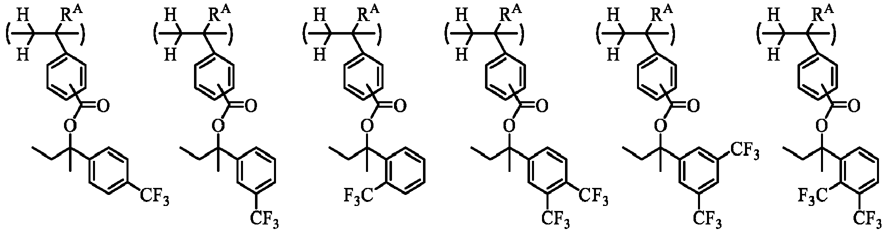

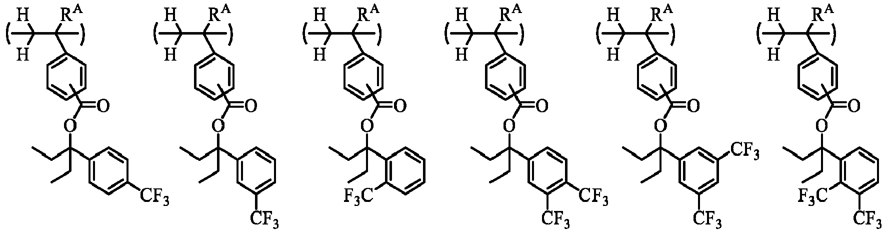

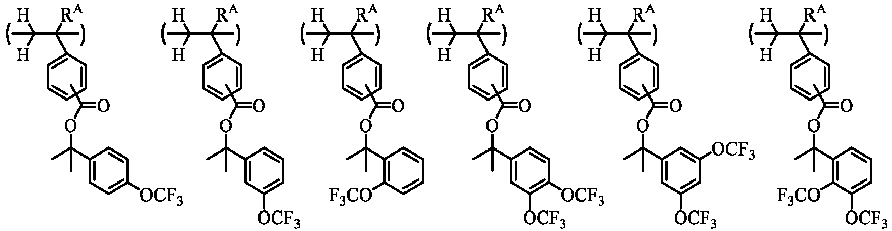

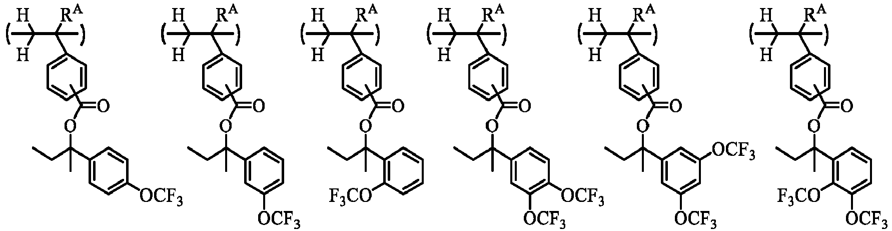

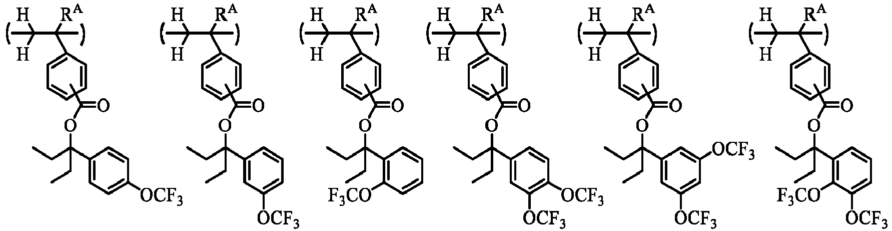

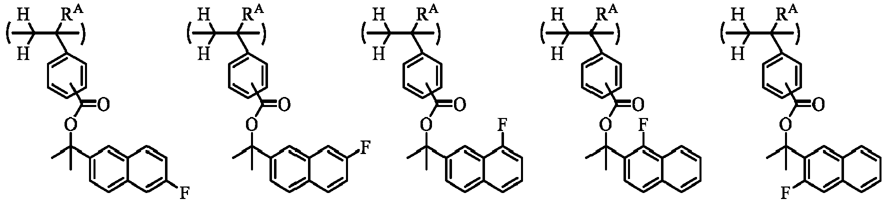

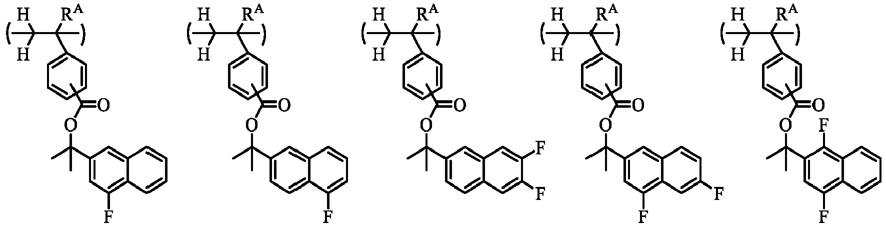

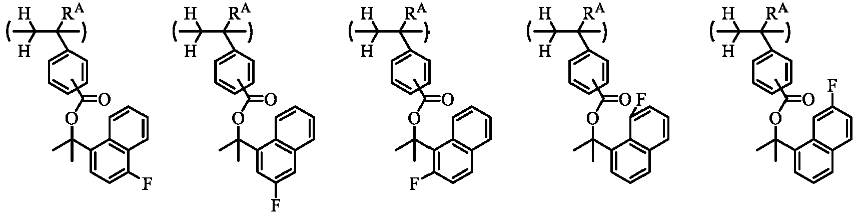

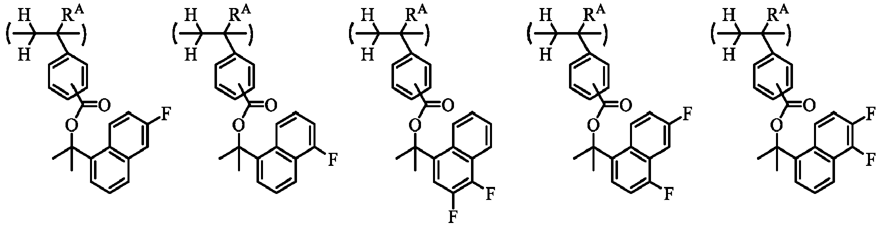

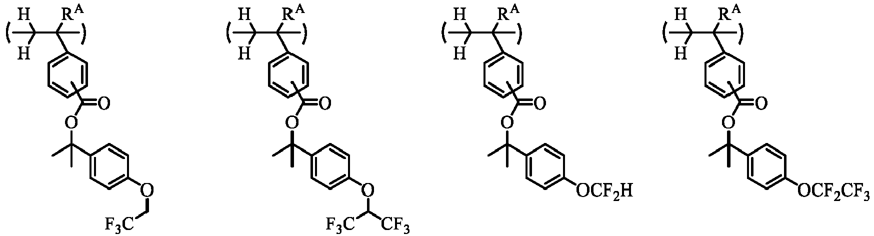

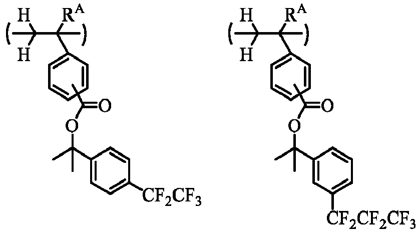

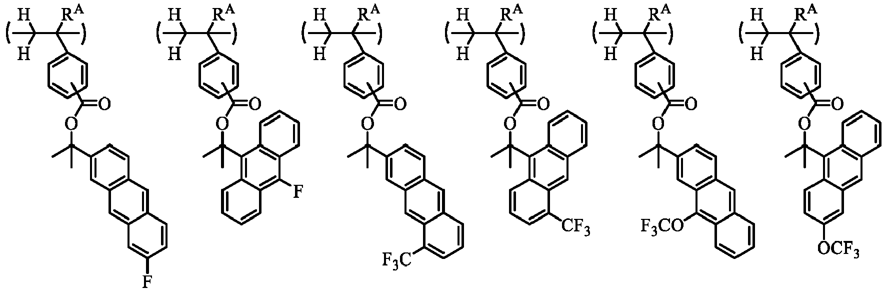

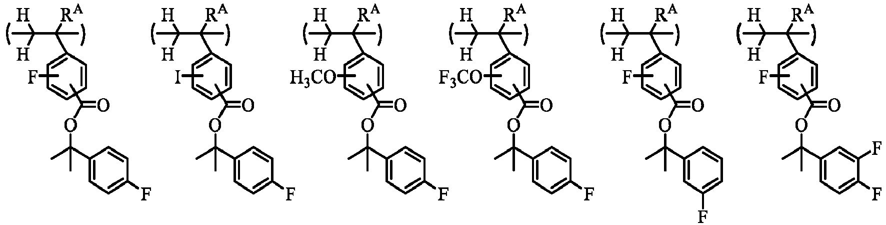

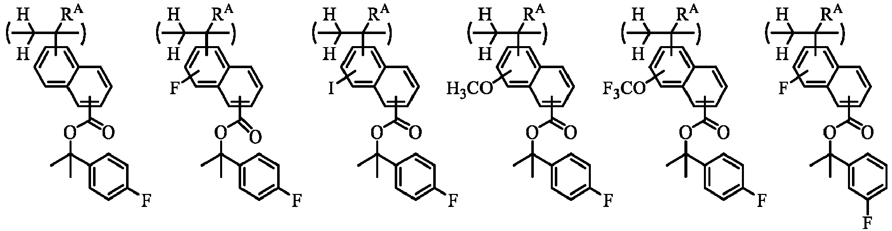

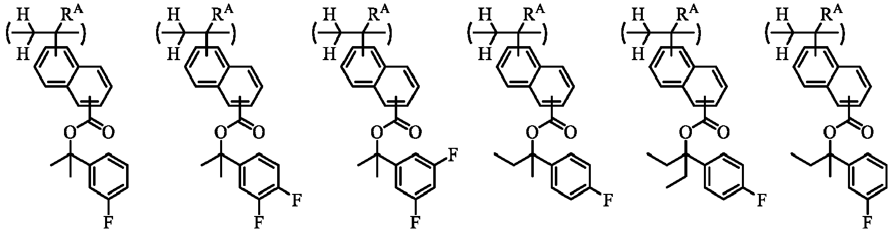

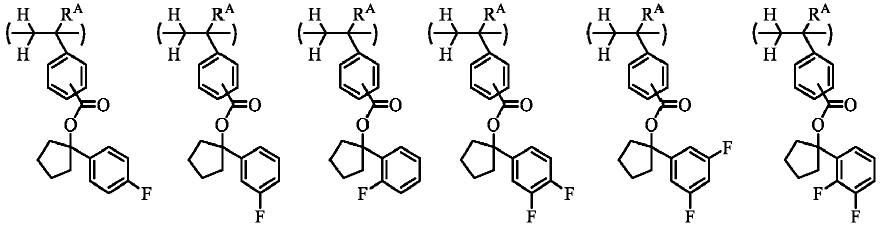

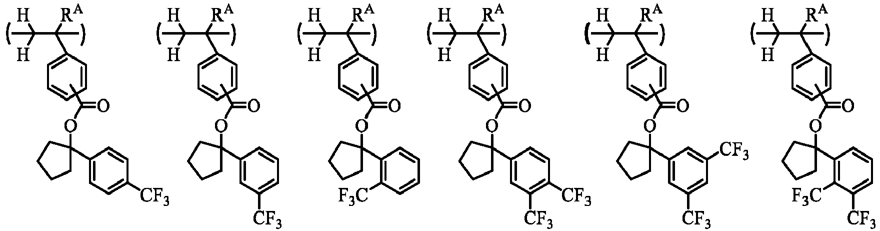

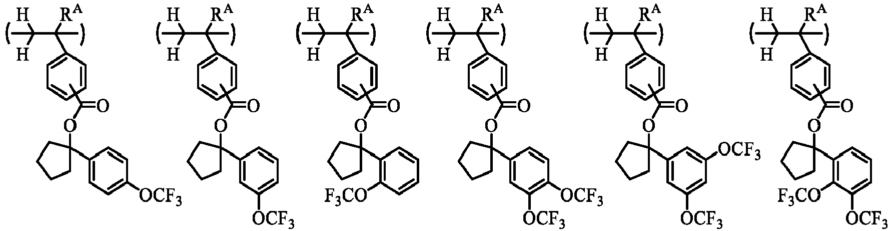

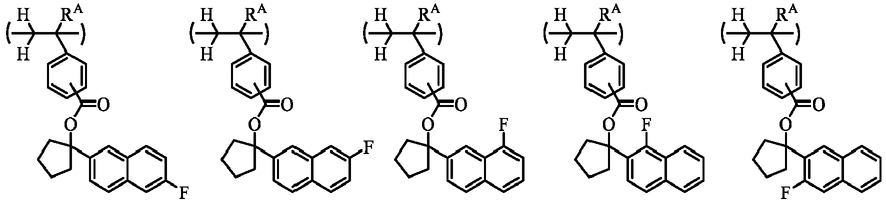

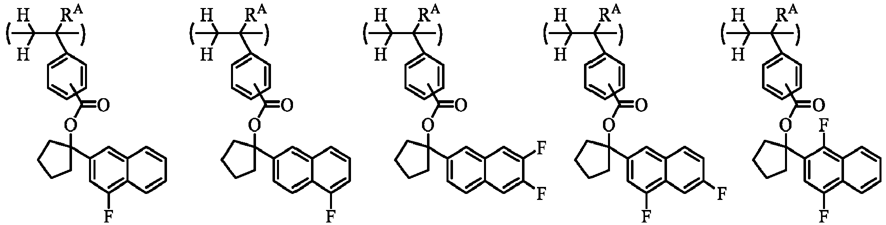

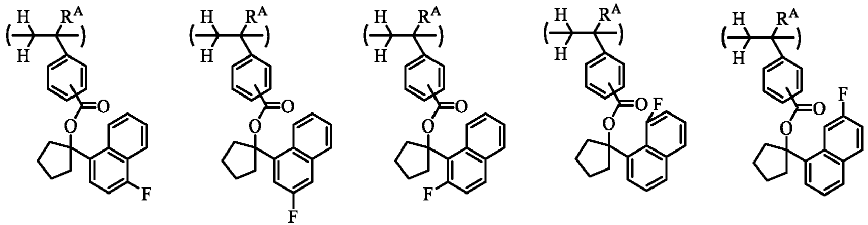

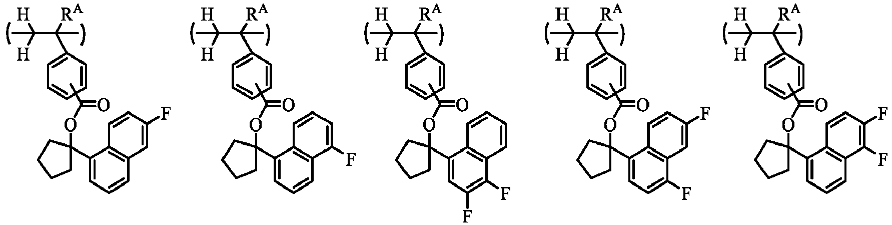

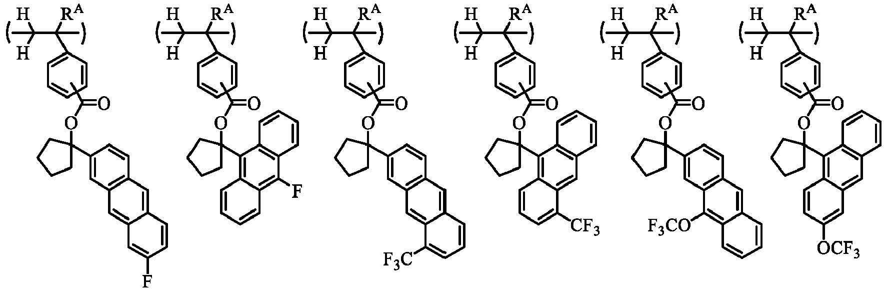

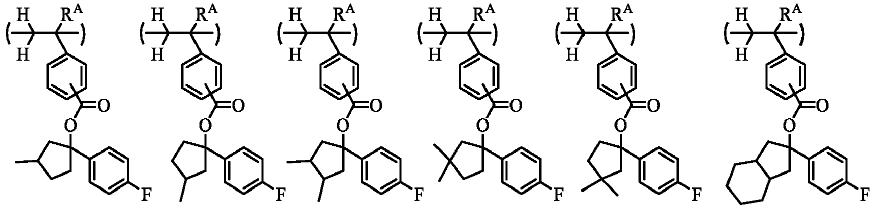

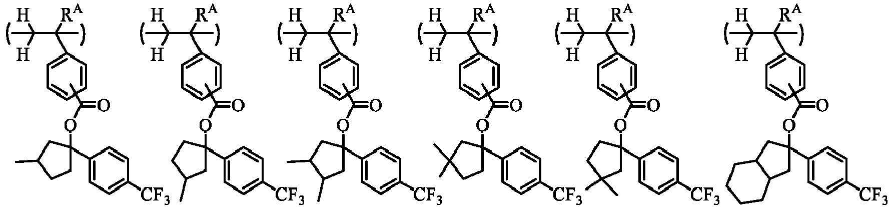

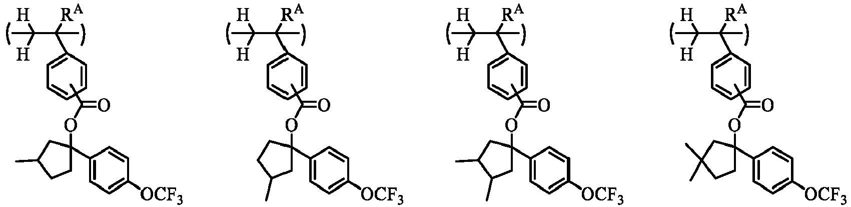

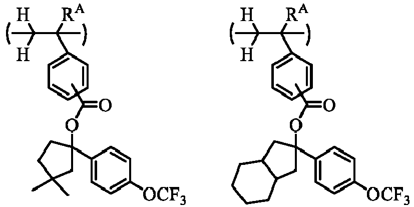

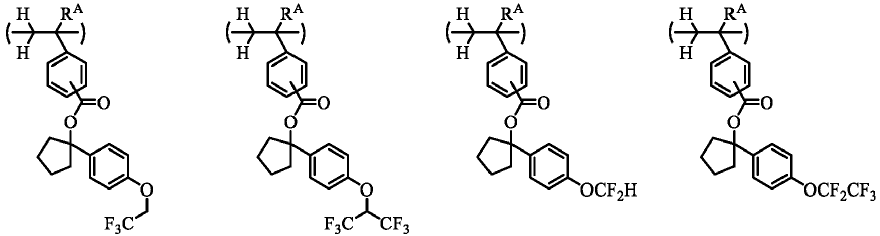

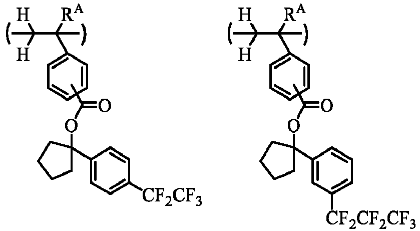

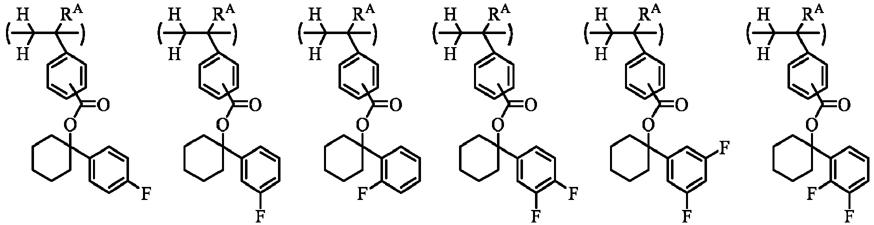

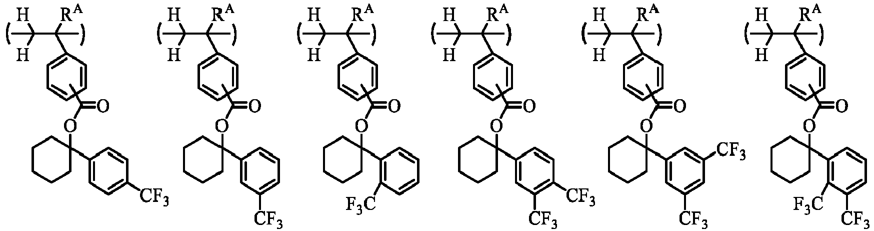

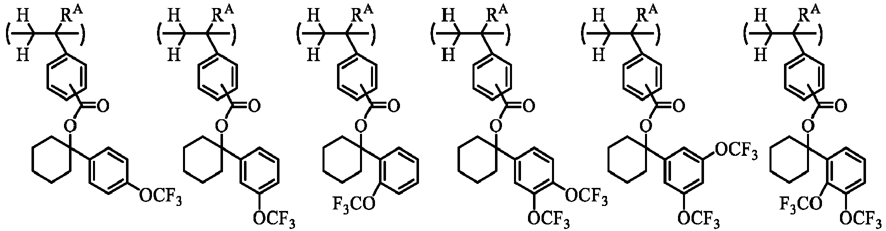

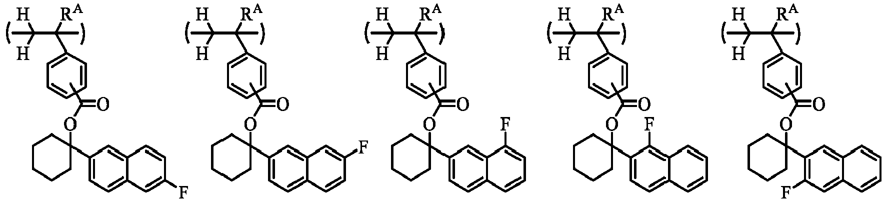

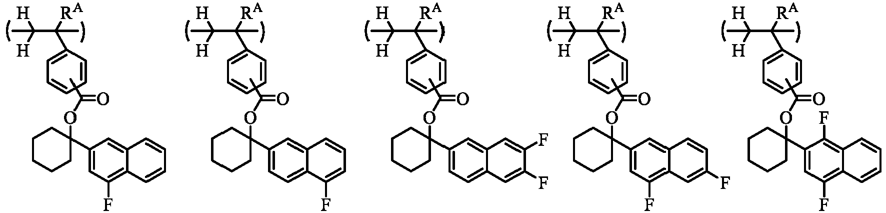

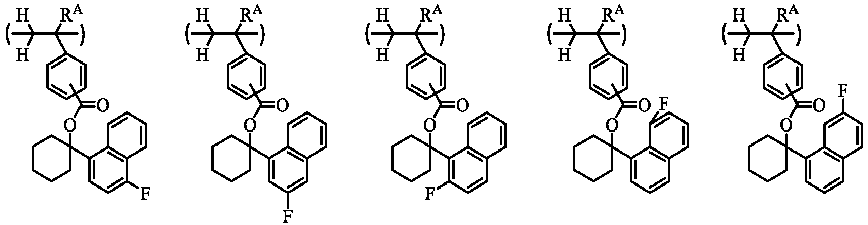

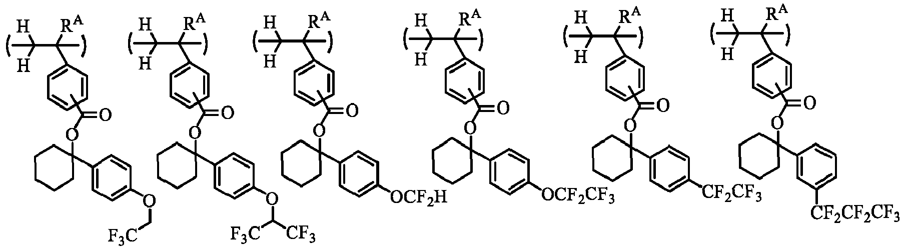

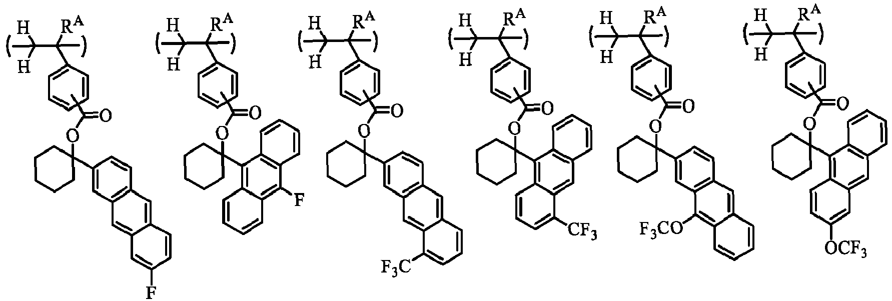

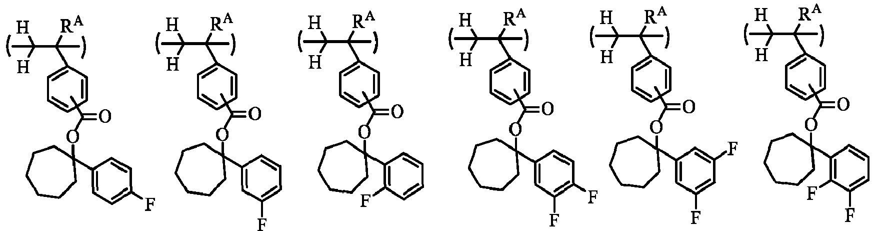

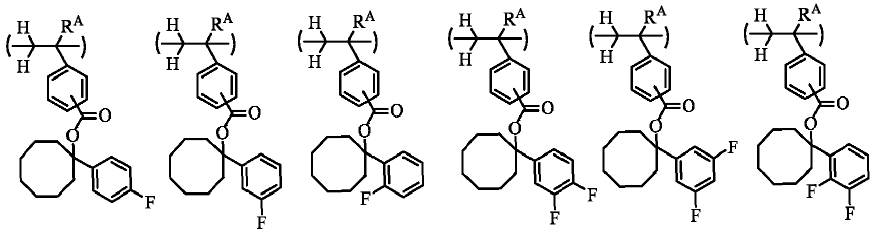

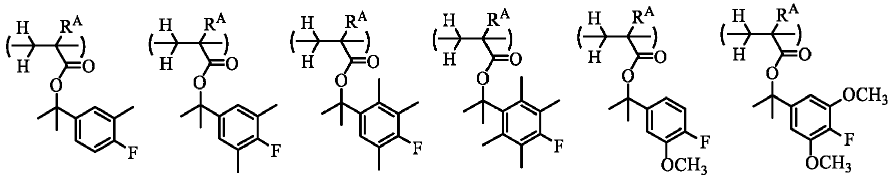

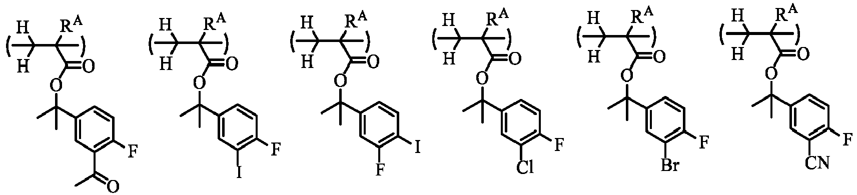

Since the acid labile group having carboxylic acid protected with a tertiary benzyl alcohol is extremely low in activation energy for acid-catalyzed deprotection reaction as compared with the acid labile group in the form of tertiary alkyl group, typically tert-butyl, deprotection reaction takes place even at a temperature around 50°C. When a polymer having an acid labile group with extremely low activation energy for deprotection reaction is used as the base polymer, the PEB temperature is too low, suggesting difficulty to control the temperature uniformity or difficulty to control the acid diffusion. If the distance of acid diffusion cannot be controlled, the CDU or maximum resolution of patterns after development is degraded. An adequate PEB temperature is necessary for acid diffusion control, and most often the range of 80 to 100°C is adequate.

Another problem arising from the use of a low-activation energy protective group is possible elimination of the protective group during polymerization in the case of a polymer with which a PAG is to be copolymerized. Although the PAG in the form of onium salt is basically neutral, the onium salt can be partially dissociated by the heat during polymerization. When a repeat unit having a phenolic hydroxy group is concurrently copolymerized, an exchange reaction takes place between the proton of the phenolic hydroxy group and the cation of the PAG to generate an acid whereby deprotection of the protective group can occur. The deprotection during polymerization becomes outstanding particularly when a low-activation energy protective group is used.

As mentioned above, the acid labile group having carboxylic acid protected with a tertiary benzyl alcohol has the advantage of satisfactory etching resistance due to the benzene ring. When a PAG is copolymerized, elimination of the protective group occurs during polymerization. When an electron attractive group is attached to a benzene ring, the activation energy for deprotection becomes high. It is believed that this is because the stability of a benzyl cation in a deprotection intermediate is lowered by the electron attractive group. It is possible to attach an electron attractive group to a protective group quite susceptible to deprotection to hold down the reactivity of deprotection reaction to an optimum level.

It is expected that when fluorine is introduced into a protective group, the swell during alkaline development is controlled and the resolution is thus improved. However, when fluorine is introduced into an acid labile group of tertiary alkyl form, the stability of intermediate cation during deprotection reaction is largely reduced by the electron attractive effect of fluorine. As a result, creation of olefin does not occur and deprotection reaction does not occur. However, the tertiary acid labile group having a fluorinated aromatic group provides the intermediate cation with optimum stability, shows adequate reactivity for deprotection, and exerts an etch resistance-improving effect.

When the polymer defined herein is used as the base polymer in a positive resist composition, especially chemically amplified positive resist composition for the purpose of controlling acid diffusion to improve the dissolution contrast and etch resistance, the chemically amplified positive resist composition shows a significantly high contrast of alkaline dissolution rate before and after light exposure, fully suppressed acid diffusion, a high resolution, satisfactory pattern profile and LWR after light exposure, and high etch resistance.

The repeat units A2 are preferably incorporated in a range of 2 to 40 mol% based on the overall repeat units of the polymer in the base polymer. The repeat units A3 are preferably incorporated in a range of 2 to 40 mol% based on the overall repeat units of the polymer in the base polymer. The repeat units A2 and A3 are preferably incorporated in a total range of 8 to 60 mol%, more preferably 10 to 40 mol% based on the overall repeat units of the polymer in the base polymer.

Where the base polymer is of the design that it is a mixture of repeat units of two types in which a phenolic hydroxy group and a carboxy group are protected with acid labile groups, the influence of develop loading is suppressed because the dissolution rate of exposed region is improved due to the carboxylate framework while maintaining pattern robustness due to the phenol framework, and the dissolution contrast between exposed and unexposed regions is optimized while maintaining a satisfactory resolution in the exposed region. As a consequence, a pattern with a minimal size difference is obtained independent of pattern density. In the fabrication of photomasks wherein the development conditions employed therein are stronger than in the processing of wafer substrates, it is required to form a pattern with a minimal size difference while maintaining a satisfactory resolution and suppressing the influence of develop loading. Then the chemically amplified positive resist composition of the invention is best suited for the processing of photomask substrates.

In a preferred embodiment, the polymer in the base polymer further comprises repeat units of at least one type selected from repeat units having the formula (B 1), repeat units having the formula (B2), and repeat units having the formula (B3), which are also referred to as repeat units B1, B2 and B3, respectively.

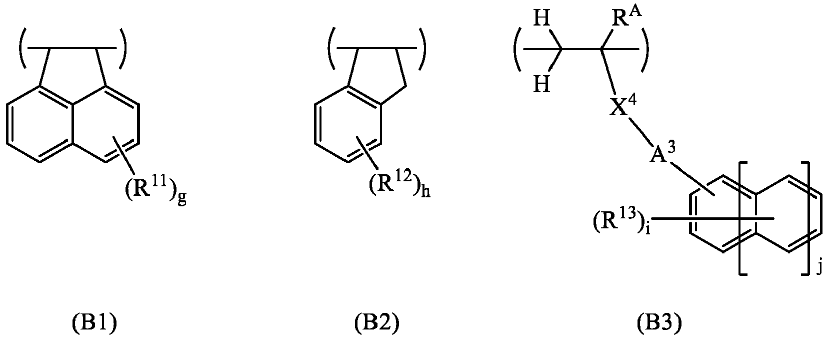

In formulae (B1) and (B2), g and h are each independently an integer of 0 to 4.

In formulae (B1) and (B2), R¹¹ and R¹² are each independently a hydroxy group, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group. The saturated hydrocarbyl group, saturated hydrocarbyloxy group and saturated hydrocarbylcarbonyloxy group may be straight, branched or cyclic. Groups R¹¹ may be identical or different when g is 2 or more. Groups R¹² may be identical or different when h is 2 or more.

In formula (B3), R^{A} is as defined above, i is an integer of 0 to 5, and j is an integer of 0 to 2.

In formula (B3), R¹³ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group. R¹³ may also be hydroxy when j is 1 or 2. The saturated hydrocarbyl group, saturated hydrocarbyloxy group, saturated hydrocarbylcarbonyloxy group, saturated hydrocarbyloxyhydrocarbyl group and saturated hydrocarbylthiohydrocarbyl group may be straight, branched or cyclic. Groups R¹³ may be identical or different when i is 2 or more.

In formula (B3), X⁴ is a single bond, ^{∗}-C(=O)-O- or ^{∗}-C(=O)-NH- wherein ^{∗} designates a point of attachment to the carbon atom in the backbone.

In formula (B3), A³ is a single bond or a C₁-C₁₀ saturated hydrocarbylene group in which some constituent -CH₂- may be replaced by -O-. The saturated hydrocarbylene group may be straight, branched or cyclic and examples thereof are as exemplified for A¹ in formula (A1).

When repeat units of at least one type selected from repeat units B 1 to B3 are incorporated, better performance is obtained because not only the aromatic ring possesses etch resistance, but the cyclic structure incorporated into the main chain also exerts the effect of improving resistance to etching and EB irradiation during pattern inspection step.

The repeat units B 1 to B3 are preferably incorporated in a range of at least 5 mol% based on the overall repeat units of the polymer in the base polymer for obtaining the effect of improving etch resistance. Also, the repeat units B 1 to B3 are preferably incorporated in a range of up to 30 mol%, more preferably up to 25 mol% based on the overall repeat units of the polymer in the base polymer. When the relevant units are free of functional groups or have a functional group other than hydroxy, their content of up to 30 mol% is preferred because the risk of forming development defects is eliminated. Each of the repeat units B 1 to B3 may be of one type or a combination of plural types.

The content of repeat units A1 and repeat units of at least one type selected from repeat units B 1 to B3 is preferably at least 50 mol%, more preferably at least 60 mol%, even more preferably at least 70 mol% based on the overall repeat units of the polymer in the base polymer.

The content of repeat units having an aromatic ring structure is preferably at least 65 mol%, more preferably at least 85 mol% based on the overall repeat units of the polymer in the base polymer. Most preferably all units are repeat units having an aromatic ring structure.

The content of repeat units A1, repeat units A2, repeat units A3, and repeat units of at least one type selected from repeat units B 1 to B3 is preferably at least 80 mol%, more preferably at least 90 mol% based on the overall repeat units of the polymer in the base polymer.

The polymer in the base polymer is preferably free of repeat units adapted to generate an acid upon light exposure. That is, the polymer in the base polymer is preferably exclusive of the so-called PAG-bound polymer. With the design of the invention, the repeat unit adapted to generate an acid upon light exposure causes the polymer to swell during alkaline development, leaving the risk of resolution being degraded.

The polymer may further comprise (meth)acrylate units protected with an acid labile group and/or (meth)acrylate units having an adhesive group such as a lactone structure or a hydroxy group other than phenolic hydroxy, as commonly used in the art. These repeat units are effective for fine adjustment of properties of a resist film, but not essential.

Examples of the (meth)acrylate unit having an adhesive group include repeat units having the following formula (B4), repeat units having the following formula (B5), and repeat units having the following formula (B6), which are also referred to as repeat units B4, B5, and B6, respectively. While these units do not exhibit acidity, they may be used as auxiliary units for providing adhesion to substrates or adjusting solubility.

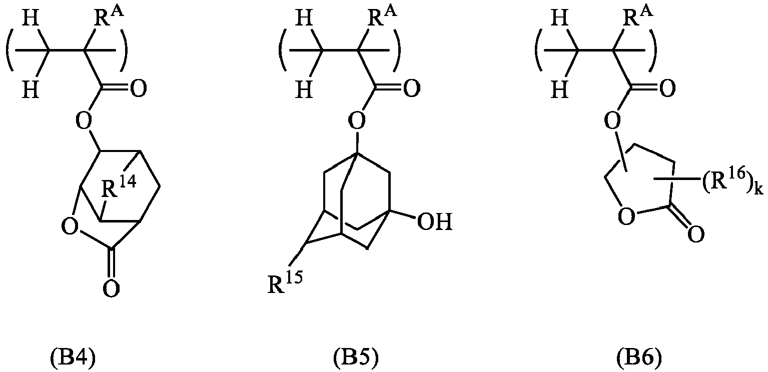

In formulae (B4) to (B6), R^{A} is as defined above. R¹⁴ is -O- or methylene. R¹⁵ is hydrogen or hydroxy. R¹⁶ is a C₁-C₄ saturated hydrocarbyl group, and k is an integer of 0 to 3.

When the repeat units B4 to B6 are included, their content is preferably 0 to 20 mol%, more preferably 0 to 10 mol% based on the overall repeat units of the polymer. Each of the repeat units B4 to B6 may be of one type or a combination of plural types.

The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630, for example.

The polymer should preferably have a Mw of 1,000 to 50,000, and more preferably 2,000 to 20,000. A Mw of at least 1,000 eliminates the risk that pattern features are rounded at their top, inviting degradations of resolution and LER. A Mw of up to 50,000 eliminates the risk that LER is degraded when a pattern with a line width of up to 100 nm is formed. As used herein, Mw is measured by GPC versus polystyrene standards using tetrahydrofuran (THF) solvent.

The polymer preferably has a narrow molecular weight distribution or dispersity (Mw/Mn) of 1.0 to 2.0, more preferably 1.0 to 1.9, even more preferably 1.0 to 1.8. A polymer with such a narrow dispersity eliminates the risk that foreign particles are left on the pattern after development and the pattern profile is aggravated.

The base polymer is designed such that the dissolution rate in alkaline developer is preferably up to 10 nm/min, more preferably up to 7 nm/min, even more preferably up to 5 nm/min. In the advanced generation of lithography wherein the coating film on the substrate is in a thin film range of up to 100 nm, the influence of pattern film thickness loss during alkaline development becomes strong. When the polymer has an alkaline dissolution rate of greater than 10 nm/min, pattern collapse occurs, i.e., a small size pattern cannot be formed. The problem becomes outstanding in the fabrication of photomasks requiring to be defectless and having a tendency of strong development process. It is noted that the dissolution rate of a base polymer in alkaline developer is computed by spin coating a 16.7 wt% solution of a polymer in propylene glycol monomethyl ether (PGME) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness.

### Fluorinated polymer

The positive resist composition may further comprise a fluorinated polymer which contains repeat units of at least one type selected from repeat units having the formula (C1), repeat units having the formula (C2), repeat units having the formula (C3), and repeat units having the formula (C4), and which may contain repeat units of at least one type selected from repeat units having the formula (C5) and repeat units having the formula (C6), for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. It is noted that repeat units having formulae (C1), (C2), (C3), (C4), (C5), and (C6) are also referred to as repeat units C1, C2, C3, C4, C5, and C6, respectively, hereinafter. Since the fluorinated polymer also has a surface active function, it can prevent insoluble residues from re-depositing onto the substrate during the development step and is thus effective for preventing development defects.

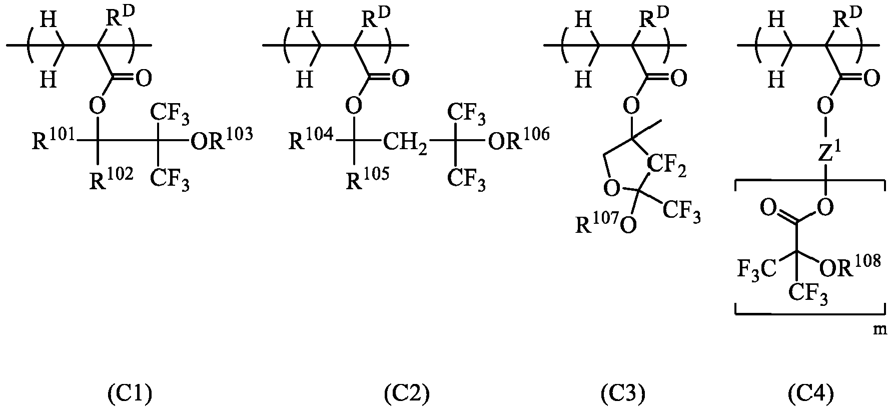

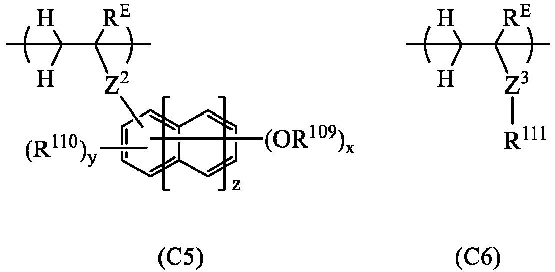

In formulae (C1) to (C6), R^{D} is each independently hydrogen, fluorine, methyl or trifluoromethyl. R^{E} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. The subscript x is an integer of 1 to 3, y is an integer satisfying: 0 ≤ y ≤ 5+2z-x, z is 0 or 1, and m is an integer of 1 to 3. Z¹ is a C₁-C₂₀ (m+1)-valent hydrocarbon group or C₁-C₂₀ (m+1)-valent fluorinated hydrocarbon group. Z² is a single bond, ^{∗}-C(=O)-O- or ^{∗}-C(=O)-NH- wherein ^{∗} designates a point of attachment to the carbon atom in the backbone. Z³ is a single bond, -O-, ^{∗}-C(=O)-O-Z³¹-Z³²- or ^{∗}-C(=O)-NH-Z³¹-Z³²-, wherein Z³¹ is a single bond or a C₁-C₁₀ saturated hydrocarbylene group, Z³² is a single bond, ester bond, ether bond or sulfonamide bond, and ^{∗} designates a point of attachment to the carbon atom in the backbone.

Examples of the C₁-C₁₀ saturated hydrocarbyl group represented by R¹⁰¹, R¹⁰², R¹⁰⁴ and R¹⁰⁵ in formulae (C1) and (C2) include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

Examples of the C₁-C₁₅ hydrocarbyl group represented by R¹⁰³, R¹⁰⁶, R¹⁰⁷ and R¹⁰⁸ in formulae (C1) to (C4) include C₁-C₁₅ alkyl, C₂-C₁₅ alkenyl and C₂-C₁₅ alkynyl groups, with the C₁-C₁₅ alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl, and n-pentadecyl. The fluorinated hydrocarbyl groups correspond to the foregoing hydrocarbyl groups in which some or all carbon-bonded hydrogen atoms are substituted by fluorine atoms.

Examples of the C₁-C₂₀ (m+1)-valent hydrocarbon group Z¹ in formula (C4) include the foregoing C₁-C₂₀ alkyl groups and C₃-C₂₀ cyclic saturated hydrocarbyl groups, with m number of hydrogen atoms being eliminated. Examples of the C₁-C₂₀ (m+1)-valent fluorinated hydrocarbon group Z¹ include the (m+1)-valent hydrocarbon groups in which at least one hydrogen atom is substituted by fluorine.

Examples of the repeat units C 1 to C4 are given below, but not limited thereto. Herein R^{D} is as defined above.

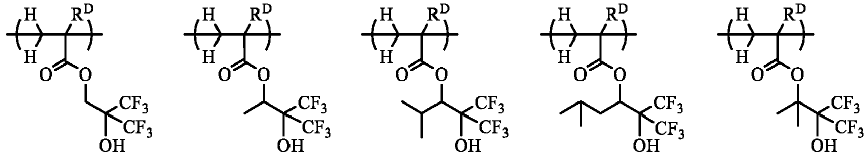

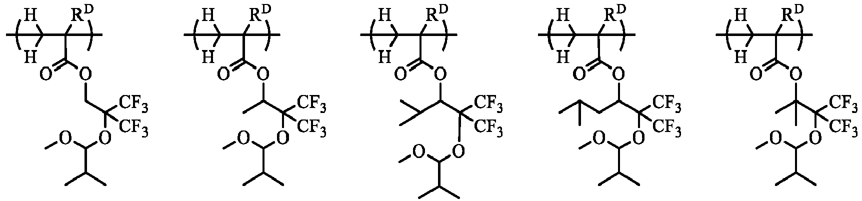

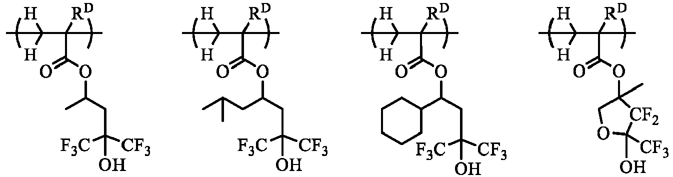

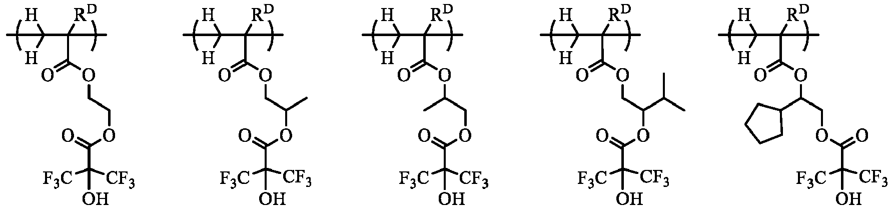

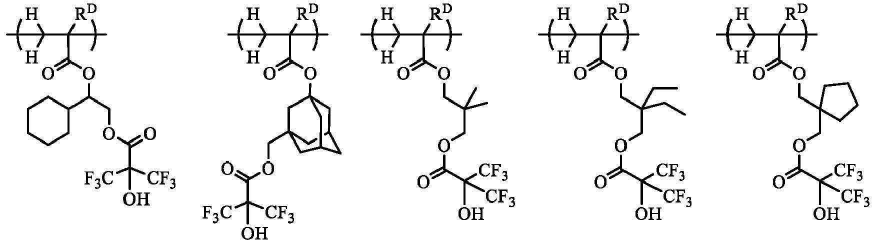

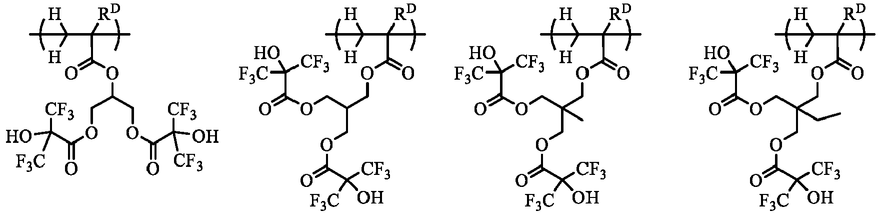

Examples of the C₁-C₅ hydrocarbyl groups R¹⁰⁹ and R¹¹⁰ in formula (C5) include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (C5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (C5), Z² is preferably ^{∗}-C(=O)-O- or ^{∗}-C(=O)-NH-. Also preferably R^{E} is methyl. The inclusion of carbonyl in Z² enhances the ability to trap the acid originating from the anti-charging film. A polymer wherein R^{E} is methyl is a robust polymer having a high Tg which is effective for suppressing acid diffusion. As a result, the resist film is improved in stability with time, and neither resolution nor pattern profile is degraded.

Examples of the repeat unit C5 are given below, but not limited thereto. Herein R^{E} is as defined above.

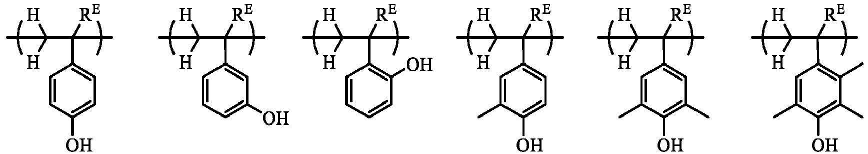

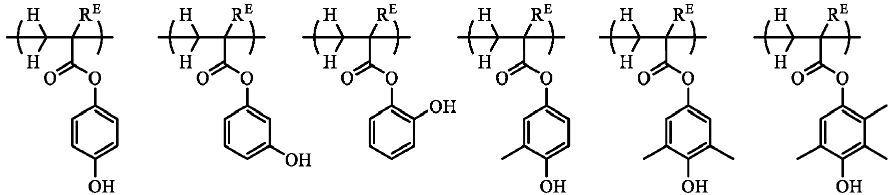

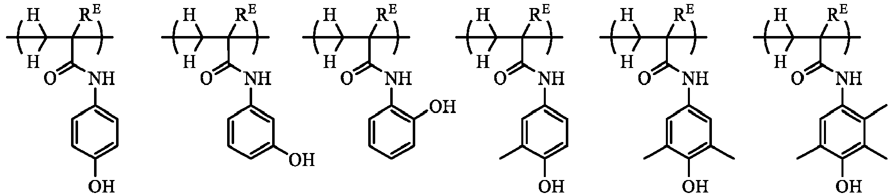

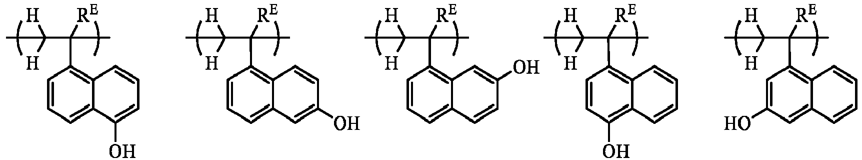

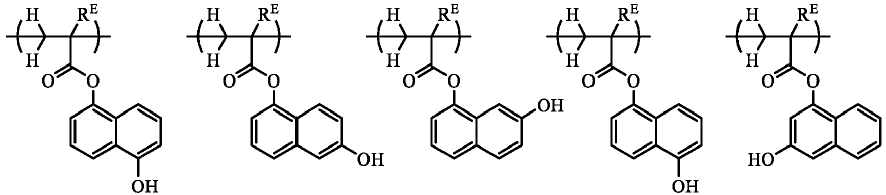

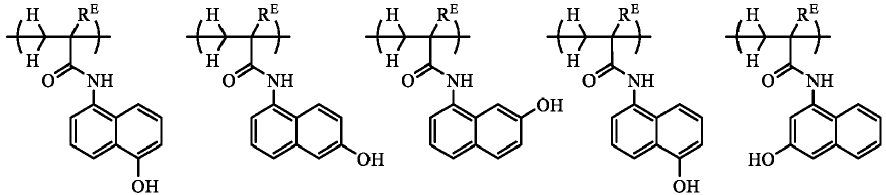

The C₁-C₁₀ saturated hydrocarbylene group Z³ in formula (C6) may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹ in formula (C6), may be straight, branched or cyclic and examples thereof include the C₁-C₂₀ alkyl and C₃-C₂₀ cyclic saturated hydrocarbyl groups exemplified above, with at least one hydrogen being substituted by fluorine.

Examples of the repeat unit C6 are given below, but not limited thereto. Herein R^{E} is as defined above.

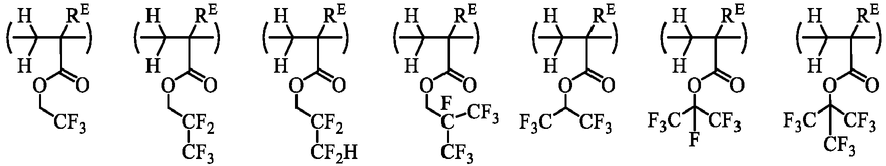

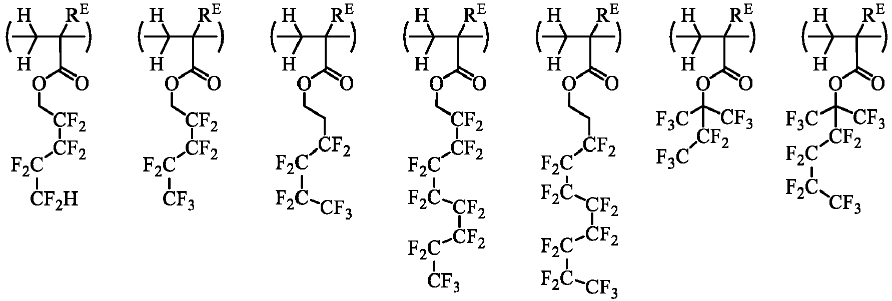

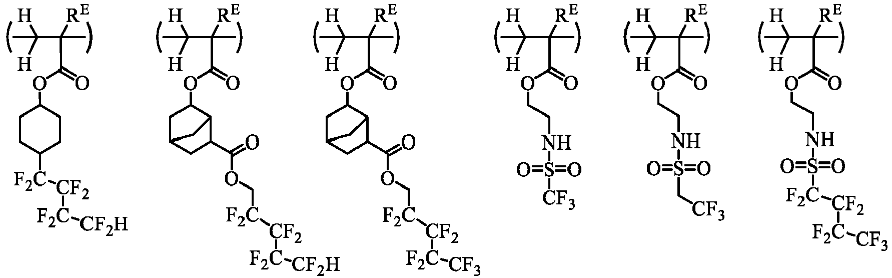

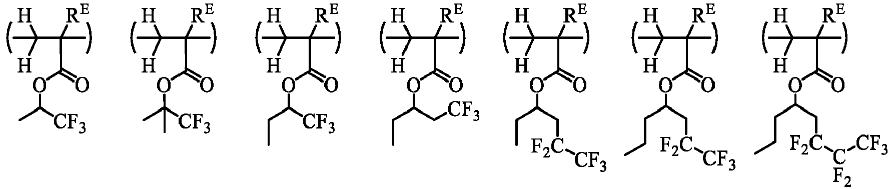

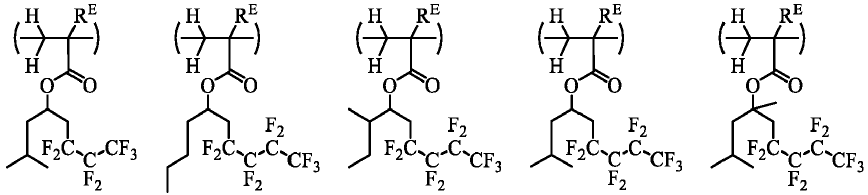

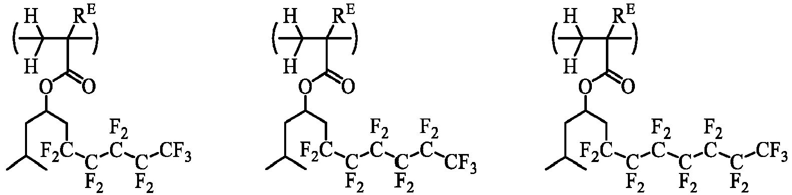

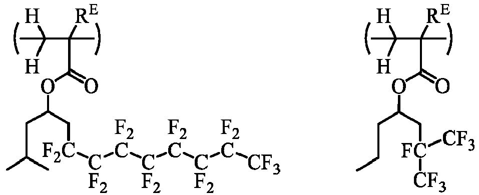

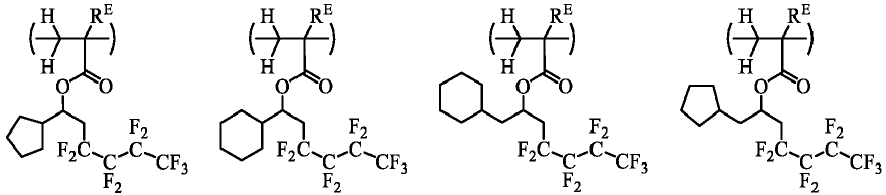

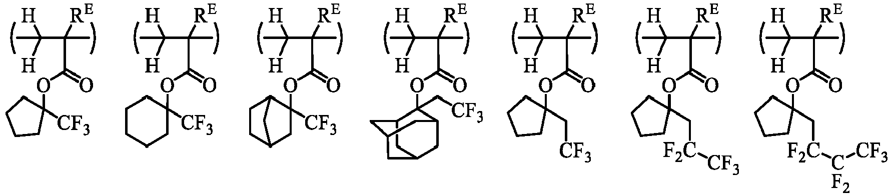

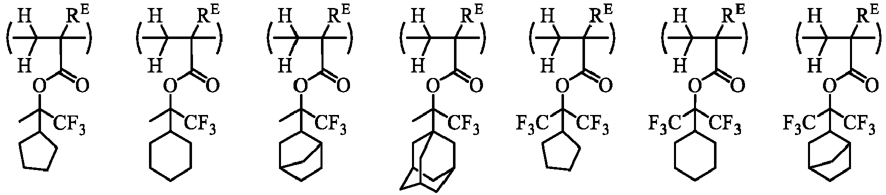

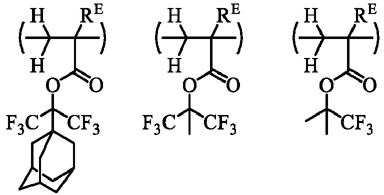

The repeat units C1 to C4 are preferably incorporated in an amount of 15 to 95 mol%, more preferably 20 to 85 mol% based on the overall repeat units of the fluorinated polymer. The repeat unit C5 and/or C6 is preferably incorporated in an amount of 5 to 85 mol%, more preferably 15 to 80 mol% based on the overall repeat units of the fluorinated polymer. Each of repeat units C1 to C6 may be used alone or in admixture.

The fluorinated polymer may comprise additional repeat units as well as the repeat units C1 to C6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the positive resist composition, the fluorinated polymer is preferably used in an amount of 0.01 to 30 parts, more preferably 0.1 to 20 parts, even more preferably 0.5 to 10 parts by weight per 80 parts by weight of the base polymer.

### Organic solvent

The chemically amplified positive resist composition may further comprise an organic solvent. The organic solvent used herein is not particularly limited as long as the components are soluble therein. Examples of the organic solvent are described in JP-A 2008-111103, paragraphs [0144]-[0145] (USP 7,537,880). Specifically, exemplary solvents include ketones such as cyclohexanone and methyl-2-n-pentyl ketone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof. Where an acid labile group of acetal form is used, a high boiling alcohol solvent such as diethylene glycol, propylene glycol, glycerol, 1,4-butanediol or 1,3-butanediol may be added to accelerate deprotection reaction of acetal.

Of the above organic solvents, it is recommended to use 1-ethoxy-2-propanol, PGMEA, PGME, cyclohexanone, EL, GBL, and mixtures thereof.

In the positive resist composition, the organic solvent is preferably used in an amount of 200 to 10,000 parts, more preferably 400 to 5,000 parts by weight per 80 parts by weight of the base polymer. The organic solvent may be used alone or in admixture.

### Photoacid generator

The positive resist composition may further comprise a photoacid generator (PAG), also referred to as acid generator of addition type. The PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to deprotect the acid labile group in the repeat units having formula (A2) or (A3).

The preferred PAGs are compounds having a sulfonium anion of the structure shown below.

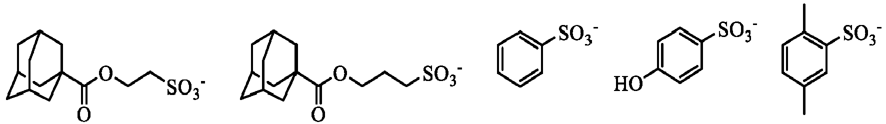

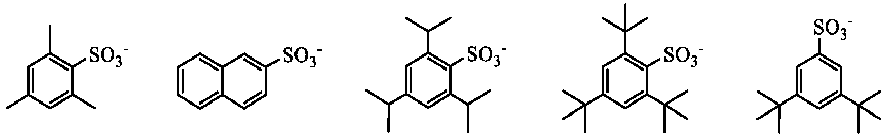

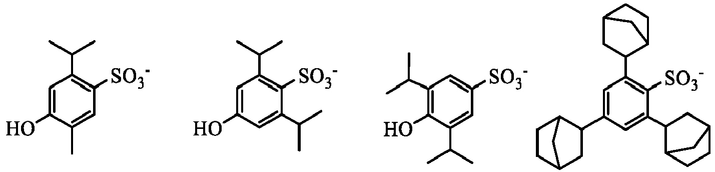

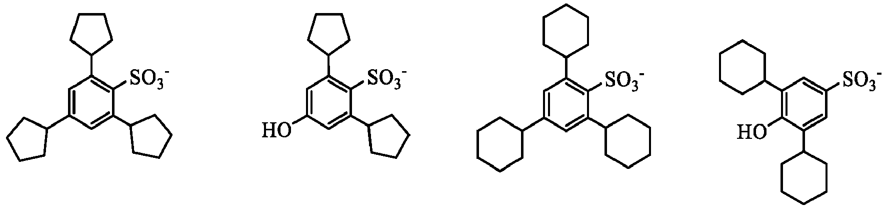

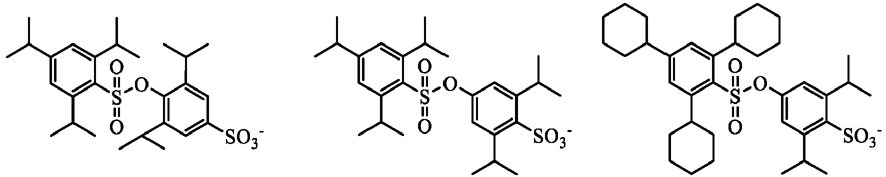

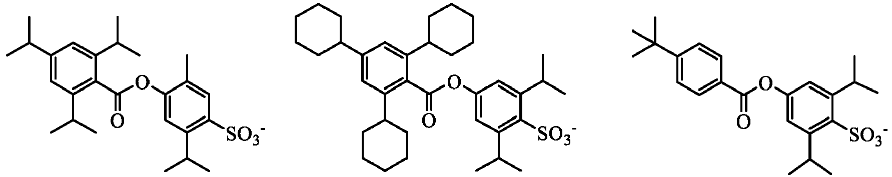

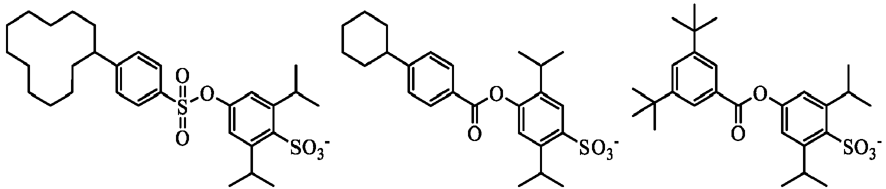

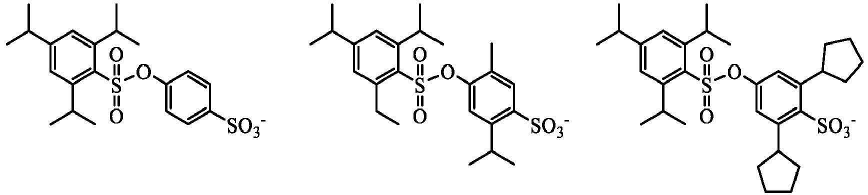

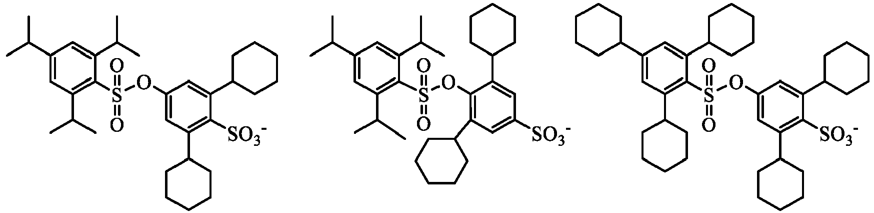

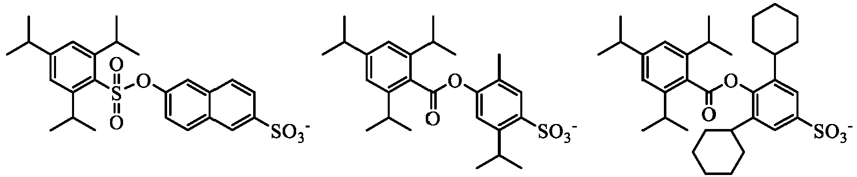

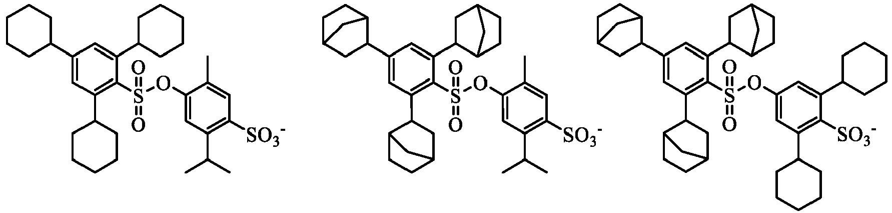

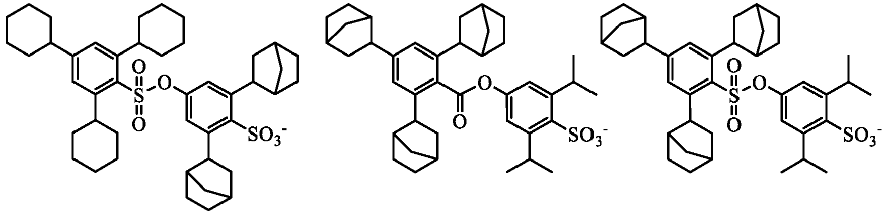

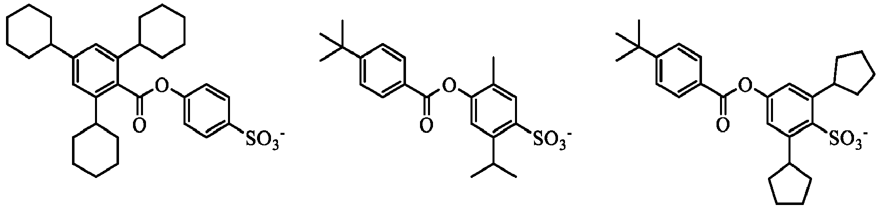

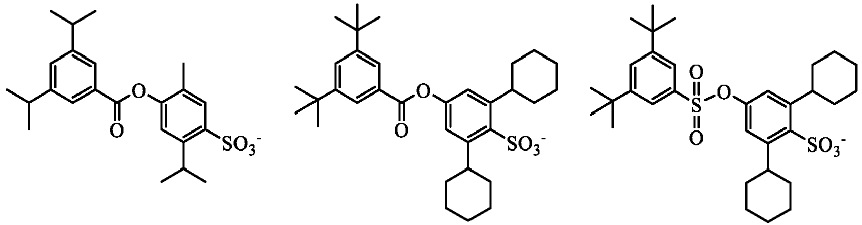

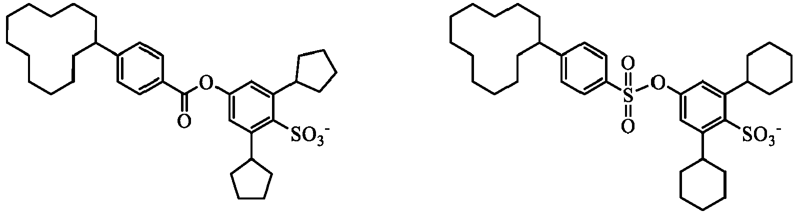

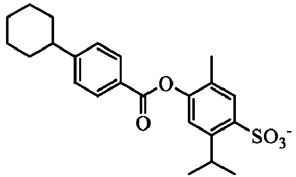

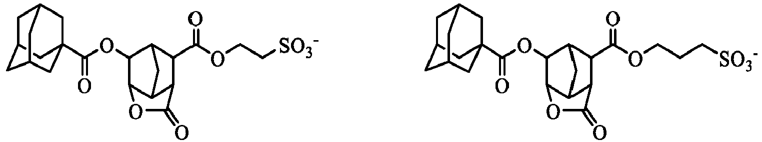

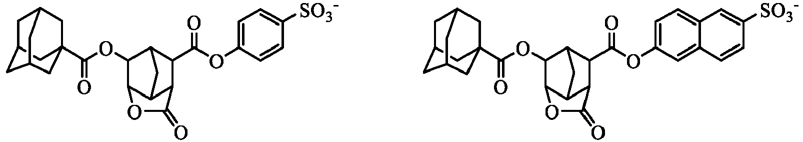

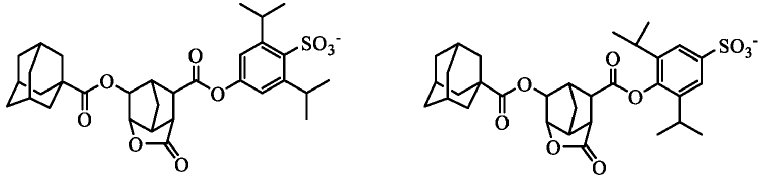

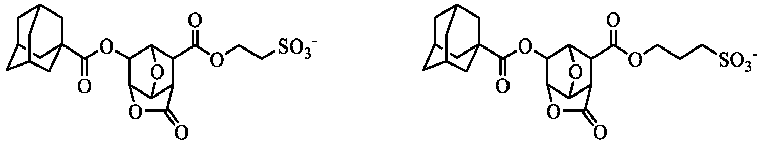

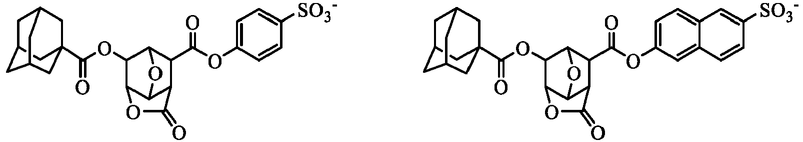

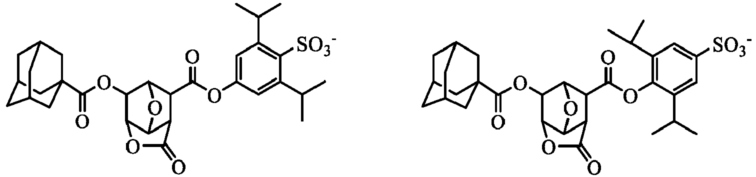

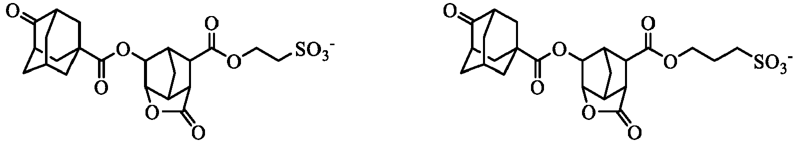

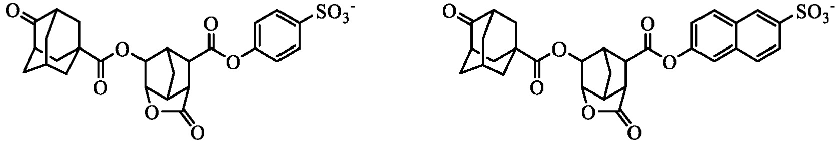

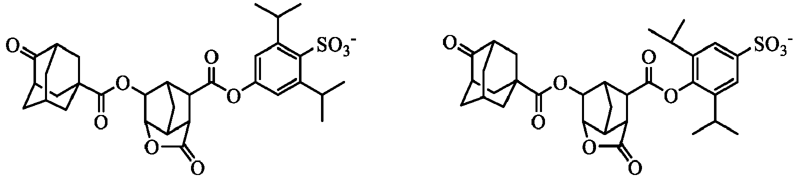

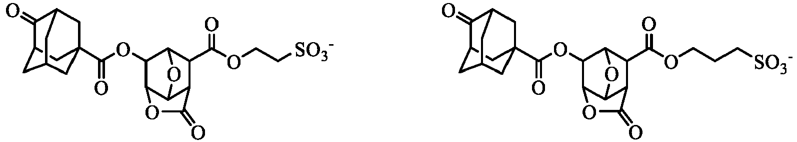

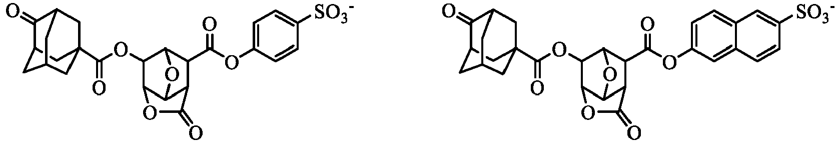

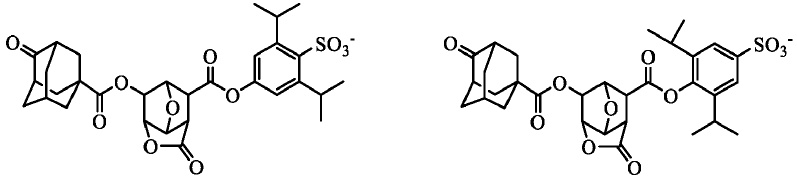

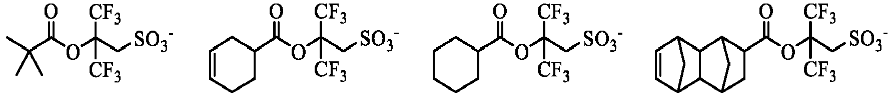

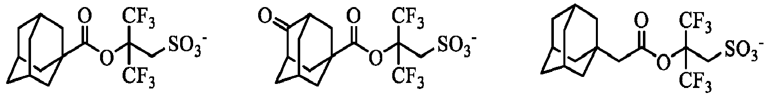

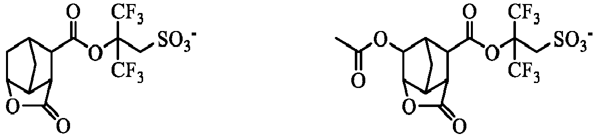

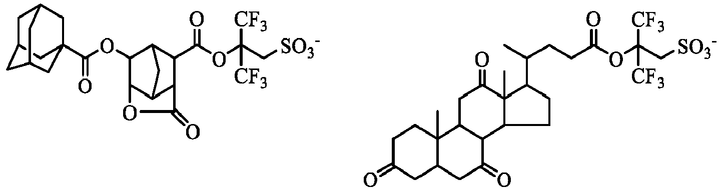

Preferred examples of the cation that pairs with the anion include sulfonium cations having the formula (D) and iodonium cations having the formula (E).

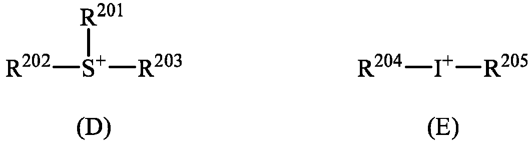

In formulae (D) and (E), R²⁰¹ to R²⁰⁵ are each independently halogen or a C₁-C₂₀ hydrocarbyl group which may contain a heteroatom.

Suitable halogen atoms include fluorine, chlorine, bromine and iodine.

The C₁-C₂₀ hydrocarbyl group may be saturated or unsaturated and straight, branched or cyclic. Examples thereof include C₁-C₂₀ alkyl groups such as methyl, ethyl, n-propyl, isopropyl, n-butyl, sec-butyl, tert-butyl, tert-pentyl, n-pentyl, n-hexyl, n-octyl, 2-ethylhexyl, n-nonyl and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; and C₆-C₂₀ aryl groups such as phenyl, naphthyl and anthracenyl. In the hydrocarbyl groups, some or all of the hydrogen atoms may be substituted by a moiety containing a heteroatom such as oxygen, sulfur, nitrogen or halogen, and a moiety containing a heteroatom such as oxygen, sulfur or nitrogen may intervene in a carbon-carbon bond, so that the group may contain a hydroxy, fluorine, chlorine, bromine, iodine, cyano, carbonyl, ether bond, ester bond, sulfonic ester bond, carbonate bond, lactone ring, sultone ring, carboxylic anhydride (-C(=O)-O-C(=O)-) or haloalkyl moiety.

Also, R²⁰¹ and R²⁰² may bond together to form a ring with the sulfur atom to which they are attached. Examples of the ring are shown below. 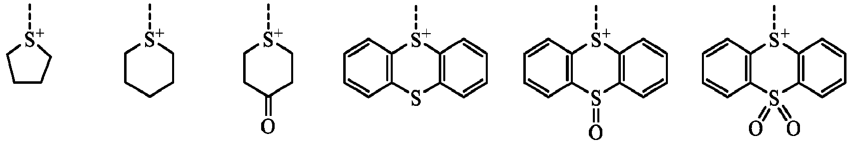 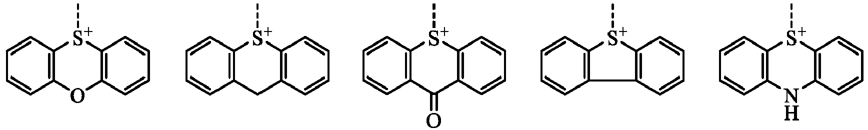 Herein, the broken line designates a point of attachment to R²⁰³.

Exemplary structures of the sulfonium cation having formula (D) are shown below, but not limited thereto.

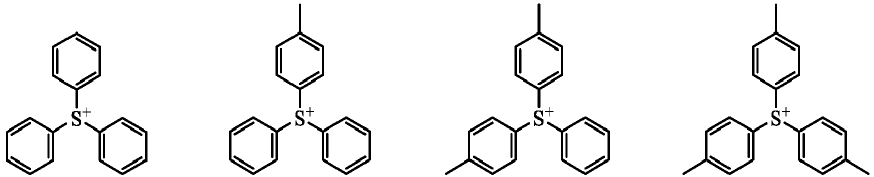

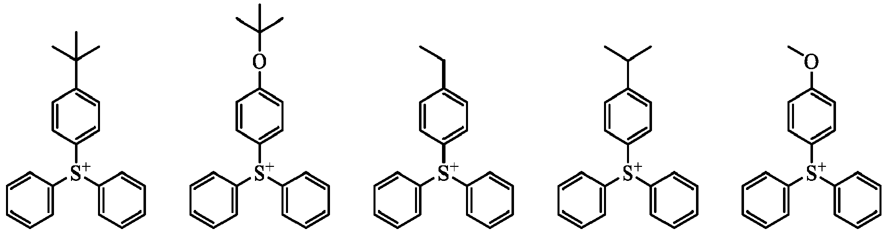

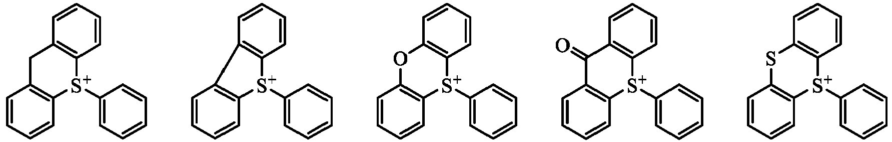

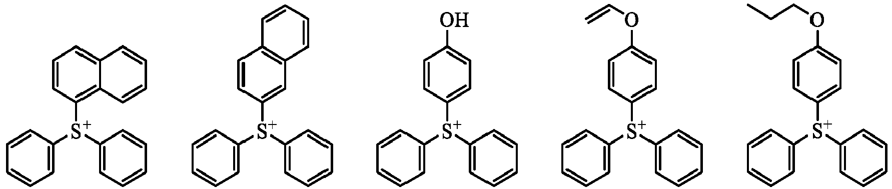

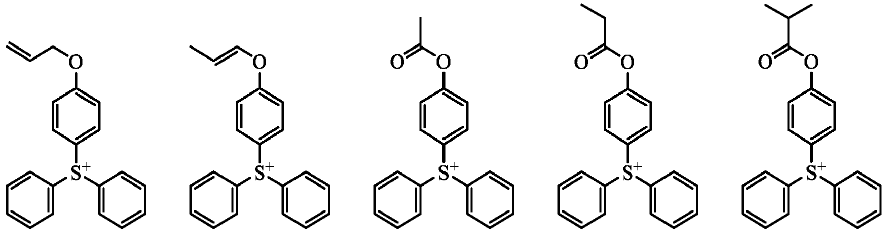

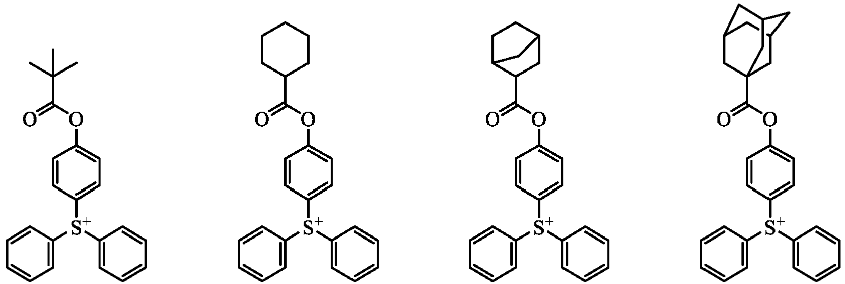

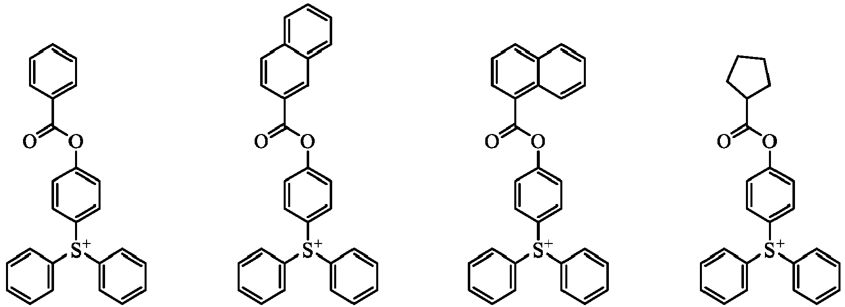

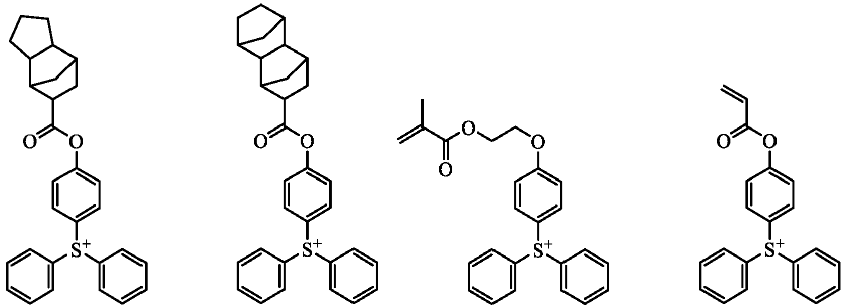

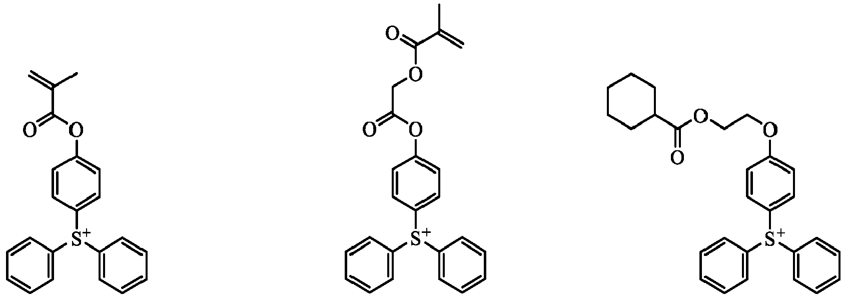

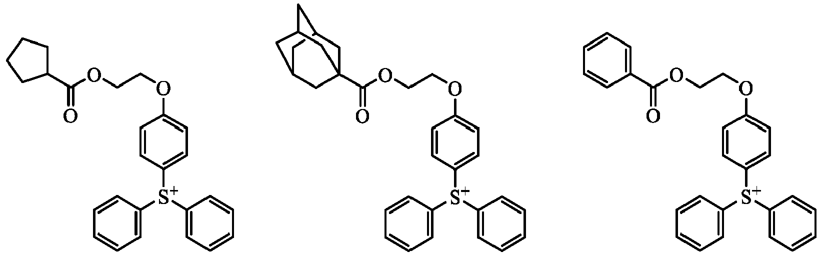

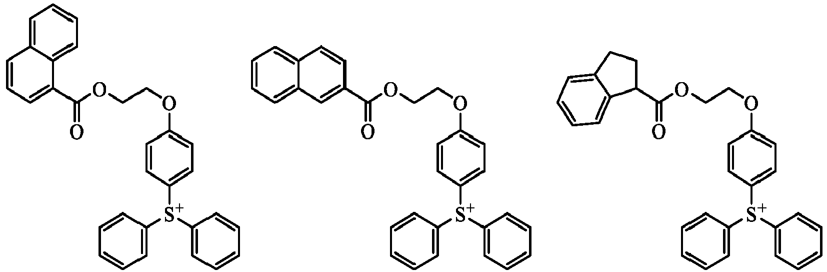

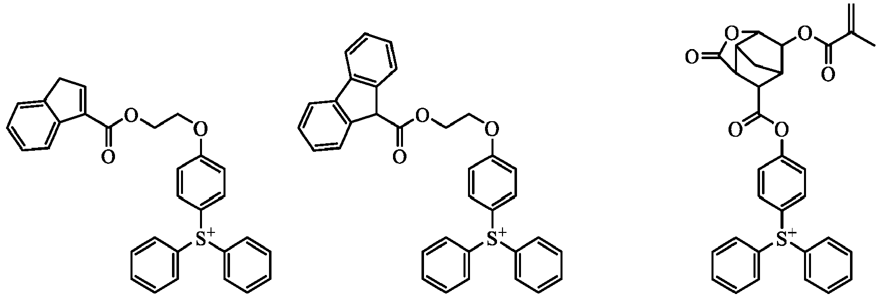

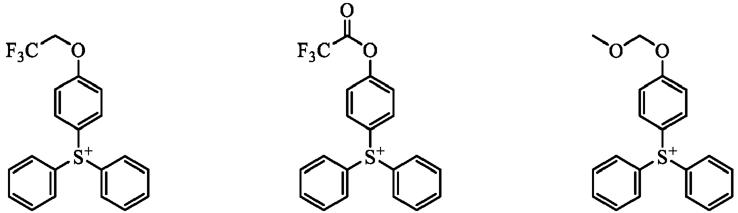

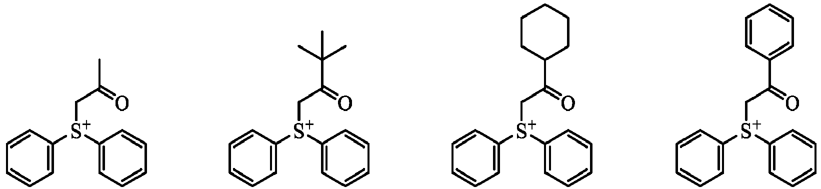

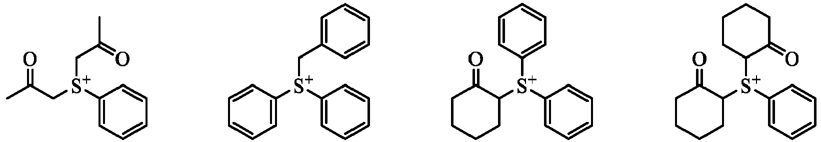

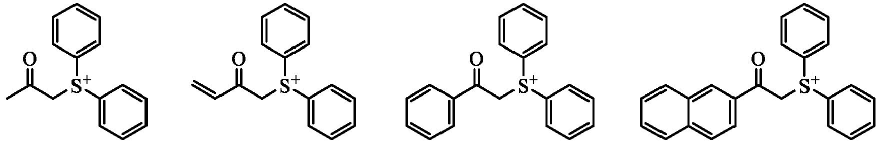

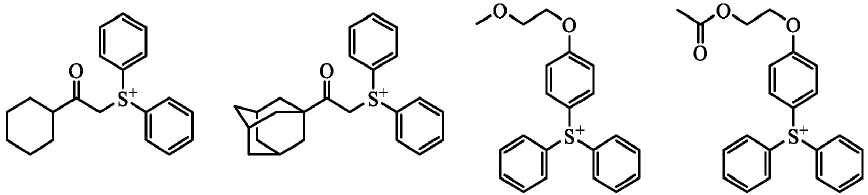

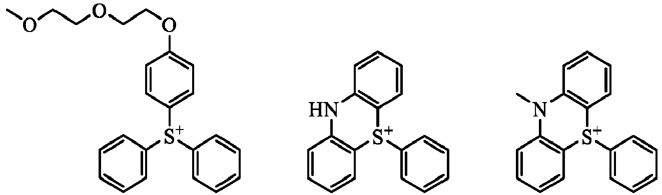

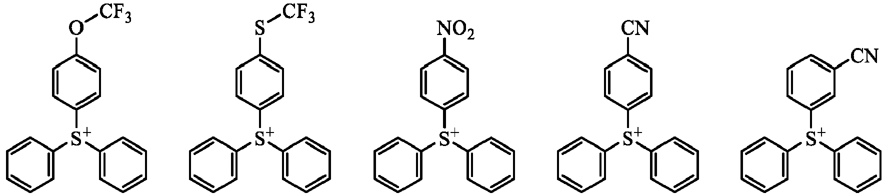

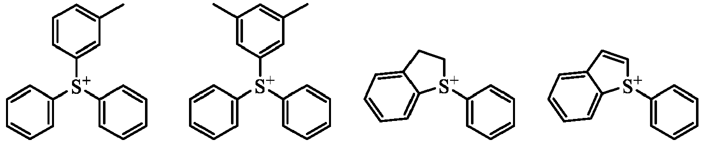

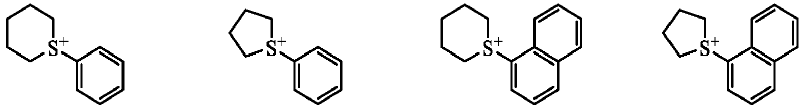

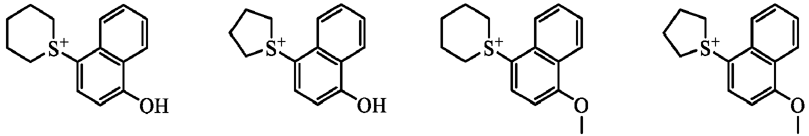

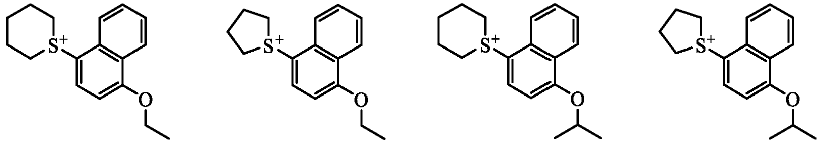

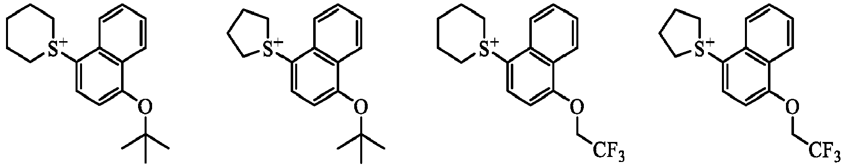

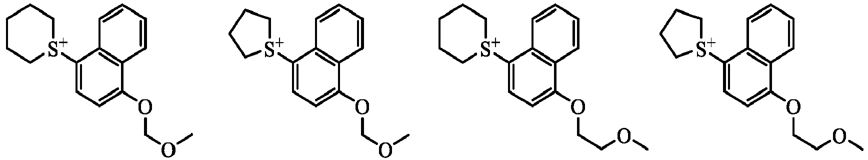

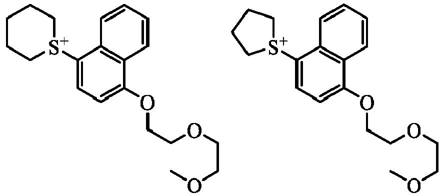

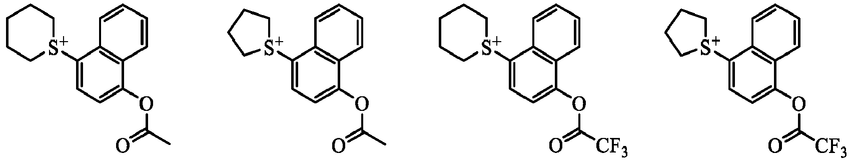

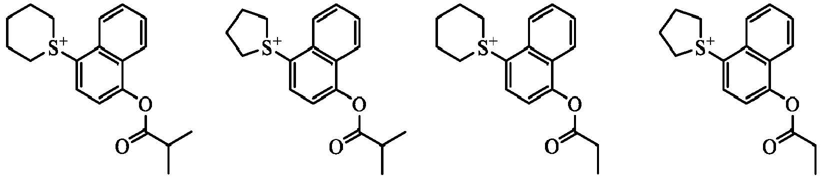

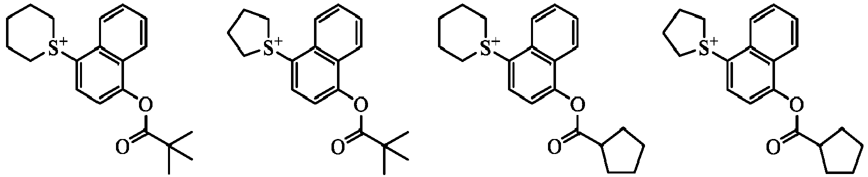

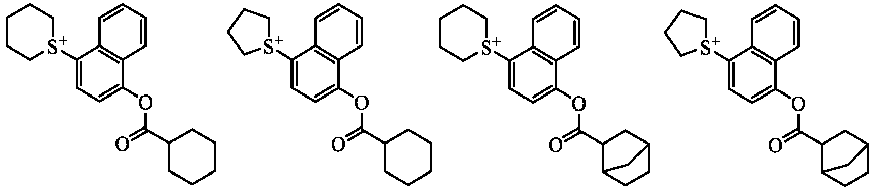

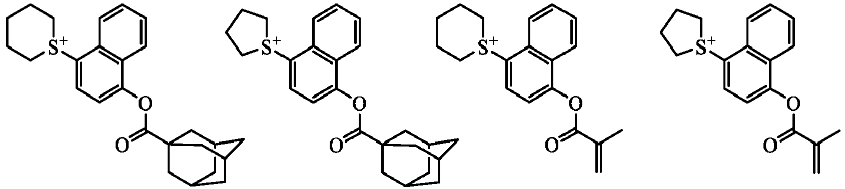

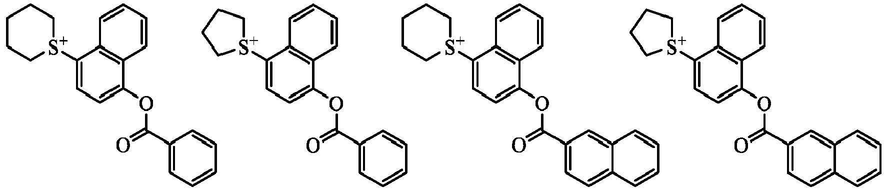

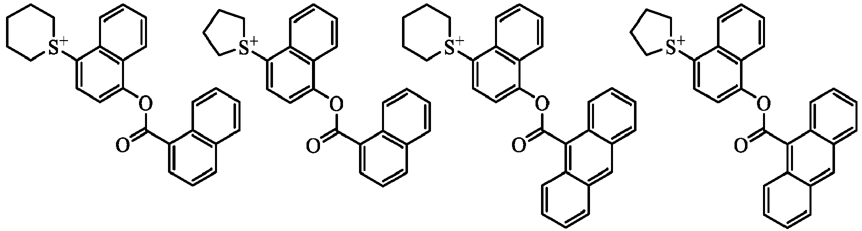

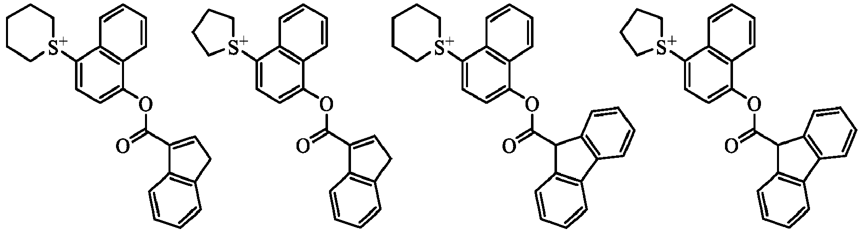

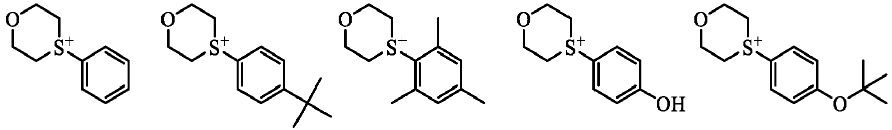

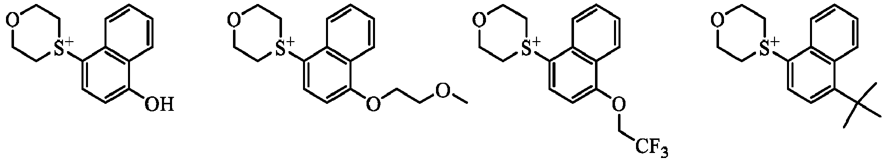

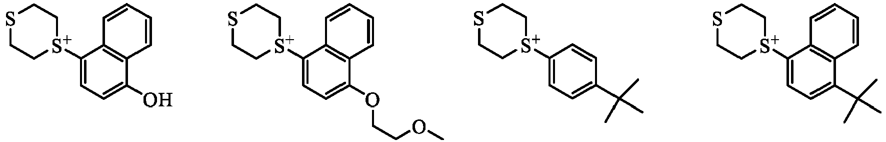

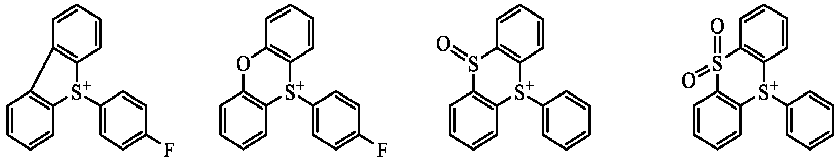

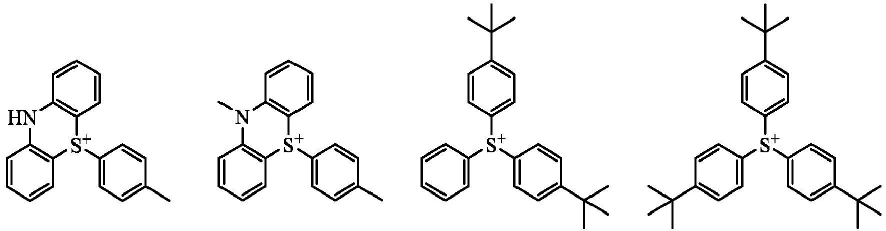

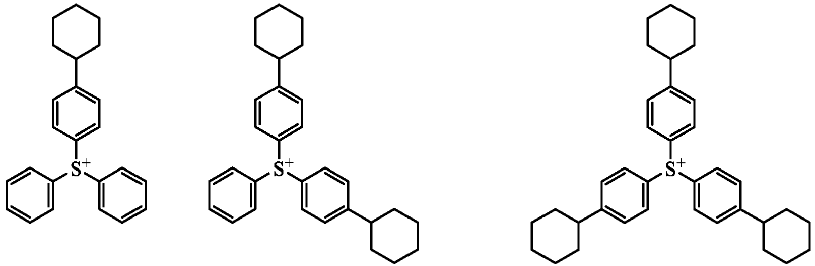

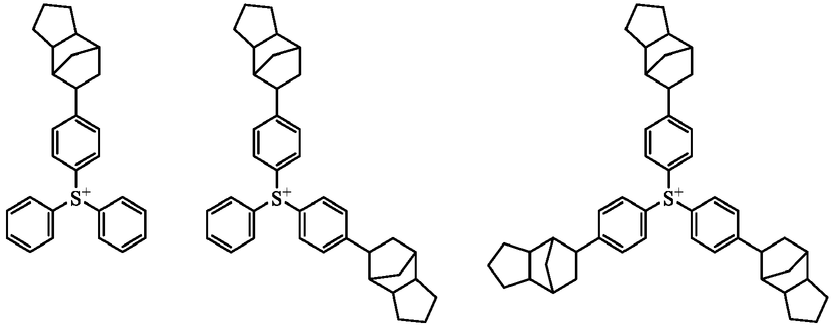

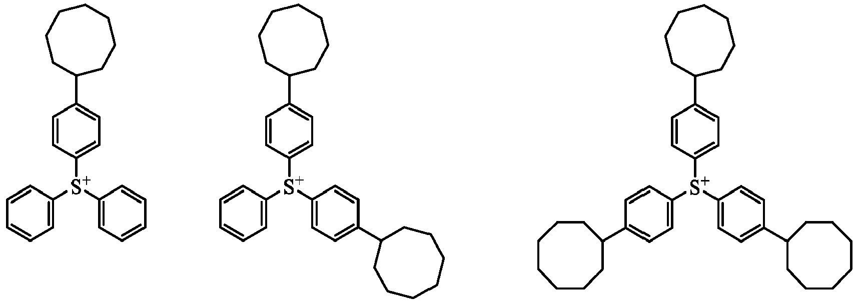

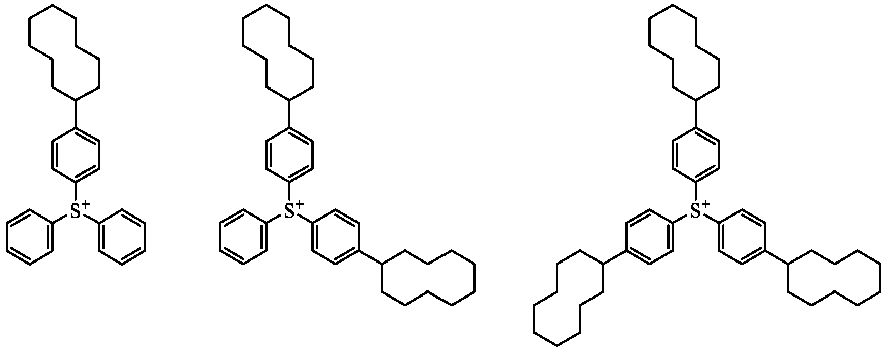

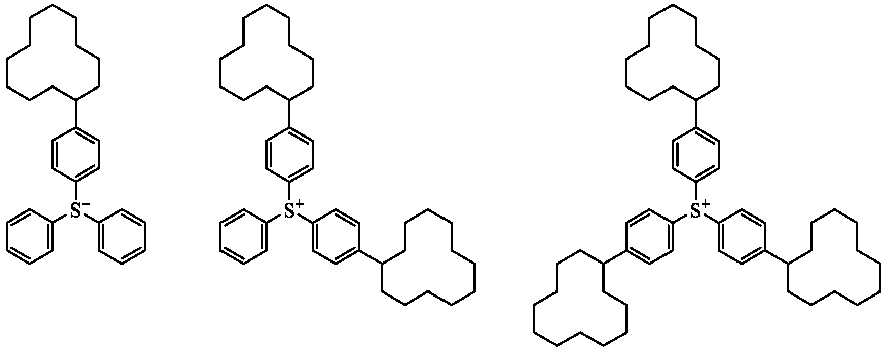

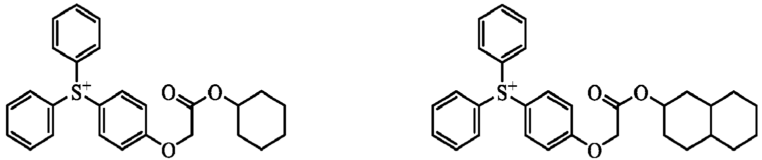

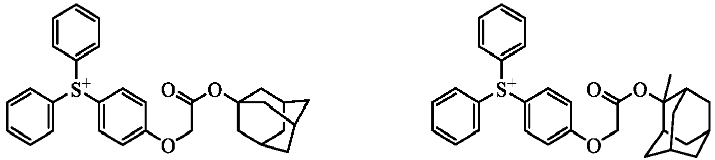

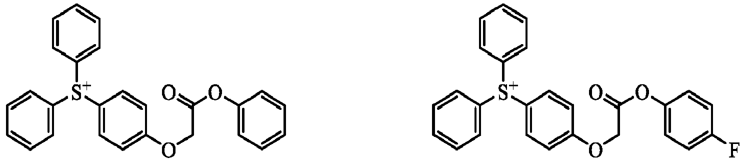

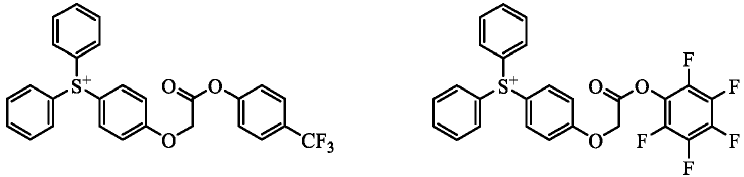

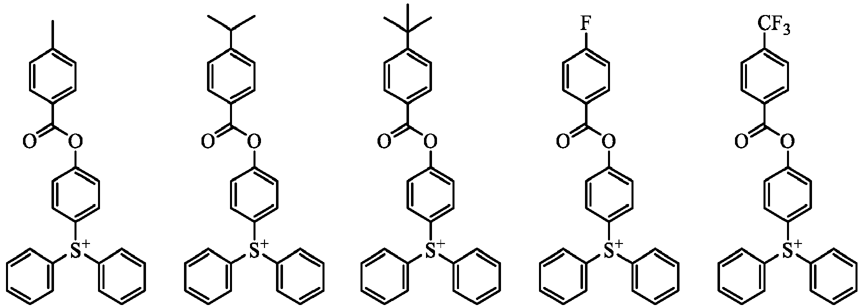

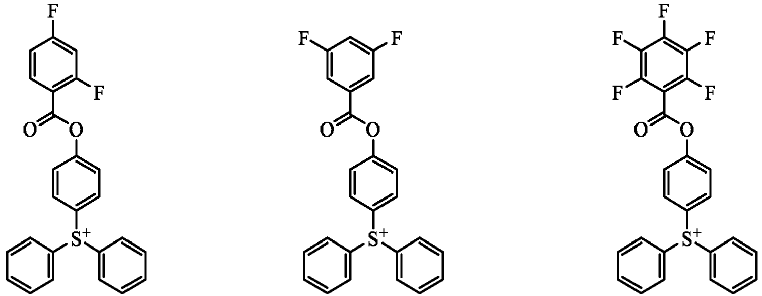

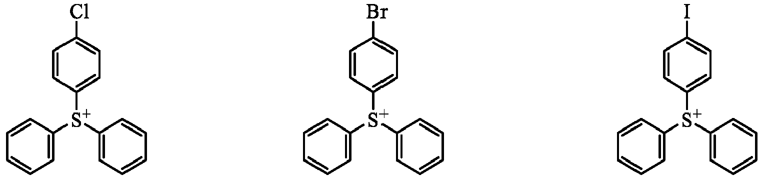

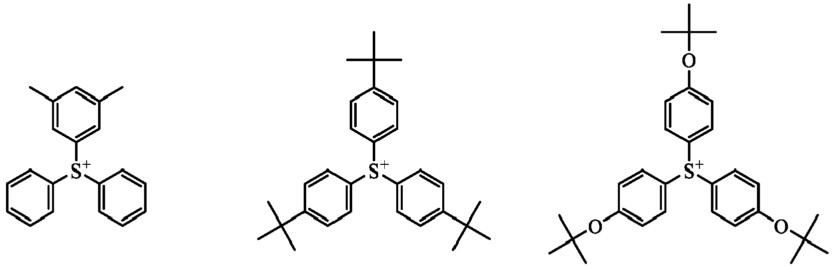

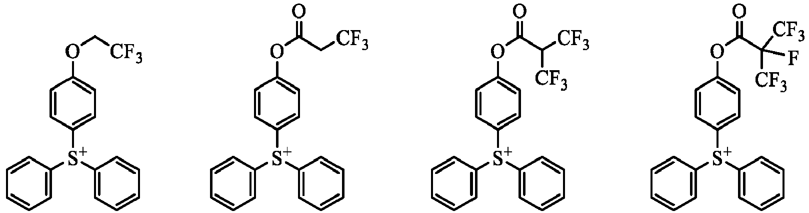

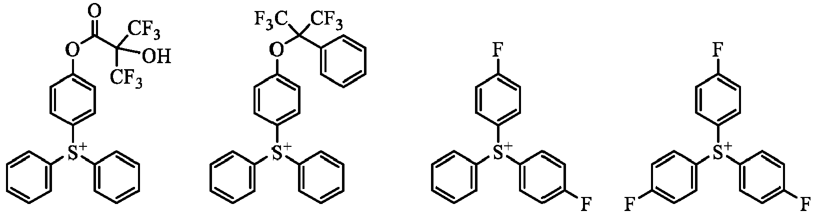

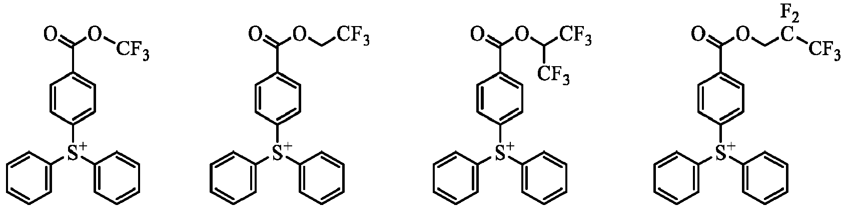

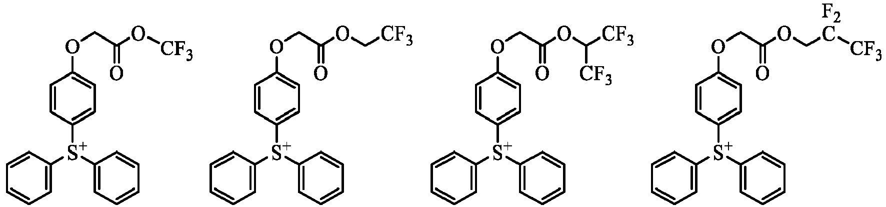

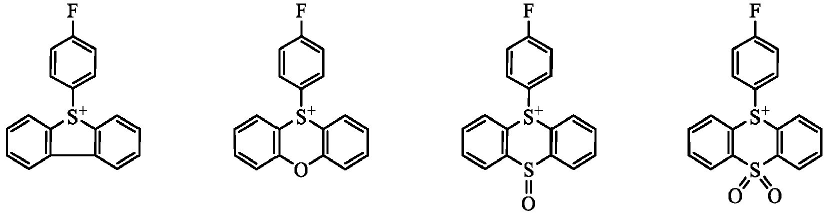

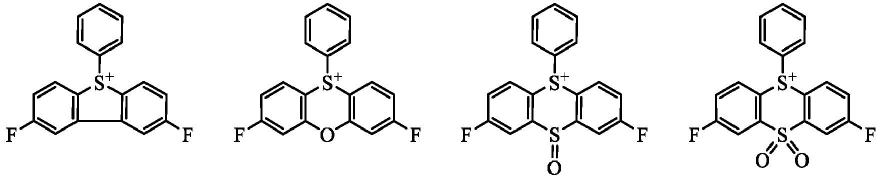

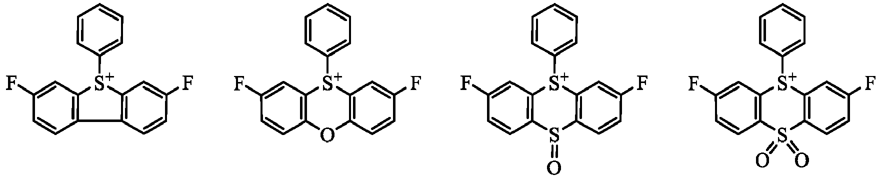

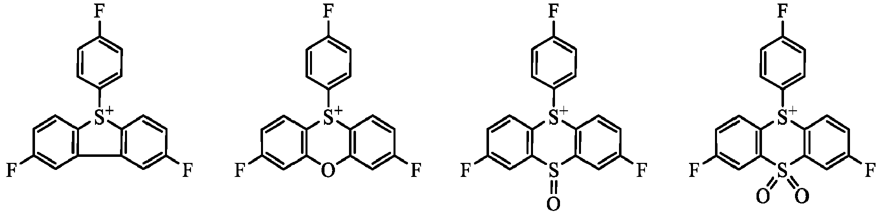

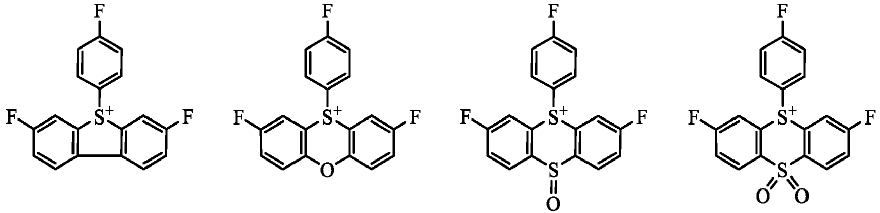

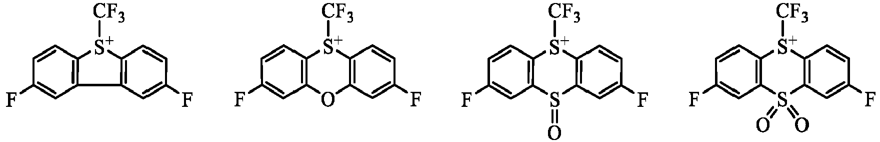

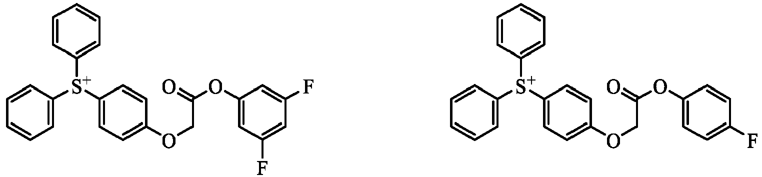

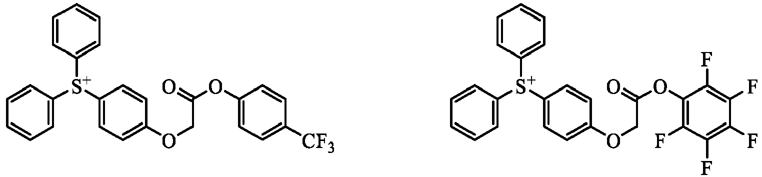

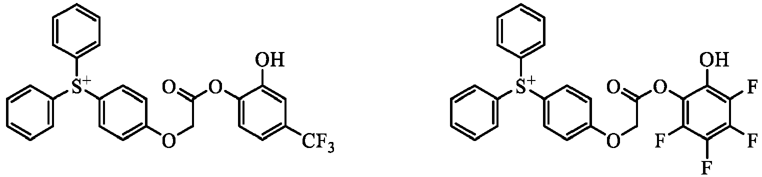

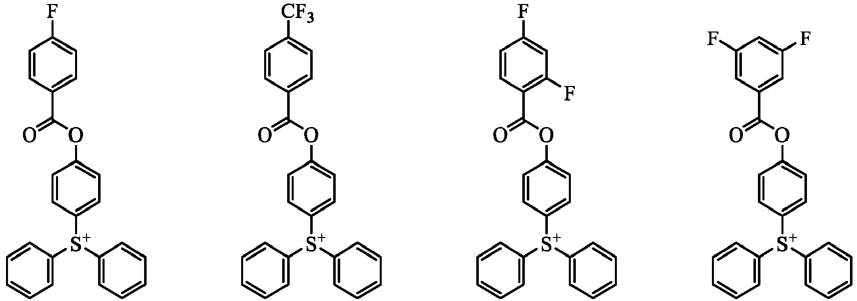

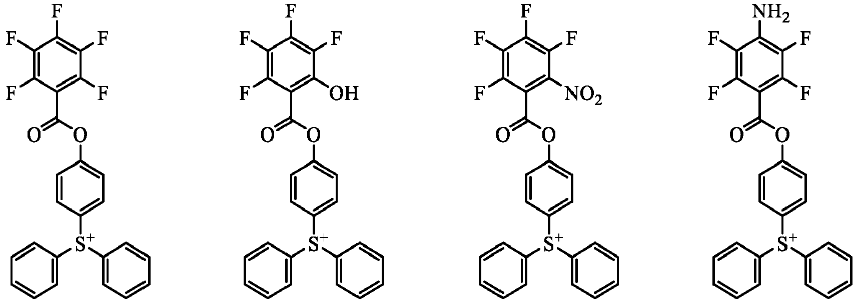

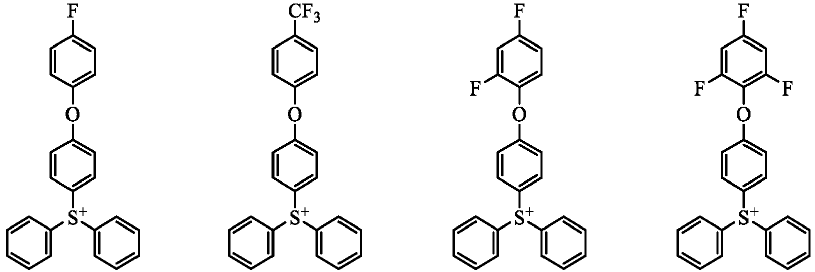

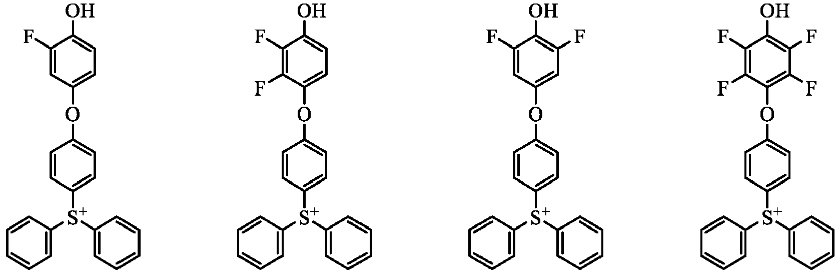

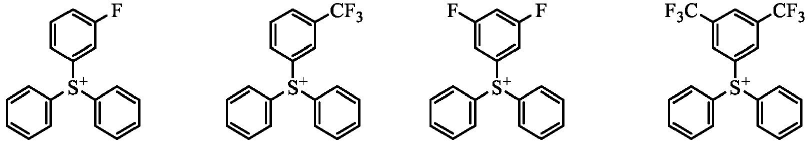

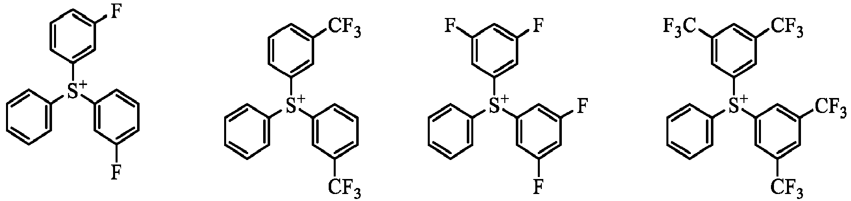

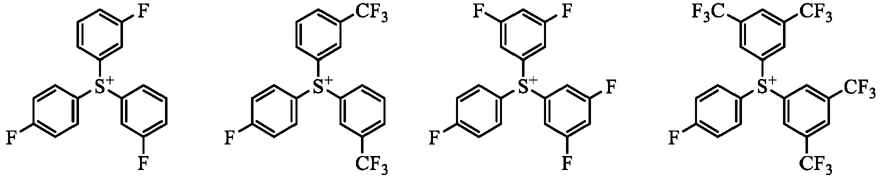

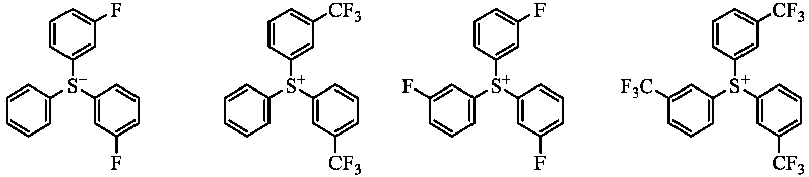

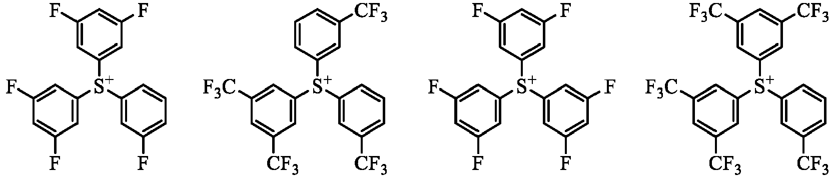

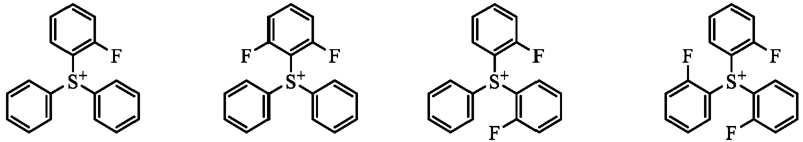

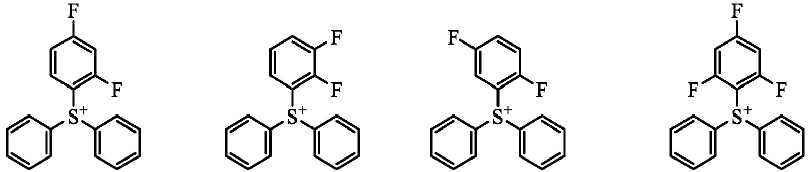

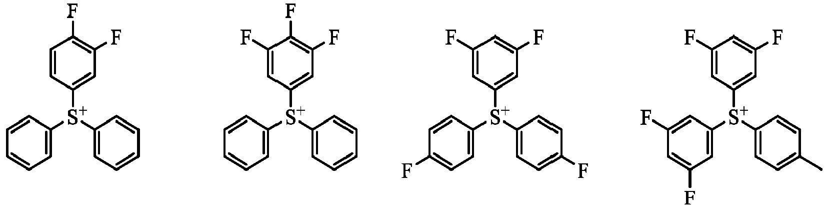

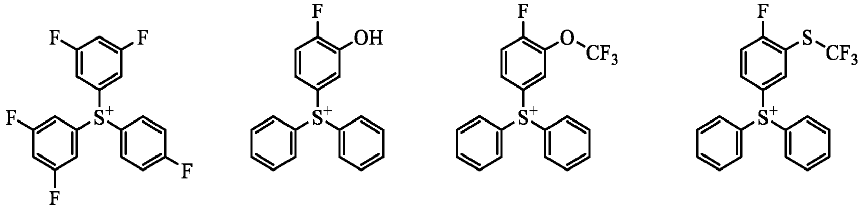

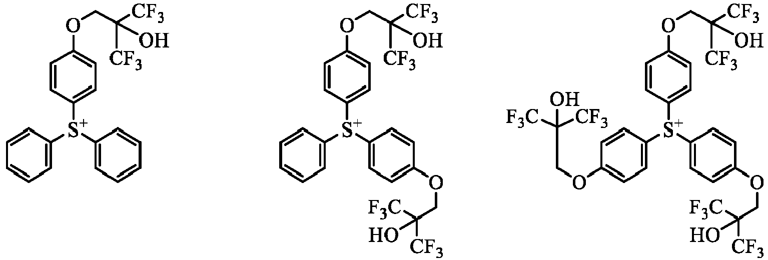

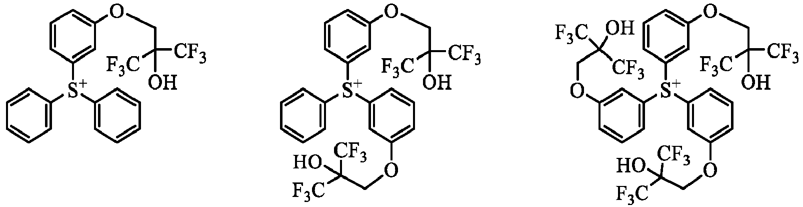

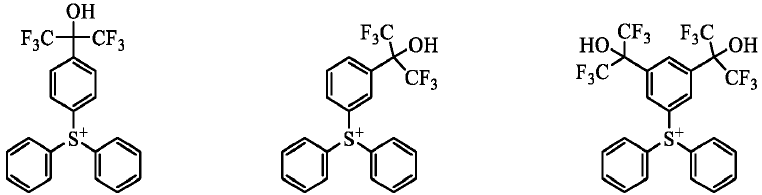

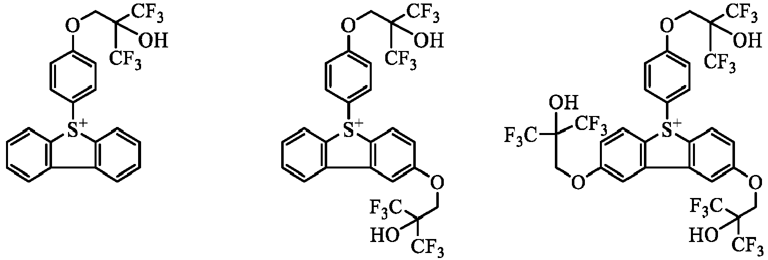

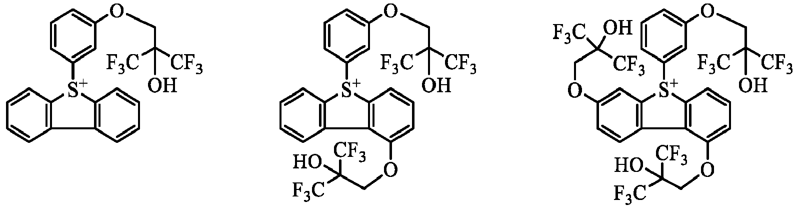

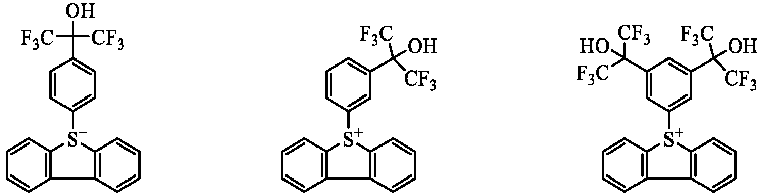

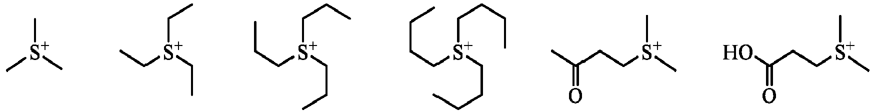

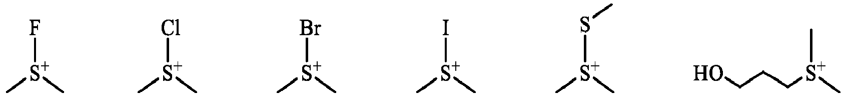

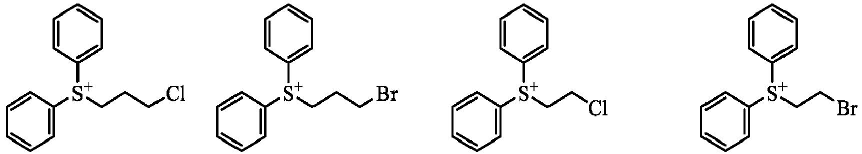

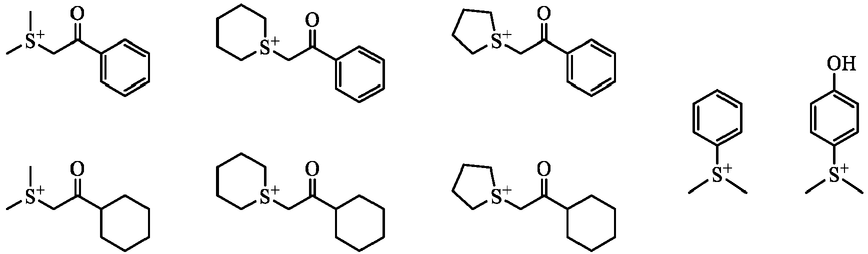

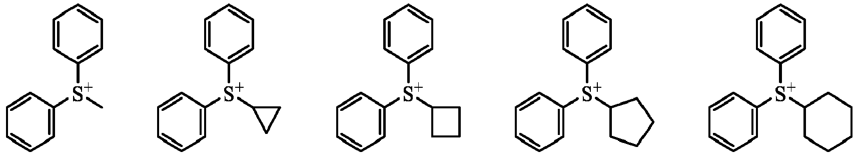

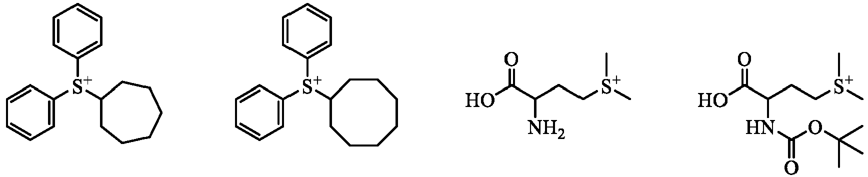

Exemplary structures of the iodonium cation having formula (E) are shown below, but not limited thereto.

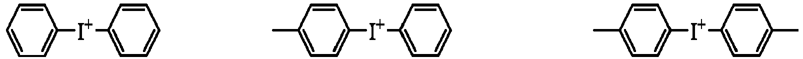

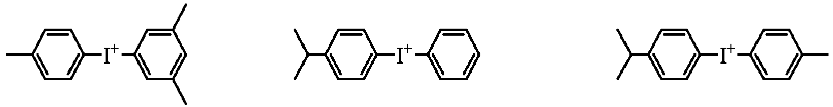

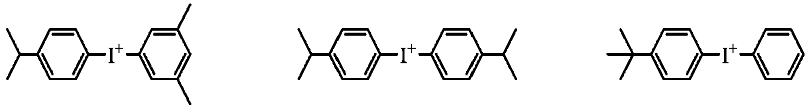

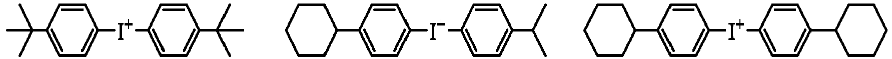

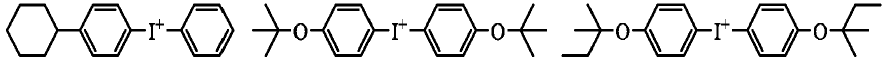

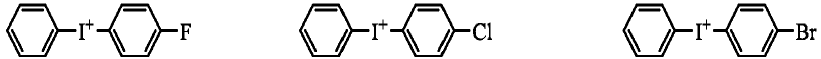

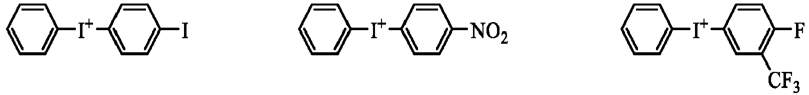

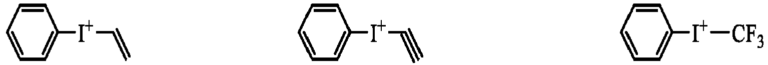

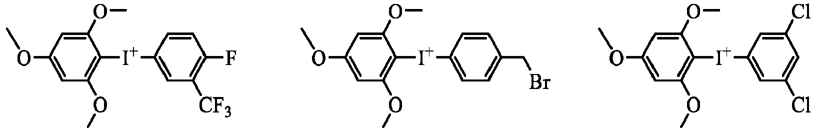

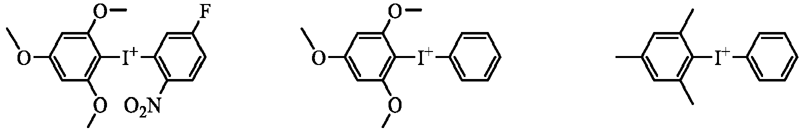

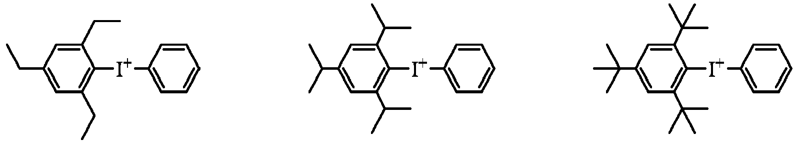

Preferably, the photoacid generator generates an acid having a pKa value of equal to or more than -2.0. The upper limit of pKa is preferably 2.0. Notably, the pKa value is computed using pKa DB in software ACD/Chemsketch ver: 9.04 of Advanced Chemistry Development Inc.

An appropriate amount of the photoacid generator of addition type used is 1 to 30 parts, more preferably 2 to 20 parts by weight per 80 parts by weight of the base polymer. The photoacid generator may be used alone or in admixture.

### Quencher

The positive resist composition preferably contains a quencher. The quencher is typically selected from conventional basic compounds. Conventional basic compounds include primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, and carbamate derivatives. Also included are primary, secondary, and tertiary amine compounds, specifically amine compounds having a hydroxy group, ether bond, ester bond, lactone ring, cyano group, or sulfonic ester bond as described in JP-A 2008-111103, paragraphs [0146]-[0164], and compounds having a carbamate group as described in JP 3790649. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound is effective for further suppressing the diffusion rate of acid in the resist film or correcting the pattern profile.

Onium salts such as sulfonium salts, iodonium salts and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. An α-non-fluorinated carboxylic acid functions as a quencher because it does not induce substantial deprotection reaction.

Examples of the onium salt of α-non-fluorinated carboxylic acid include compounds having the formula (F1).

R³⁰¹-CO₂⁻ Mq⁺ (F1)

In formula (F1), R³⁰¹ is hydrogen or a C₁-C₄₀ hydrocarbyl group which may contain a heteroatom, exclusive of the hydrocarbyl group in which the hydrogen bonded to the carbon atom at α-position of the sulfo group is substituted by fluorine or fluoroalkyl.

The hydrocarbyl group may be saturated or unsaturated and straight, branched or cyclic. Examples thereof include C₁-C₄₀ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), dialkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In these groups, some hydrogen may be substituted by a moiety containing a heteroatom such as oxygen, sulfur, nitrogen or halogen, and some carbon may be replaced by a moiety containing a heteroatom such as oxygen, sulfur or nitrogen, so that the group may contain a hydroxy moiety, cyano moiety, carbonyl moiety, ether bond, thioether bond, ester bond, sulfonic ester bond, carbonate bond, lactone ring, sultone ring, carboxylic anhydride (-C(=O)-O-C(=O)-), or haloalkyl moiety. Suitable heteroatom-containing hydrocarbyl groups include heteroaryl groups such as thienyl; alkoxyphenyl groups such as 4-hydroxyphenyl, 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (F1), Mq⁺ is an onium cation. The onium cation is preferably selected from sulfonium, iodonium and ammonium cations, more preferably sulfonium and iodonium cations. Exemplary sulfonium cations are as exemplified above for the sulfonium cation having formula (D). Exemplary iodonium cations are as exemplified above for the iodonium cation having formula (E).

Examples of the anion of the salt having formula (F1) are shown below, but not limited thereto.

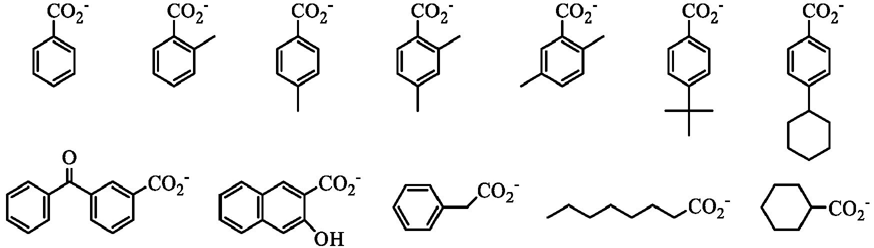

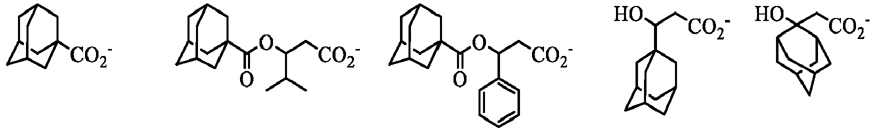

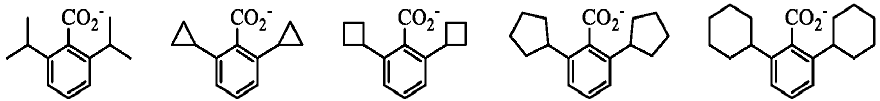

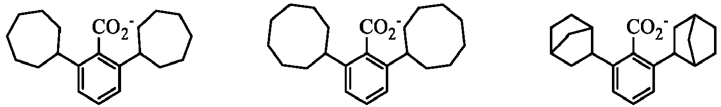

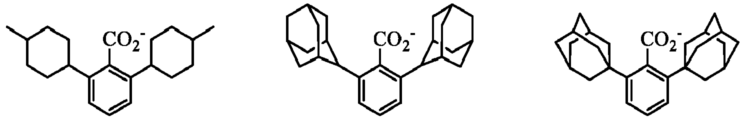

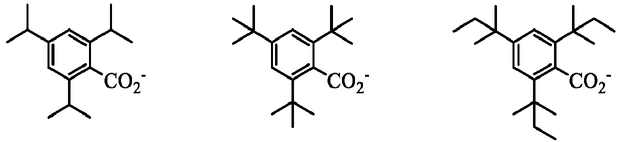

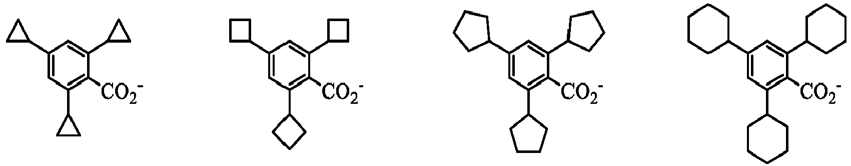

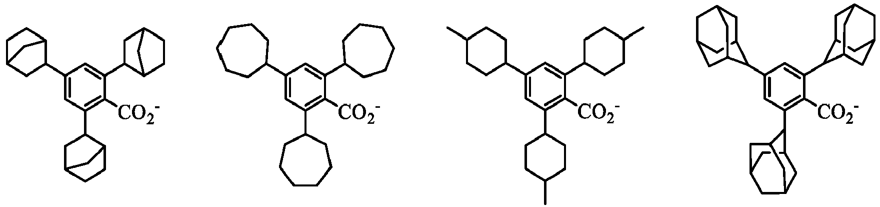

A sulfonium salt of iodized benzene ring-containing carboxylic acid having the formula (F2) is also useful as the quencher.

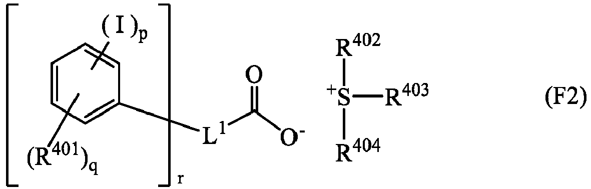

In formula (F2), R⁴⁰¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy or C₁-C₄ saturated hydrocarbylsulfonyloxy group, in which some or all hydrogen may be substituted by halogen, or -N(R^{401A})-C(=O)-R^{401B}, or -N(R^{401A})-C(=O)-O-R^{401B}. R^{401A} is hydrogen or a C₁-C₆ saturated hydrocarbyl group. R^{401B} is a C₁-C₆ saturated hydrocarbyl or C₂-C₈ unsaturated aliphatic hydrocarbyl group.

In formula (F2), p is an integer of 1 to 5, q is an integer of 0 to 3, and r is an integer of 1 to 3. L¹ is a single bond, or a C₁-C₂₀ (r+1)-valent linking group which may contain at least one moiety selected from ether bond, carbonyl moiety, ester bond, amide bond, sultone ring, lactam ring, carbonate moiety, halogen, hydroxy moiety, and carboxy moiety. The saturated hydrocarbyl, saturated hydrocarbyloxy, saturated hydrocarbylcarbonyloxy, and saturated hydrocarbylsulfonyloxy groups may be straight, branched or cyclic. Groups R⁴⁰¹ may be the same or different when q and/or r is 2 or 3.

In formula (F2), R⁴⁰², R⁴⁰³ and R⁴⁰⁴ are each independently halogen, or a C₁-C₂₀ hydrocarbyl group which may contain a heteroatom. The hydrocarbyl group may be saturated or unsaturated and straight, branched or cyclic. Examples thereof include C₁-C₂₀ alkyl, C₂-C₂₀ alkenyl, C₆-C₂₀ aryl, and C₇-C₂₀ aralkyl groups. In these groups, some or all hydrogen may be substituted by hydroxy, carboxy, halogen, oxo, cyano, nitro, sultone, sulfone, or sulfonium salt-containing moiety, or some carbon may be replaced by an ether bond, ester bond, carbonyl moiety, amide bond, carbonate bond or sulfonic ester bond. Also R⁴⁰² and R⁴⁰³ may bond together to form a ring with the sulfur atom to which they are attached.

Examples of the compound having formula (F2) include those described in USP 10,295,904 (JP-A 2017-219836). These compounds exert a sensitizing effect due to remarkable absorption and an acid diffusion controlling effect.

A nitrogen-containing carboxylic acid salt compound having the formula (F3) is also useful as the quencher.

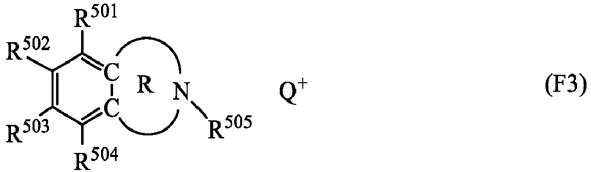

In formula (F3), R⁵⁰¹ to R⁵⁰⁴ are each independently hydrogen, -L²-CO₂⁻, or a C₁-C₂₀ hydrocarbyl group which may contain a heteroatom. R⁵⁰¹ and R⁵⁰², R⁵⁰² and R⁵⁰³, or R⁵⁰³ and R⁵⁰⁴ may bond together to form a ring with the carbon atom to which they are attached. L² is a single bond or a C₁-C₂₀ hydrocarbylene group which may contain a heteroatom. R⁵⁰⁵ is hydrogen or a C₁-C₂₀ hydrocarbyl group which may contain a heteroatom.

In formula (F3), the ring R is a C₂-C₆ ring containing the carbon and nitrogen atoms in the formula, in which some or all of the carbon-bonded hydrogen atoms may be substituted by a C₁-C₂₀ hydrocarbyl group or -L²-CO₂⁻ and in which some carbon may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (F3) has at least one -L²-CO₂⁻. That is, at least one of R⁵⁰¹ to R⁵⁰⁴ is -L²-CO₂⁻, and/or at least one of hydrogen atoms bonded to carbon atoms in the ring R is substituted by -L²-CO₂⁻.

In formula (F3), Q⁺ is a sulfonium, iodonium or ammonium cation, with the sulfonium cation being preferred. Examples of the sulfonium cation are as exemplified above for the cation having formula (D).

Examples of the anion in the compound having formula (F3) are shown below, but not limited thereto.

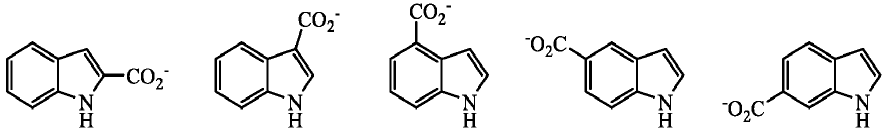

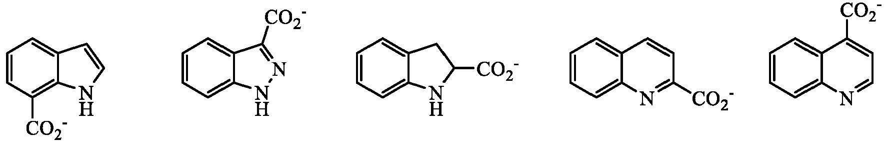

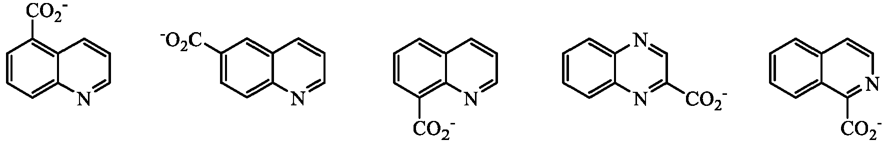

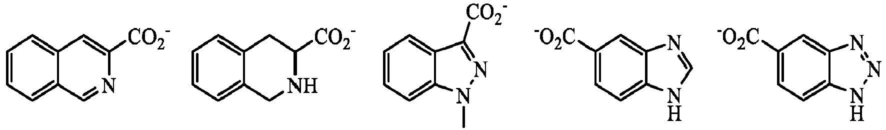

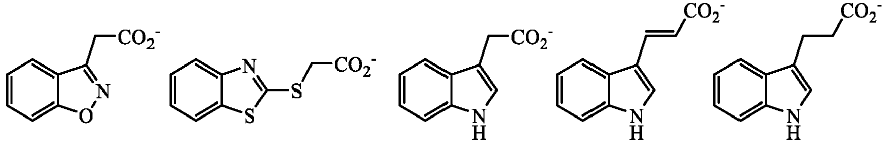

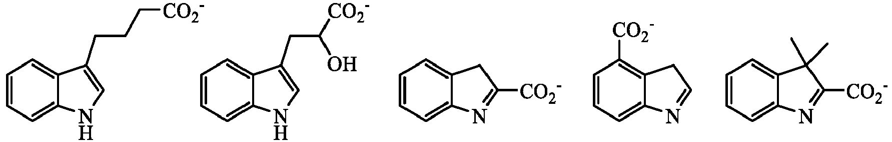

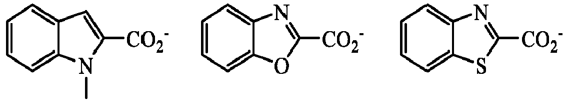

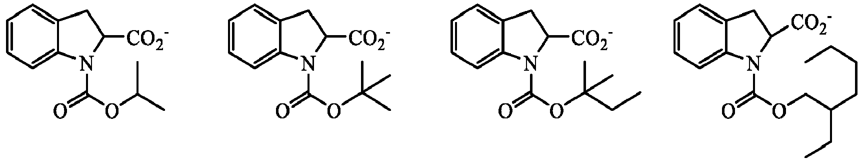

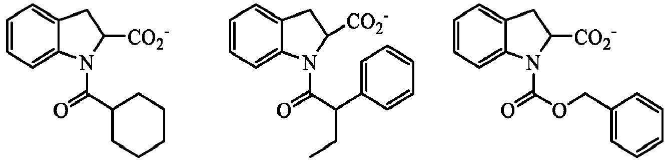

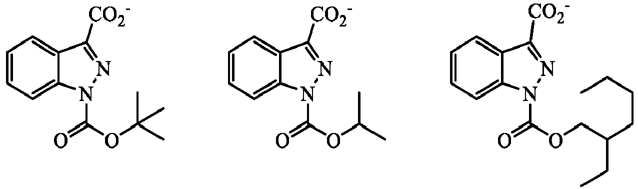

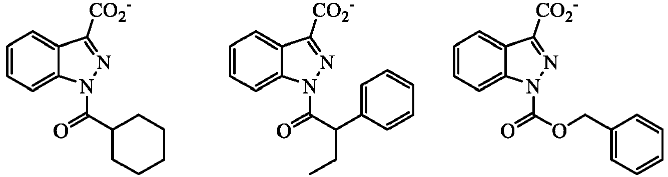

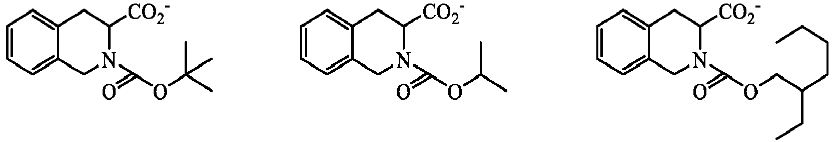

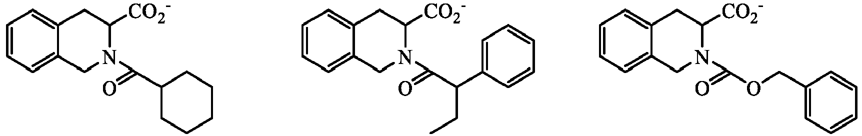

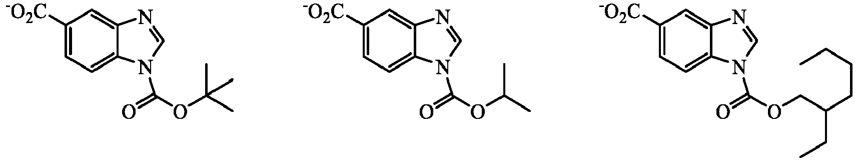

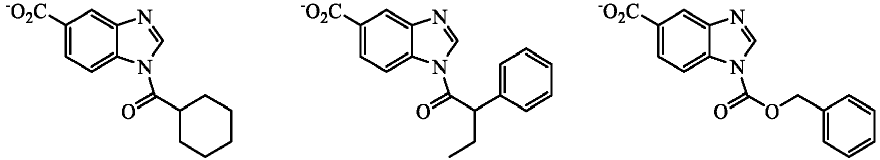

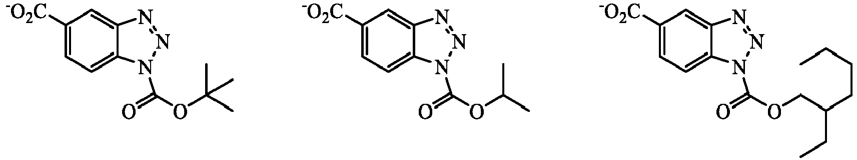

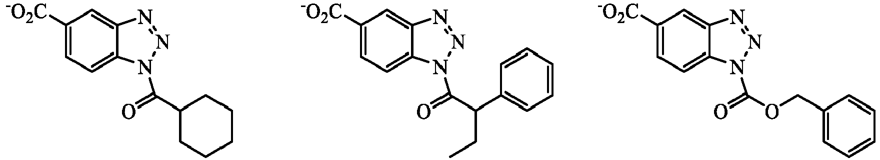

Weak acid betaine compounds are also useful as the quencher. Non-limiting examples thereof are shown below.

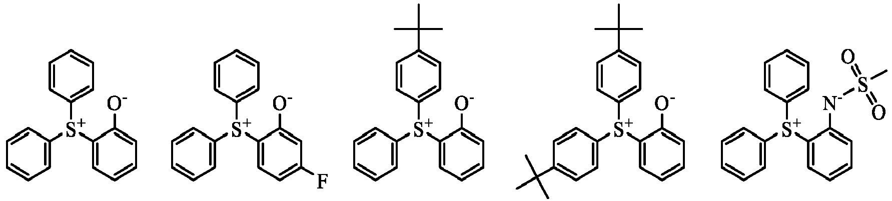

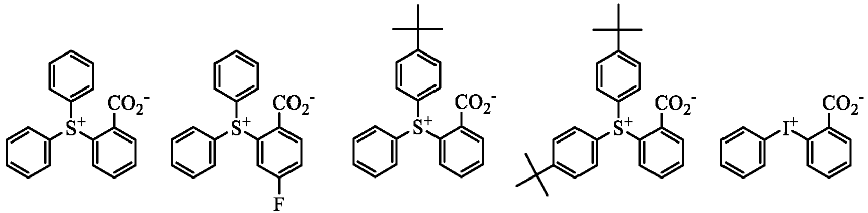

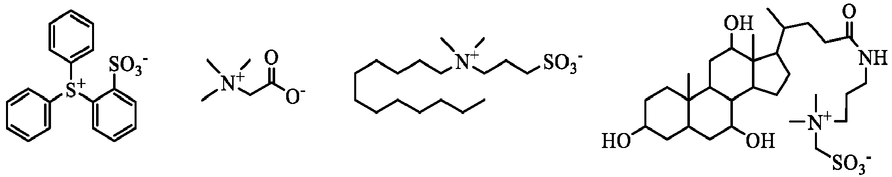

Also useful are quenchers of polymer type as described in USP 7,598,016 (JP-A 2008-239918). The polymeric quencher segregates at the resist surface after coating and thus enhances the rectangularity of resist pattern. When a protective film is applied as is often the case in the immersion lithography, the polymeric quencher is also effective for preventing a film thickness loss of resist pattern or rounding of pattern top.

When used, the quencher is preferably added in an amount of 0 to 50 parts, more preferably 0.1 to 40 parts by weight per 80 parts by weight of the base polymer. The quencher may be used alone or in admixture.

### Surfactant

The positive resist composition may contain any conventional surfactants for facilitating to coat the composition to the substrate. A number of surfactants are known in the art as described in JP-A 2004-115630, and any suitable one may be chosen therefrom. The amount of surfactant added is preferably 0 to 5 parts by weight per 80 parts by weight of the base polymer. It is noted that the surfactant need not be added when the positive resist composition contains a fluorinated polymer as mentioned above, which also plays the role of a surfactant.

From the standpoint of improving the develop loading effect, the chemically amplified positive resist composition is preferably designed such that a resist film formed therefrom in an over-exposed region may have a dissolution rate in alkaline developer of at least 50 nm/sec, more preferably at least 100 nm/sec, even more preferably at least 200 nm/sec. As long as the dissolution rate is at least 50 nm/sec, the resist film is uniformly dissolved in alkaline developer independent of a pattern layout difference in the case of a grouped/isolated pattern, and the variation of line width can be minimized. It is noted that the dissolution rate of an over-exposed region is computed by spin coating the positive resist composition onto a 8-inch silicon wafer, baking at 110°C for 60 seconds to form a resist film of 90 nm thick, exposing the resist film to KrF excimer laser radiation in a sufficient energy dose to complete deprotection reaction on the polymer, baking at 110°C for 60 seconds, developing the film in a 2.38 wt% TMAH aqueous solution at 23°C, and measuring a loss of film thickness by means of a resist development analyzer.

Also preferably, the resist film formed from the positive resist composition in an unexposed region has a dissolution rate in alkaline developer of up to 10 nm/min, more preferably up to 8 nm/min, even more preferably up to 6 nm/min. Where the resist film is in the thin film range of up to 100 nm, the influence of pattern film thickness loss in alkaline developer becomes greater. If the dissolution rate in unexposed region is more than 10 nm/min, pattern collapse will occur, failing to form a small size pattern. The problem becomes outstanding in the fabrication of photomasks requiring to be defectless and having a tendency of strong development process. It is noted that the dissolution rate of an unexposed region is computed by spin coating the positive resist composition onto a 6-inch silicon wafer, baking at 110°C for 240 seconds to form a resist film of 80 nm thick, developing the film in a 2.38 wt% TMAH aqueous solution at 23°C for 80 seconds, and measuring a loss of film thickness.

### Pattern forming process

A further embodiment of the invention is a process for forming a resist pattern comprising the steps of applying the chemically amplified positive resist composition onto a substrate to form a resist film thereon, exposing patternwise the resist film to high-energy radiation, and developing the exposed resist film in an alkaline developer.

The resist composition is first applied onto a substrate on which an integrated circuit is to be formed (e.g., Si, SiO, SiO₂, SiN, SiON, TiN, WSi, BPSG, SOG, or organic antireflective coating) or a substrate on which a mask circuit is to be formed (e.g., Cr, CrO, CrON, MoSi₂, Si, SiO, SiO₂, SiON, SiONC, CoTa, NiTa, TaBN, or SnO₂) by a suitable coating technique such as spin coating. The coating is prebaked on a hot plate at a temperature of preferably 60 to 150°C for 1 to 20 minutes, more preferably at 80 to 140°C for 1 to 10 minutes. The resulting resist film is generally 0.03 to 2 µm thick.

The resist film is then exposed to a desired pattern of high-energy radiation such as UV, deep-UV, excimer laser radiation (KrF, ArF, etc.), EUV, x-ray, γ-ray, synchrotron radiation or EB. Exposure using EUV or EB is preferred.

When UV, deep-UV, excimer laser, EUV, x-ray, γ-ray or synchrotron radiation is used as the high-energy radiation, the resist film is exposed thereto through a mask having a desired pattern in a dose of preferably 1 to 500 mJ/cm², more preferably 10 to 400 mJ/cm². When EB is used as the high-energy radiation, the resist film is exposed thereto directly in a dose of preferably 1 to 500 µC/cm², more preferably 10 to 400 µC/cm².

The exposure may be performed by conventional lithography whereas the immersion lithography of holding a liquid between the resist film and the mask may be employed if desired. In the case of immersion lithography, a protective film which is insoluble in water may be formed on the resist film.

After the exposure, the resist film may be baked (PEB) on a hotplate preferably at 60 to 150°C for 1 to 20 minutes, more preferably at 80 to 140°C for 1 to 10 minutes.

After the exposure or PEB, the resist film is developed in a developer in the form of an aqueous alkaline solution for preferably 0.1 to 3 minutes, more preferably 0.5 to 2 minutes by conventional techniques such as dip, puddle and spray techniques. A typical developer is a 0.1 to 5 wt%, preferably 2 to 3 wt% aqueous solution of tetramethylammonium hydroxide (TMAH) or another alkali. In this way, the desired pattern is formed on the substrate.

The positive resist composition of the invention is useful in forming a resist pattern having a satisfactory resolution and reduced LER. The positive resist composition is also useful in forming a resist pattern on a substrate having a surface layer of a material which is less adhesive to a resist film with a likelihood of later pattern stripping or pattern collapse. Examples of such substrate include substrates having sputter deposited on their outermost surface a layer of metallic chromium or a chromium compound containing one or more light elements such as oxygen, nitrogen and carbon, and substrates having an outermost layer of SiO, SiOₓ, or a tantalum, molybdenum, cobalt, nickel, tungsten or tin compound. The substrate to which the positive resist composition is applied is most typically a photomask blank which may be of transmission or reflection type.

The resist pattern forming process is successful in forming patterns having a high resolution, minimized influence of develop loading, and a reduced size difference independent of a pattern density (grouped or isolated) even on a substrate (typically photomask blank) whose outermost surface is made of a material tending to affect resist pattern profile such as a chromium, silicon or tantalum-containing material.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards.

### [1] Synthesis of polymer

### Synthesis Example 1-1

### Synthesis of Polymer P-1

In nitrogen atmosphere, a 300-mL dropping cylinder was charged with 49.3 g of 4-acetoxystyrene, 18.9 g of 4-(1-methyl-1-cyclopentyloxy)styrene, 11.8 g of 1-methylcyclopentyl methacrylate, 8.6 g of dimethyl-2,2'-azobis(2-methylpropionate) (tradename V-601 by Fujifilm Wako Pure Chemical), and 124 g of methyl ethyl ketone (MEK) solvent to form a monomer solution. In nitrogen atmosphere, a 500-mL flask was charged with 62 g of MEK and heated at 80°C. The monomer solution was added dropwise to the flask over 4 hours. After the completion of dropwise addition, the polymerization solution was continuously stirred for 18 hours while maintaining its temperature at 80°C. The polymerization solution was cooled to room temperature and added dropwise to 1,300 g of hexane for precipitation. The solid precipitate or copolymer was collected by filtration. The copolymer was washed twice with 500 g of hexane. In a 1-L flask under nitrogen atmosphere, the copolymer was dissolved in a mixture of 144 g of THF and 48 g of methanol. 22.3 g of ethanolamine was added to the solution, which was stirred at 60°C for 3 hours. The reaction solution was concentrated under reduced pressure. The concentrate was dissolved in a mixture of 240 g of ethyl acetate and 60 g of water. The solution was transferred to a separatory funnel, to which 11.1 g of acetic acid was added and separatory operation was carried out. After the lower layer was removed, 60 g of water and 14.8 g of pyridine were added to the organic layer, followed by separatory operation. After the lower layer was removed, 60 g of water was added to the organic layer, followed by separatory operation. The water washing/separation cycle was repeated 5 times in total. The organic layer as separated was concentrated and dissolved in 130 g of acetone. The acetone solution was added dropwise to 1,200 g of water for precipitation. The crystallized precipitate was filtered, washed with water, and suction filtered for 2 hours. The product as filtered was dissolved in 130 g of acetone. The acetone solution was added dropwise to 1,200 g of water for precipitation. The crystallized precipitate was filtered, washed with water, and dried. There was obtained 50.3 g of the target polymer P-1 as white solid. Polymer P-1 was analyzed by ¹H-NMR, ¹³C-NMR and GPC, with the results shown below.

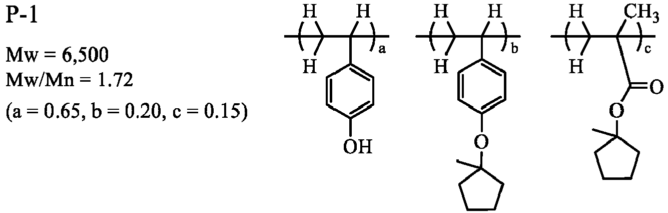

### Synthesis Examples 1-2 to 1-44 and Comparative Synthesis Examples 1-1 to 1-2

### Synthesis of Polymers P-2 to P-44 and Comparative Polymers cP-1 and cP-2

Polymers P-2 to P-44 and Comparative Polymers cP-1 and cP-2 in Tables 1 to 3 were synthesized by the same procedure as Synthesis Example 1-1 except that the type and amount (mol%) of monomers were changed. In Tables 1 to 3, the incorporation ratio is a molar ratio.

**Table 1**

| | Unit 1 | Incorporation ratio (mol%) | Unit 2 | Incorporation ratio (mol%) | Unit 3 | Incorporation ratio (mol%) | Unit 4 | Incorporation ratio (mol%) | Mw | Mw/Mn |
|---|---|---|---|---|---|---|---|---|---|---|
| P-1 | A-1 | 65.0 | C-1 | 20.0 | C-5 | 15.0 | - | - | 4,500 | 1.62 |
| P-2 | A-1 | 60.0 | B-1 | 10.0 | C-1 | 15.0 | C-5 | 15.0 | 6,600 | 1.60 |
| P-3 | A-1 | 60.0 | B-2 | 15.0 | C-1 | 15.0 | C-5 | 10.0 | 6,400 | 1.58 |
| P-4 | A-1 | 60.0 | B-2 | 10.0 | C-1 | 15.0 | C-5 | 15.0 | 6,900 | 1.61 |
| P-5 | A-1 | 60.0 | B-3 | 10.0 | C-1 | 15.0 | C-5 | 15.0 | 6,500 | 1.69 |
| P-6 | A-1 | 60.0 | B-4 | 10.0 | C-1 | 15.0 | C-5 | 15.0 | 6,400 | 1.68 |
| P-7 | A-1 | 60.0 | B-2 | 10.0 | C-2 | 200 | C-6 | 10.0 | 6,700 | 1.67 |
| P-8 | A-1 | 60.0 | B-2 | 10.0 | C-3 | 10.0 | C-5 | 20.0 | 6,800 | 1.65 |
| P-9 | A-1 | 60.0 | B-2 | 10.0 | C-4 | 15.0 | C-5 | 15.0 | 7,200 | 1.66 |
| P-10 | A-1 | 60.0 | B-2 | 10.0 | C-9 | 15.0 | C-5 | 15.0 | 6,500 | 1.67 |
| P-11 | A-1 | 65.0 | B-2 | 10.0 | C-1 | 15.0 | C-6 | 10.0 | 6,600 | 1.68 |
| P-12 | A-1 | 65.0 | B-2 | 10.0 | C-1 | 15.0 | C-7 | 10.0 | 6,400 | 1.65 |
| P-13 | A-1 | 65.0 | B-2 | 10.0 | C-1 | 15.0 | C-8 | 10.0 | 6,600 | 1.68 |
| P-14 | A-1 | 60.0 | B-2 | 10.0 | C-1 | 15.0 | C-12 | 15.0 | 6,500 | 1.66 |
| P-15 | A-1 | 60.0 | B-2 | 10.0 | C-1 | 15.0 | C-19 | 15.0 | 6,600 | 1.67 |
| P-16 | A-1 | 60.0 | B-2 | 10.0 | C-1 | 15.0 | C-20 | 15.0 | 6,700 | 1.64 |
| P-17 | A-1 | 60.0 | B-2 | 10.0 | C-1 | 15.0 | C-21 | 15.0 | 6,600 | 1.65 |
| P-18 | A-1 | 65.0 | B-2 | 10.0 | C-1 | 15.0 | C-22 | 10.0 | 6,400 | 1.64 |
| P-19 | A-1 | 65.0 | B-2 | 10.0 | C-1 | 15.0 | C-23 | 10.0 | 6,500 | 1.66 |
| P-20 | A-1 | 65.0 | B-2 | 10.0 | C-1 | 15.0 | C-24 | 10.0 | 6,800 | 1.63 |
| P-21 | A-1 | 65.0 | B-2 | 10.0 | C-1 | 15.0 | C-25 | 10.0 | 6,700 | 1.62 |
| P-22 | A-1 | 65.0 | B-2 | 10.0 | C-1 | 15.0 | C-26 | 10.0 | 6,800 | 1.65 |
| P-23 | A-1 | 65.0 | B-2 | 10.0 | C-1 | 15.0 | C-27 | 10.0 | 6,800 | 1.64 |
| P-24 | A-1 | 60.0 | B-2 | 10.0 | C-13 | 15.0 | C-5 | 15.0 | 6,400 | 1.70 |
| P-25 | A-1 | 60.0 | B-2 | 10.0 | C-14 | 15.0 | C-5 | 15.0 | 6,500 | 1.70 |
| P-26 | A-1 | 65.0 | B-2 | 10.0 | C-15 | 10.0 | C-5 | 15.0 | 6,500 | 1.68 |
| P-27 | A-1 | 65.0 | B-2 | 10.0 | C-16 | 10.0 | C-5 | 15.0 | 6,400 | 1.67 |
| P-28 | A-1 | 65.0 | B-2 | 10.0 | C-17 | 10.0 | C-5 | 15.0 | 6,600 | 1.68 |
| P-29 | A-1 | 65.0 | B-2 | 10.0 | C-18 | 10.0 | C-5 | 15.0 | 6,700 | 1.70 |
| P-30 | A-1 | 65.0 | B-2 | 10.0 | C-10 | 10.0 | C-1 | 15.0 | 6,800 | 1.65 |
| P-31 | A-1 | 65.0 | B-2 | 10.0 | C-11 | 10.0 | C-1 | 15.0 | 6,600 | 1.66 |

**Table 2**

| | Unit 1 | Incorporation ratio (mol%) | Unit 2 | Incorporation ratio (mol%) | Unit 3 | Incorporation ratio (mol%) | Unit 4 | Incorporation ratio (mol%) | Mw | Mw/Mn |
|---|---|---|---|---|---|---|---|---|---|---|
| P-32 | A-2 | 60.0 | B-3 | 10.0 | C-1 | 15.0 | C-5 | 15.0 | 7,300 | 1.67 |
| P-33 | A-2 | 70.0 | C-1 | 15.0 | C-5 | 15.0 | - | - | 6,100 | 1.68 |
| P-34 | A-2 | 70.0 | C-1 | 15.0 | C-19 | 15.0 | - | - | 6,300 | 1.66 |
| P-35 | A-2 | 70.0 | C-10 | 15.0 | C-1 | 15.0 | - | - | 6,400 | 1.68 |
| P-36 | A-3 | 60.0 | B-3 | 10.0 | C-1 | 15.0 | C-5 | 15.0 | 7,500 | 1.68 |
| P-37 | A-3 | 70.0 | C-1 | 15.0 | C-5 | 15.0 | - | - | 6,500 | 1.69 |
| P-38 | A-3 | 70.0 | C-1 | 15.0 | C-19 | 15.0 | - | - | 6,400 | 1.69 |
| P-39 | A-3 | 70.0 | C-10 | 15.0 | C-1 | 15.0 | - | - | 6,800 | 1.67 |
| P-40 | A-1 | 60.0 | B-2 | 10.0 | C-1 | 30.0 | - | - | 6,600 | 1.64 |
| P-41 | A-1 | 60.0 | B-2 | 10.0 | C-19 | 30.0 | - | - | 6,200 | 1.62 |
| P-42 | A-2 | 70.0 | C-1 | 30.0 | - | - | - | - | 6,200 | 1.67 |
| P-43 | A-2 | 70.0 | C-19 | 30.0 | - | - | - | - | 6,800 | 1.68 |
| P-44 | A-1 | 60.0 | C-1 | 5.0 | C-5 | 35.0 | - | - | 6,900 | 1.69 |

**Table 3**

| | Unit 1 | Incorporation ratio (mol%) | Unit 2 | Incorporation ratio (mol%) | Unit 3 | Incorporation ratio (mol%) | Unit 4 | Incorporation ratio (mol%) | Mw | Mw/Mn |
|---|---|---|---|---|---|---|---|---|---|---|
| cP-1 | A-1 | 78.0 | B-2 | 15.0 | C-1 | 4.0 | C-5 | 3.0 | 6,600 | 1.65 |
| cP-2 | A-1 | 55.0 | C-1 | 5.0 | C-5 | 400 | - | - | 6,800 | 1.67 |

The structure of repeat units incorporated in the polymers is shown below.

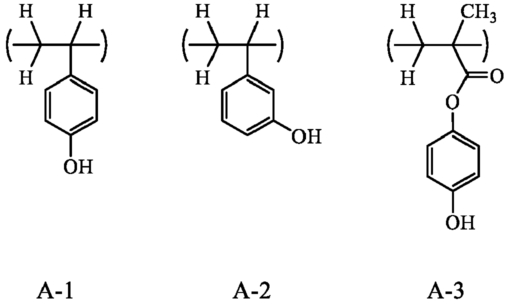

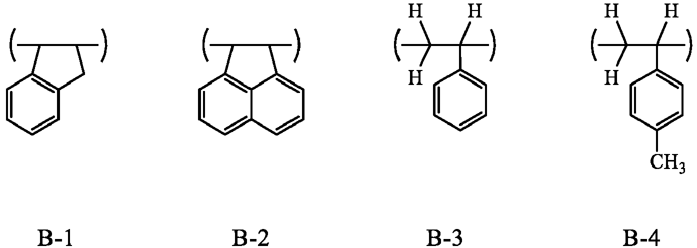

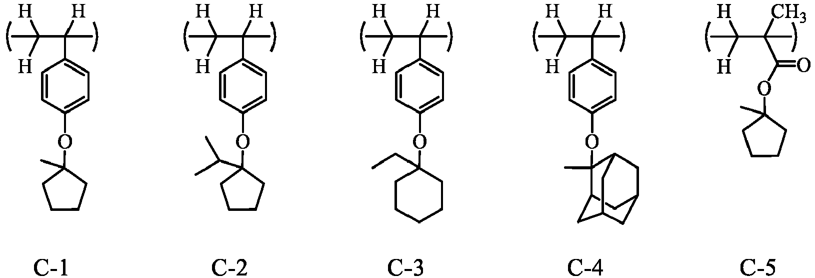

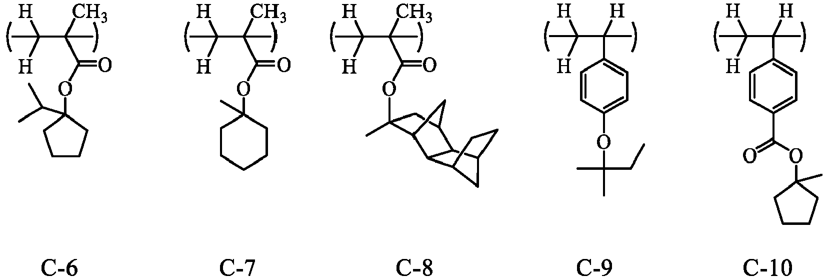

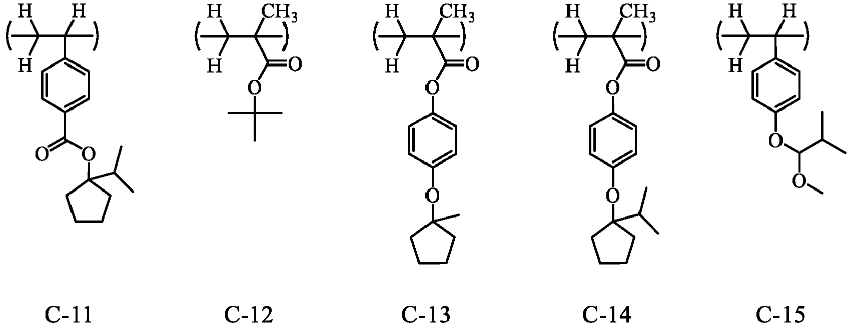

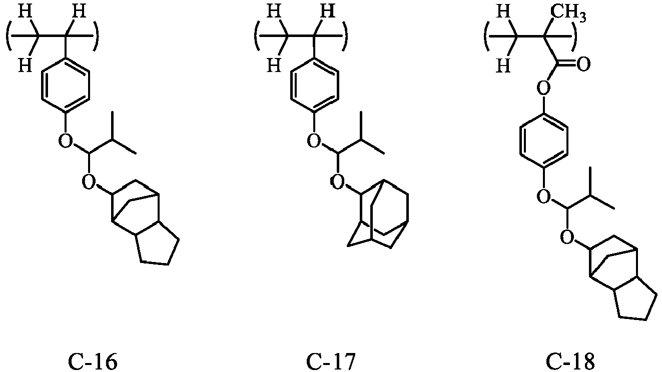

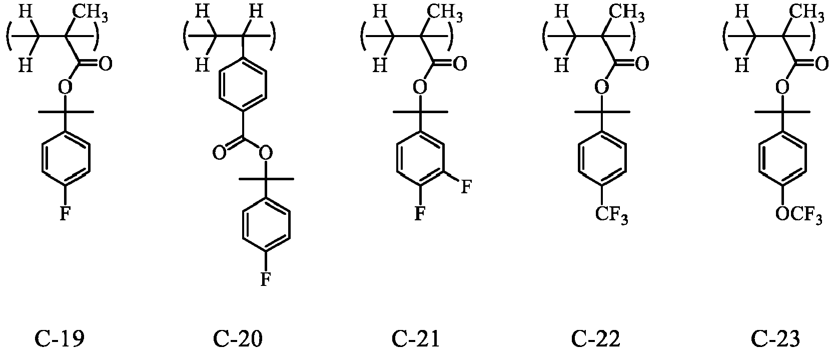

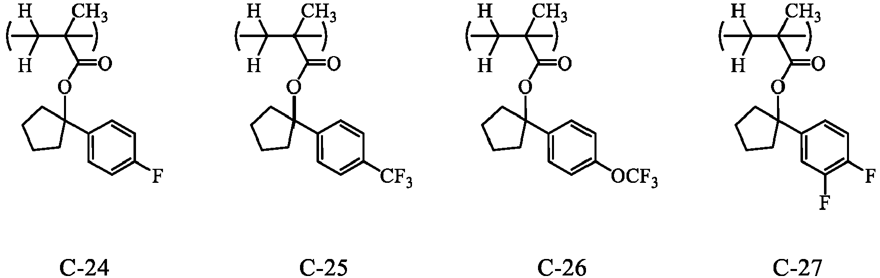

The dissolution rate of a polymer in alkaline developer was computed by spin coating a 16.7 wt% solution of the polymer in propylene glycol monomethyl ether (PGME) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness. Polymers P-1 to P-44 and Comparative Polymer cP-2 showed a dissolution rate of up to 10 nm/min. Comparative Polymer cP-1 showed a dissolution rate of 20 nm/min.

### Synthesis Examples 2-1 to 2-6

### Synthesis of Polymers AP-1 to AP-6 and Comparative Polymer cP-3

Polymers AP-1 to AP-6 and Comparative Polymer cP-3 were synthesized by the same procedure as Synthesis Example 1-1 except that the monomers were changed.

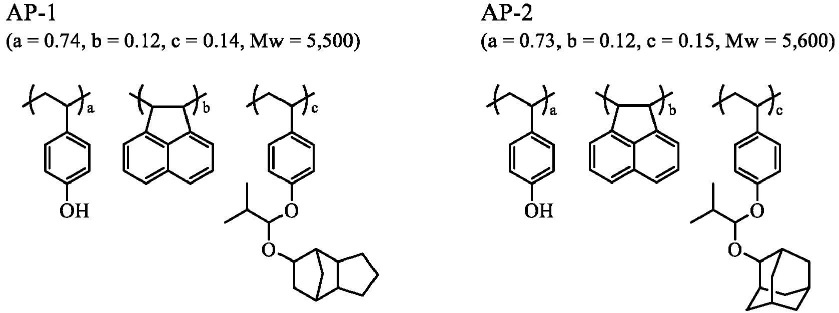

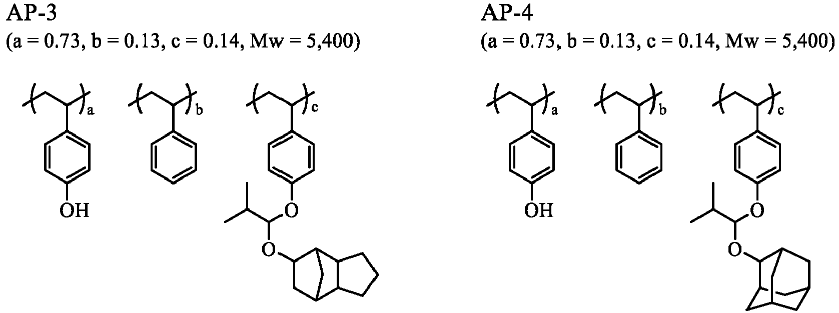

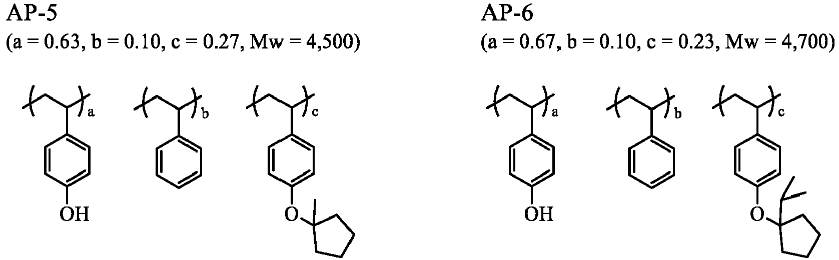

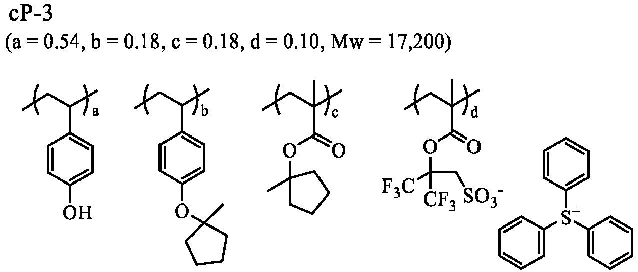

Polymers AP-1 to AP-6 and Comparative Polymer cP-3 showed a dissolution rate of up to 10 nm/min.

### [2] Preparation of chemically amplified positive resist compositions

### Examples 1-1 to 1-58 and Comparative Examples 1-1 to 1-5

Positive resist compositions were prepared by dissolving selected components in an organic solvent in accordance with the formulation shown in Tables 4 to 7, and filtering the solution through a UPE filter with a pore size of 0.02 µm. The organic solvent was a mixture of 340 pbw of PGMEA, 1,700 pbw of EL, and 1,360 pbw of PGME.

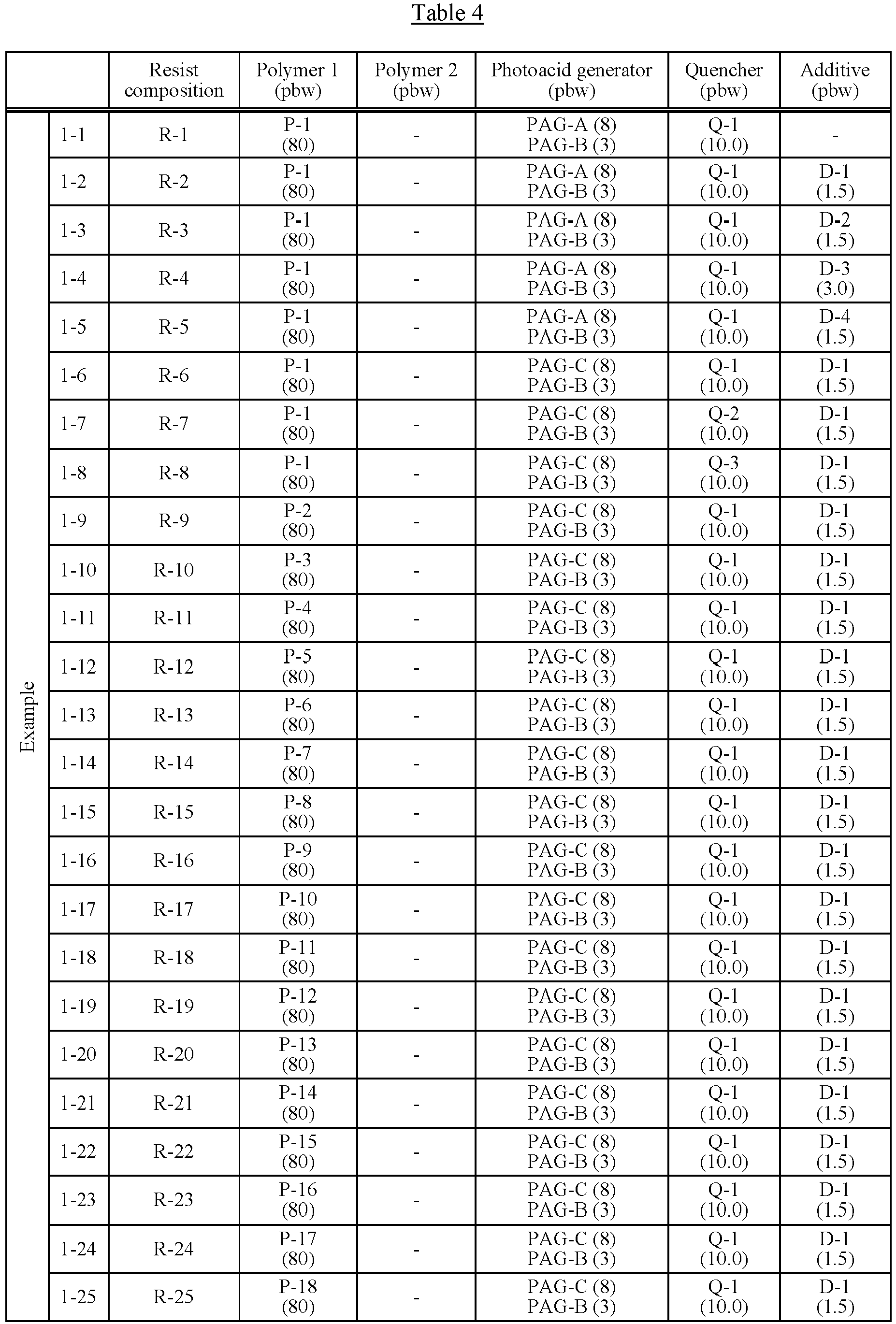

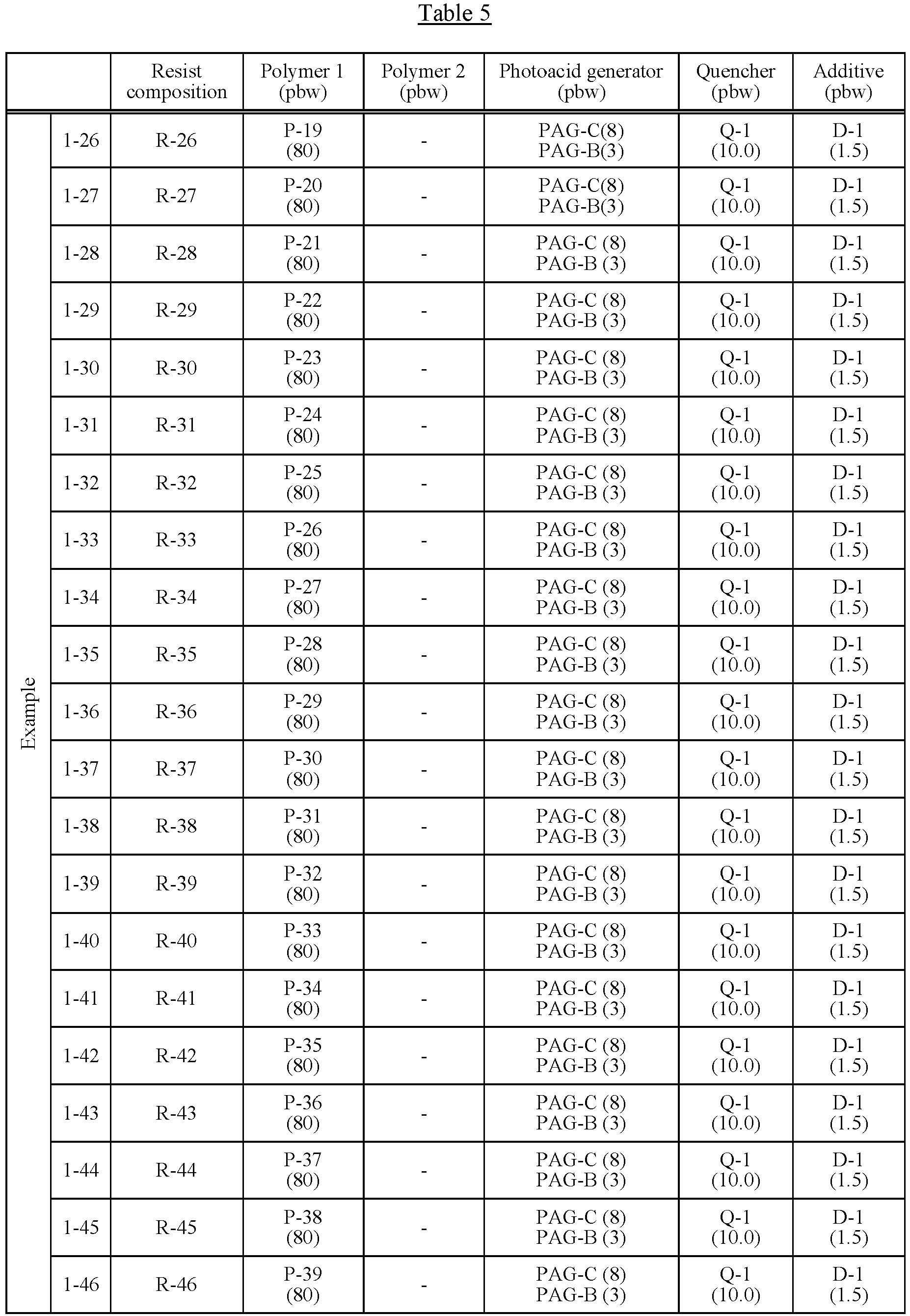

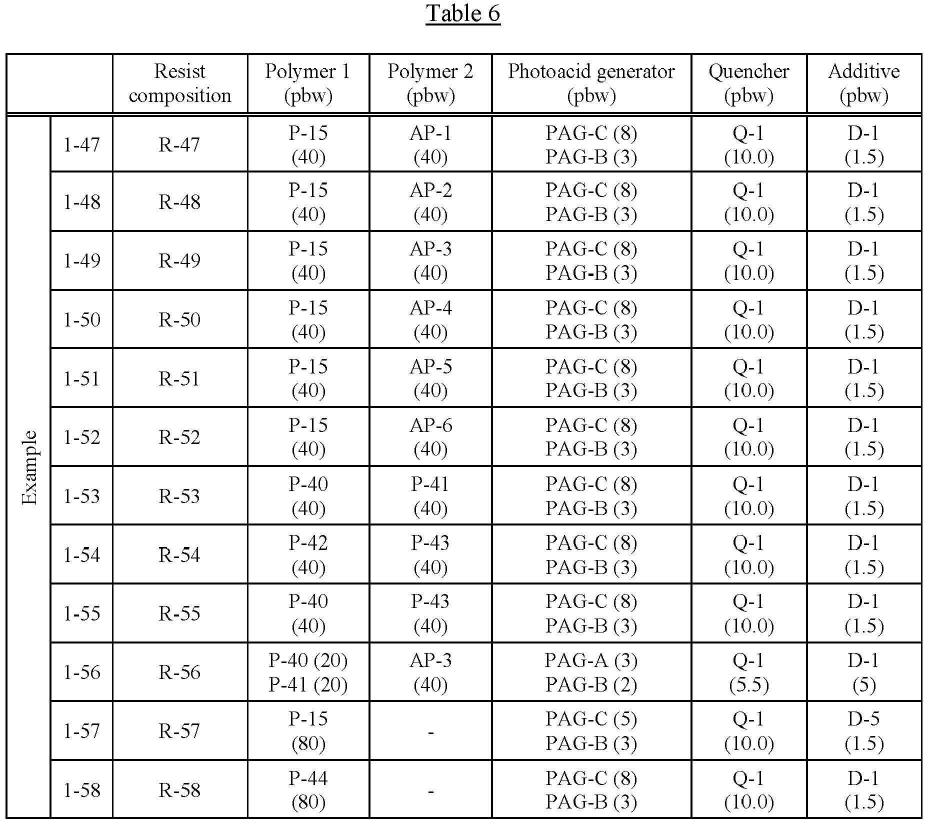

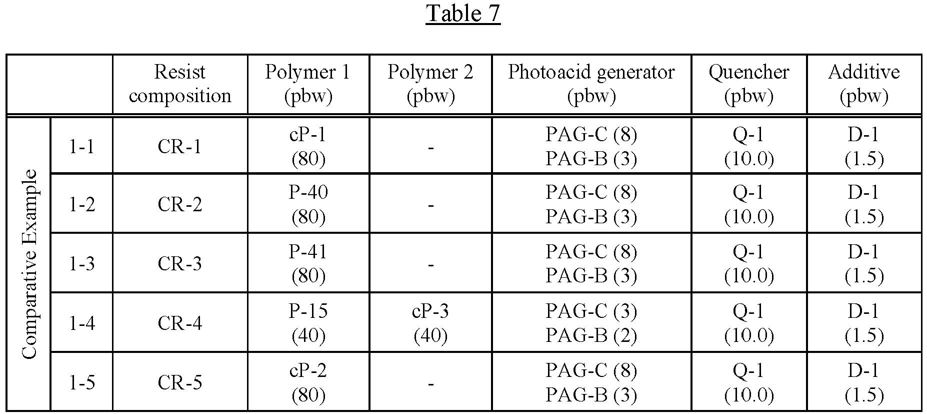

In Tables 4 to 7, quenchers Q-1 to Q-3, photoacid generators PAG-A to PAG-C, and polymers D-1 to D-5 have the structures shown below.

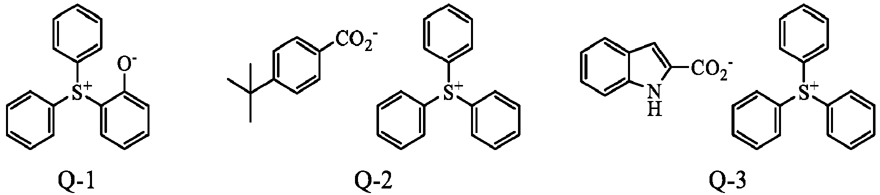

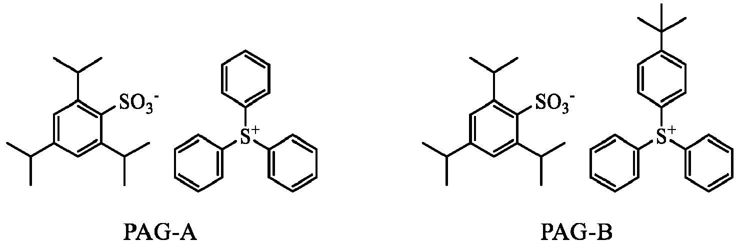

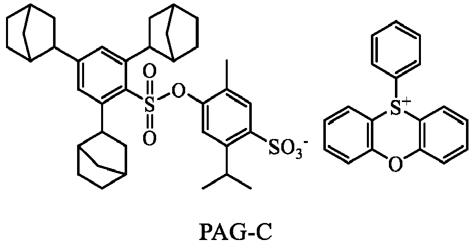

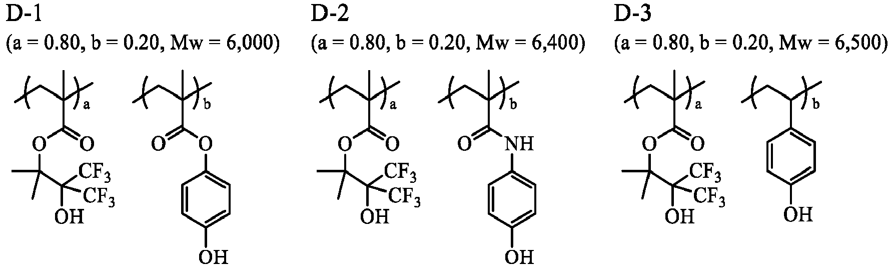

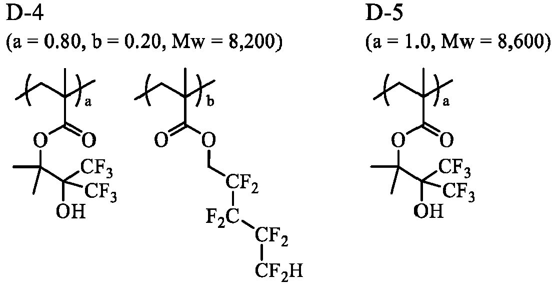

### [3] EB lithography test

### Examples 2-1 to 2-57 and Comparative Examples 2-1 to 2-4

Using a coater/developer system ACT-M (Tokyo Electron Ltd.), each of the chemically amplified positive resist compositions (R-1 to R-57, CR-1 to CR-4) was spin coated onto a photomask blank of 152 mm squares having the outermost surface of chromium and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1:1 resolution at the top and bottom of a 200-nm 1:1 line-and-space (LS) pattern. The LS resolution (or maximum resolution) was defined as the minimum line width of a 200-nm L/S pattern that could be resolved at the optimum dose. The edge roughness (LER) of a 200-nm LS pattern was measured under SEM. The develop loading was evaluated by forming a 200-nm LS pattern at the dose (µC/cm²) capable of resolving a 1:1 LS pattern of 200 nm design at a ratio 1: 1 and a 200-nm LS pattern including dummy patterns having a density of 15%, 25%, 33%, 45%, 50%, 55%, 66%, 75%, 85%, and 95% arranged around the center pattern, measuring the size of spaces under SEM, and comparing the size difference among grouped and isolated patterns. Also, the pattern was visually observed to judge whether or not the profile was rectangular.

The dissolution rate of an over-exposed region is computed by spin coating the resist solution onto a 8-inch silicon wafer, baking at 110°C for 60 seconds to form a resist film of 90 nm thick, exposing the resist film to KrF excimer laser radiation in a dose (mJ/cm²) capable of resolving a 200-nm 1:1 LS pattern at a ratio 1:1, baking at 110°C for 60 seconds, developing the film in a 2.38 wt% TMAH aqueous solution at 23°C, and measuring a loss of film thickness by means of a resist development rate analyzer (RDA-800 by Litho Tech Japan Corp.). The results are shown in Tables 8 to 10.

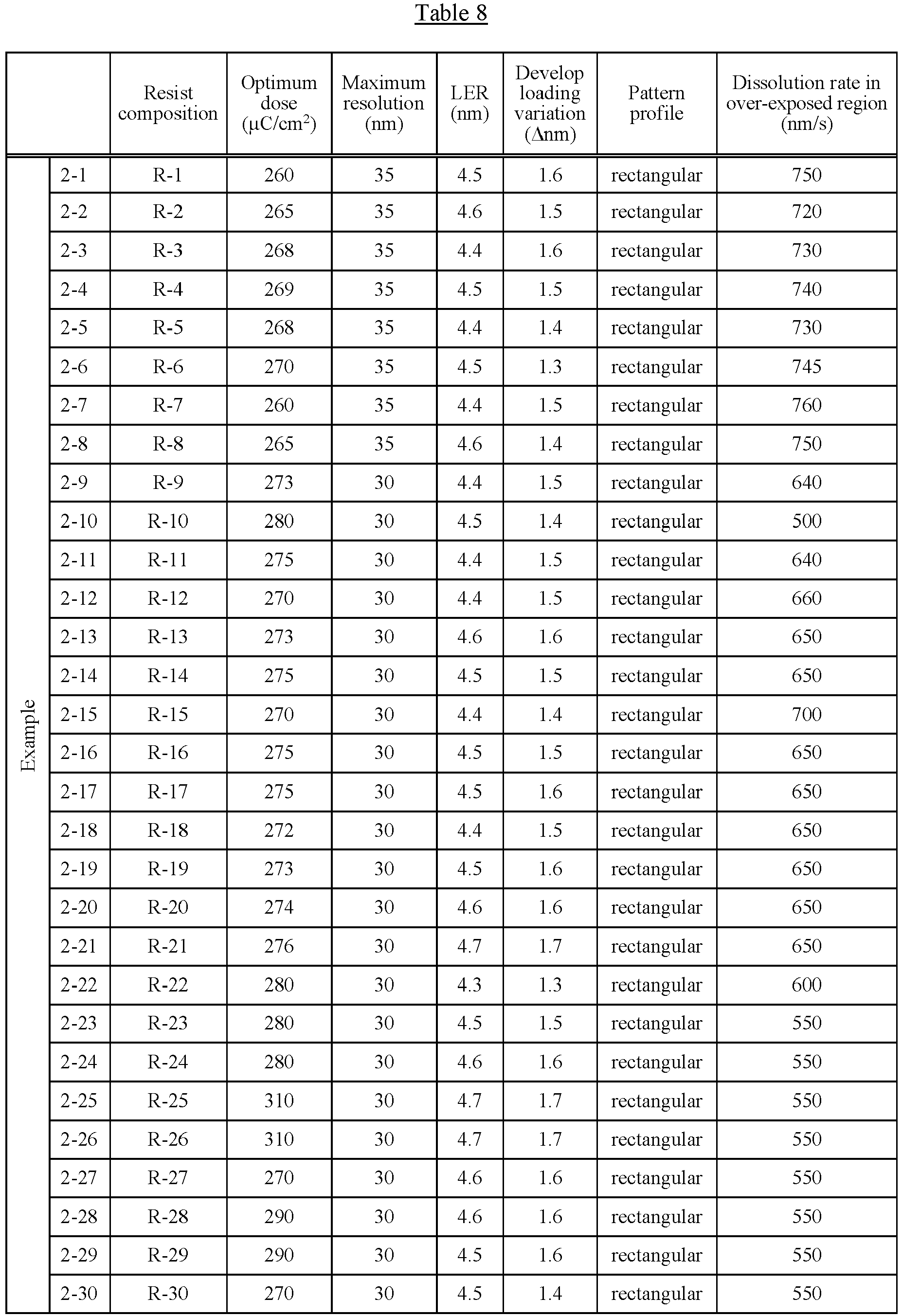

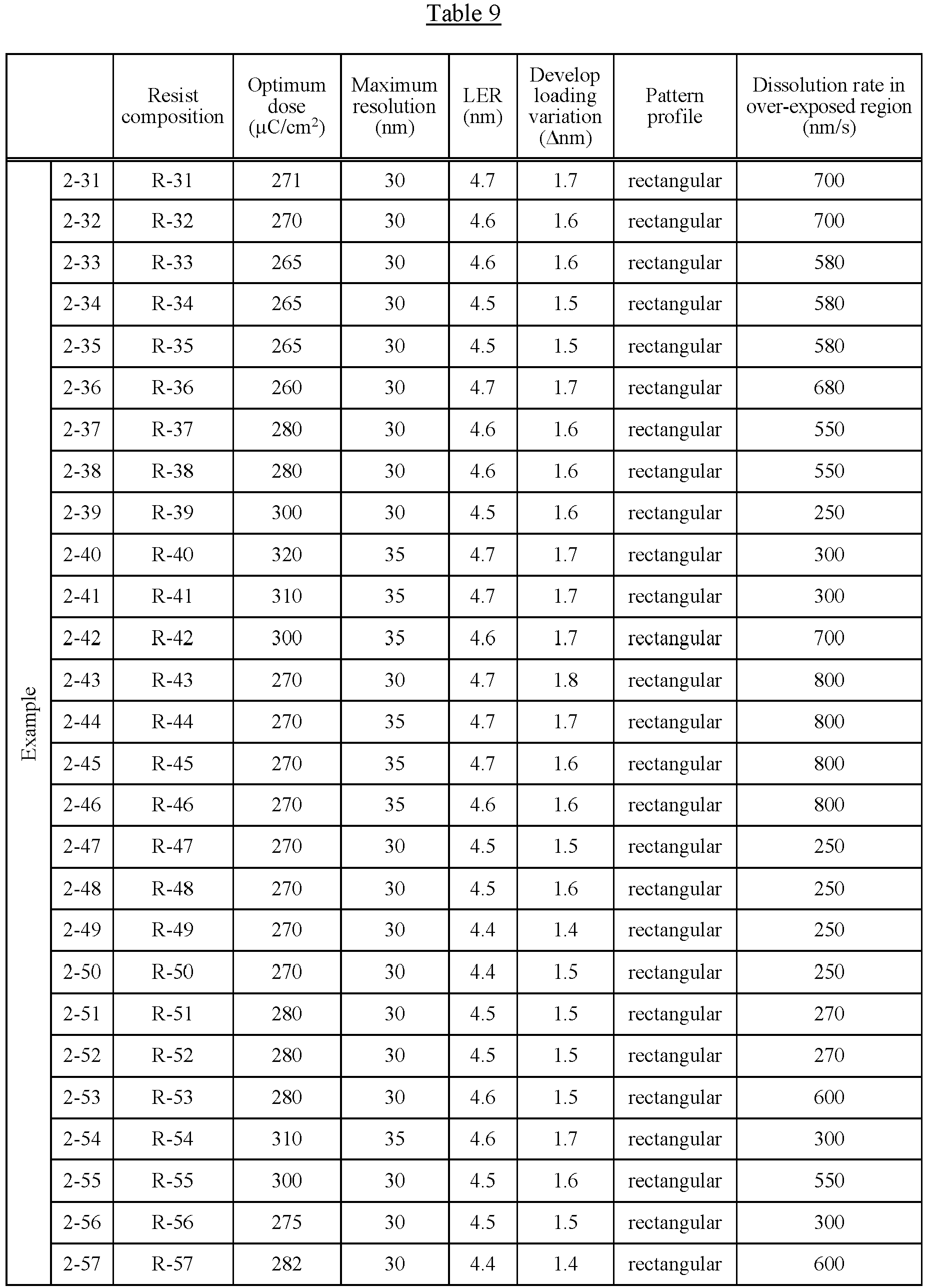

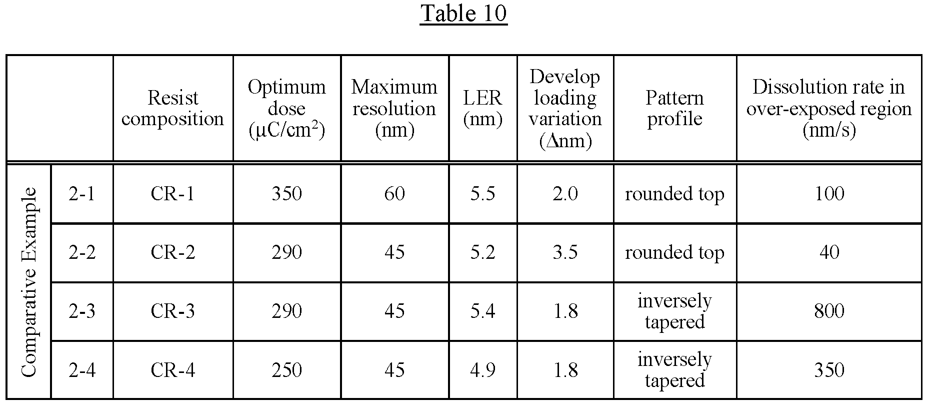

### [4] Evaluation of etching resistance

### Examples 3-1 to 3-3 and Comparative Example 3-1

Each of the chemically amplified resist compositions (R-9, R-22, R-58, CR-5) was spin-coated onto a mask blank of 152 mm square having a chromium outermost surface and baked on a hotplate at 110°C for 600 seconds to form a resist film of 120 nm thick. The film thickness was measured by an optical film thickness measurement system NanoSpec (Nanometrics Inc.). Measurement was carried out at 81 in-plane points on the blank substrate excluding an outer rim portion extending 10 mm inward from the blank circumference. From these measurements, an average film thickness and a film thickness range were determined. Using a dry etching equipment UNAXIS G4, the coated blank was dry etched under the conditions shown below. A film thickness loss rate (Å/sec) was computed from the thickness of the remaining film at the end of etching. The results are shown in Table 11.

| | |
|---|---|
| RF1 (RIE): | pulse 700 V |
| RF2 (ICP): | CW 400 W |
| Pressure: | 6 mTorr |
| Cl₂: | 185 sccm |
| O₂: | 55 sccm |
| He: | 9.25 sccm |
| Etching time: | 75 sec |

**Table 11**

| | | Resist composition | Film thickness loss rate [Å/sec] |
|---|---|---|---|
| Example | 3-1 | R-9 | 6.7 |
| | 3-2 | R-22 | 5.8 |
| | 3-3 | R-58 | 7.4 |
| Comparative Example | 3-1 | CR-5 | 8.3 |

All the chemically amplified positive resist compositions (R-1 to R-57) within the scope of the invention show satisfactory resolution, reduced LER, rectangular pattern profile, and controlled values of develop loading. Of the comparative resist compositions (CR-1 to CR-4), composition CR-1 has so high an over-exposed region dissolution rate that the pattern has a top-rounded profile and a low resolution. Composition CR-2 has so low an over-exposed region dissolution rate that the control of develop loading is insufficient. In compositions CR-3 and CR-4, because the design of base polymers is insufficient, not all resolution, LER and pattern rectangularity are met although the develop loading is fully controlled. This is accounted for by the design of base polymers. That is, avoiding a PAG-bound polymer framework and combining a phenolic acid-labile group with an acrylic acid-labile group are successful in optimizing a pattern profile due to phenolic units and optimizing an exposed region dissolution rate due to acrylic units. As a result, all resolution, LER, pattern rectangularity, and develop loading control are achieved. In the dry etching test, compositions R-9, R-22 and R-58 show better etching resistance than composition CR-5, indicating that an aromatic ring structure content of at least 65 mol% in the base polymer is effective in mask processing.

The resist pattern forming process using the chemically amplified positive resist composition is effective in photolithography for the fabrication of semiconductor devices and the processing of photomask blanks of transmission and reflection types.

Japanese Patent Application No. 2021-206280 is incorporated herein by reference.

Although some preferred embodiments have been described, many modifications and variations may be made thereto in light of the above teachings. It is therefore to be understood that the invention may be practiced otherwise than as specifically described without departing from the scope of the appended claims.

## Claims

1. A chemically amplified positive resist composition comprising a base polymer protected with an acid labile group and adapted to turn alkali soluble under the action of acid, wherein
said base polymer contains a polymer comprising a phenolic hydroxy group-containing unit, a unit containing a phenolic hydroxy group protected with an acid labile group, and a unit containing a carboxy group protected with an acid labile group, or a polymer comprising a phenolic hydroxy group-containing unit and a unit containing a phenolic hydroxy group protected with an acid labile group and a polymer comprising a phenolic hydroxy group-containing unit and a unit containing a carboxy group protected with an acid labile group,
the phenolic hydroxy group-containing unit is a repeat unit having the following formula (A1), the unit containing a phenolic hydroxy group protected with an acid labile group is a repeat unit having the following formula (A2), and the unit containing a carboxy group protected with an acid labile group is a repeat unit having the following formula (A3),
the aromatic ring-containing repeat units account for at least 65 mol% of the overall repeat units of the polymer in said base polymer, 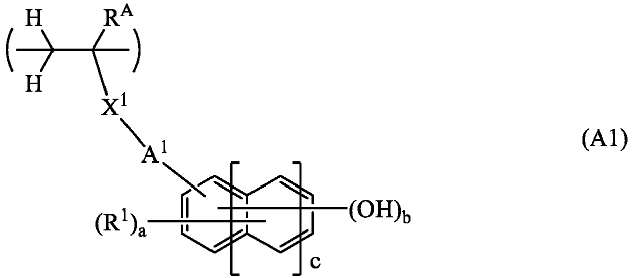
wherein a is an integer satisfying 0 ≤ a ≤ 5+2c-b, b is an integer of 1 to 3, c is an integer of 0 to 2,
R^{A} is hydrogen, fluorine, methyl or trifluoromethyl,
X¹ is a single bond, *-C(=O)-O- or *-C(=O)-NH-, * designates a point of attachment to the carbon atom in the backbone,
A¹ is a single bond or a C₁-C₁₀ saturated hydrocarbylene group in which some constituent -CH₂- may be replaced by -O-,
R¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group, 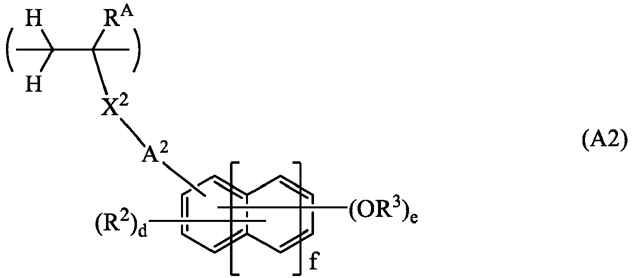
wherein R^{A} is as defined above,
d is an integer satisfying 0 ≤ d ≤ 5+2f-e, e is an integer of 1 to 3, f is an integer of 0 to 2,
X² is a single bond, *-C(=O)-O- or *-C(=O)-NH-, * designates a point of attachment to the carbon atom in the backbone,
A² is a single bond or a C₁-C₁₀ saturated hydrocarbylene group in which some constituent -CH₂- may be replaced by -O-,
R² is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
R³ is an acid labile group when e is 1, or hydrogen or an acid labile group, at least one R³ being an acid labile group, when e is 2 or 3, 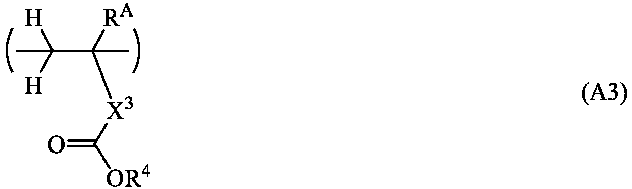
wherein R^{A} is as defined above,
X³ is a single bond, phenylene group, naphthylene group or ^{∗}-C(=O)-O-X^{3A}-,
wherein X^{3A} is a C₁-C₂₀ saturated hydrocarbylene group which may contain a hydroxy moiety, ether bond, ester bond or lactone ring, or a phenylene or naphthylene group, * designates a point of attachment to the carbon atom in the backbone, and
R⁴ is an acid labile group.

2. The positive resist composition of claim 1 wherein the phenolic hydroxy group-containing unit is a repeat unit having the following formula (A1-1): 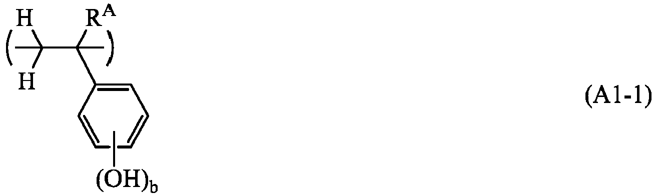 wherein R^{A} and b are as defined above.

3. The positive resist composition of claim 1 or 2 wherein the unit containing a phenolic hydroxy group protected with an acid labile group is a repeat unit having the following formula (A2-1): 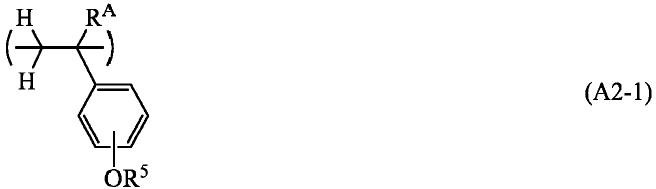 wherein R^{A} is as defined above, and R⁵ is an acid labile group having a C₆-C₂₀ aromatic hydrocarbon moiety and/or C₅-C₂₀ alicyclic hydrocarbon moiety.

4. The positive resist composition of any one of claims 1 to 3 wherein the unit containing a carboxy group protected with an acid labile group is a repeat unit having the following formula (A3-1): 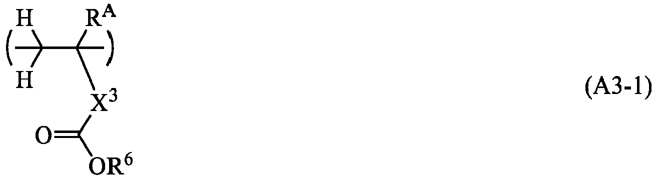 wherein R^{A} and X³ are as defined above, and R⁶ is an acid labile group having a C₆-C₂₀ aromatic hydrocarbon moiety and/or C₅-C₂₀ alicyclic hydrocarbon moiety.

5. The positive resist composition of any one of claims 1 to 3 wherein the unit containing a carboxy group protected with an acid labile group is a repeat unit having the following formula (A3-2): 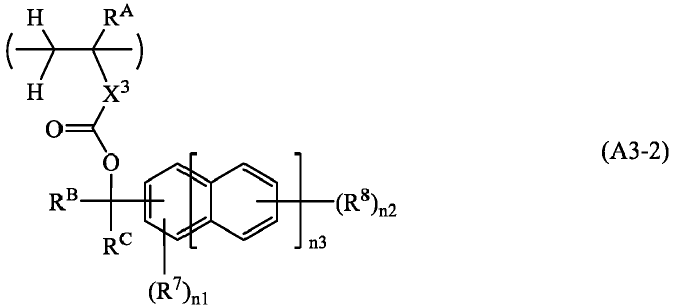 wherein R^{A} and X³ are as defined above,
R^{B} and R^{C} are each independently a C₁-C₁₀ hydrocarbyl group which may contain a heteroatom, R^{B} and R^{C} may bond together to form a ring with the carbon atom to which they are attached,
R⁷ is each independently fluorine, a C₁-C₅ fluorinated alkyl group or C₁-C₅ fluorinated alkoxy group,
R⁸ is each independently a C₁-C₁₀ hydrocarbyl group which may contain a heteroatom,
n1 is 1 or 2, n2 is an integer of 0 to 5, and n3 is an integer of 0 to 2.

6. The positive resist composition of claim 5 wherein the repeat unit having formula (A3-2) has the following formula (A3-3): 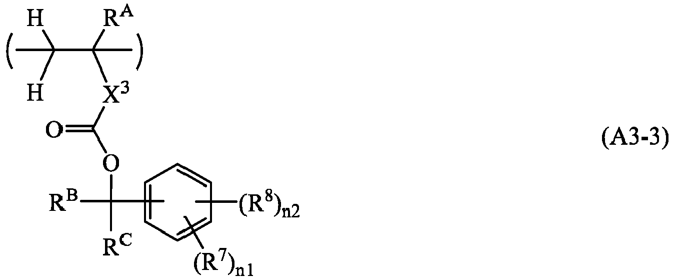 wherein R^{A}, R^{B}, R^{C}, X³, R⁷, R⁸, n1 and n2 are as defined above.

7. The positive resist composition of claim 5 or 6 wherein R⁷ is fluorine, trifluoromethyl or trifluoromethoxy.

8. The positive resist composition of any one of claims 1 to 7 wherein the polymer in said base polymer further comprises a repeat unit having any one of the following formulae (B 1) to (B3): 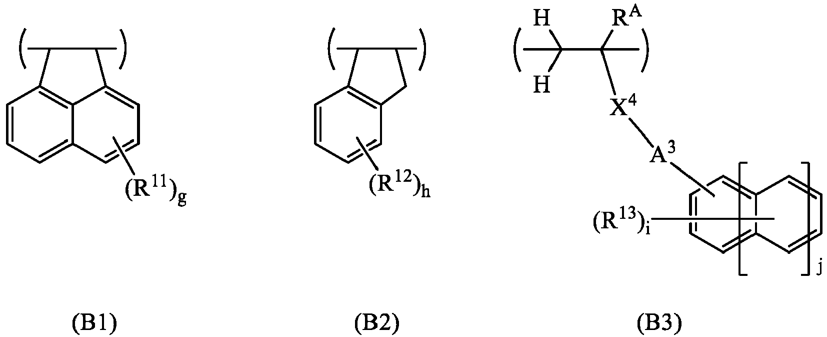 wherein R^{A} is as defined above,
g and h are each independently an integer of 0 to 4, i is an integer of 0 to 5, j is an integer of 0 to 2,
R¹¹ and R¹² are each independently a hydroxy group, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group,
R¹³ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group, R¹³ may also be hydroxy when j is 1 or 2,
X⁴ is a single bond, *-C(=O)-O- or *-C(=O)-NH-, * designates a point of attachment to the carbon atom in the backbone,
A³ is a single bond or a C₁-C₁₀ saturated hydrocarbylene group in which some constituent -CH₂- may be replaced by -O-.

9. The positive resist composition of claim 8 wherein the total of the repeat unit having formula (A1) and the repeat unit having any one of formulae (B 1) to (B3) is at least 50 mol% of the overall repeat units of the polymer in said base polymer.

10. The positive resist composition of any one of claims 1 to 9, further comprising a fluorinated polymer comprising repeat units of at least one type selected from repeat units having the following formula (C1), repeat units having the following formula (C2), repeat units having the following formula (C3), and repeat units having the following formula (C4) and optionally repeat units of at least one type selected from repeat units having the following formula (C5) and repeat units having the following formula (C6): 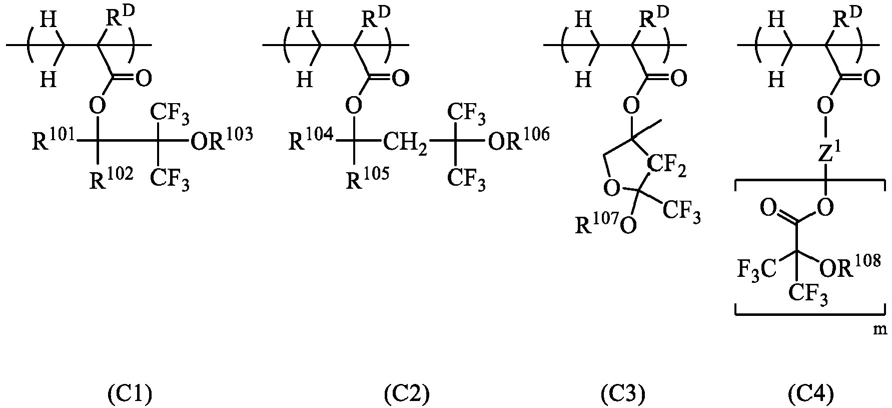 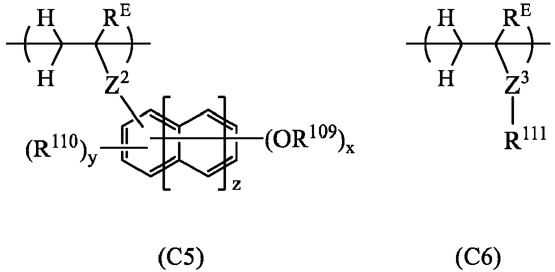 wherein R^{D} is each independently hydrogen, fluorine, methyl or trifluoromethyl,
R^{E} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen atom is substituted by fluorine and in which some constituent -CH₂- may be replaced by an ester bond or ether bond,
x is an integer of 1 to 3, y is an integer satisfying 0 ≤ y ≤ 5+2z-x, z is 0 or 1, m is an integer of 1 to 3,
Z¹ is a C₁-C₂₀ (m+1)-valent hydrocarbon group or C₁-C₂₀ (m+1)-valent fluorinated hydrocarbon group,
Z² is a single bond, *-C(=O)-O- or *-C(=O)-NH-, * designates a point of attachment to the carbon atom in the backbone,
Z³ is a single bond, -O-, ^{∗}-C(=O)-O-Z³¹-Z³²- or ^{∗}-C(=O)-NH-Z³¹-Z³²-, Z³¹ is a single bond or a C₁-C₁₀ saturated hydrocarbylene group, Z³² is a single bond, ester bond, ether bond or sulfonamide bond, * designates a point of attachment to the carbon atom in the backbone.

11. A resist pattern forming process comprising the steps of:
applying the chemically amplified positive resist composition of any one of claims 1 to 10 onto a substrate to form a resist film thereon,
exposing the resist film patternwise to high-energy radiation, and
developing the exposed resist film in an alkaline developer.

12. The process of claim 11 wherein the high-energy radiation is EUV or EB.

13. The process of claim 11 or 12 wherein the substrate has the outermost surface of a material containing at least one element selected from chromium, silicon, tantalum, molybdenum, cobalt, nickel, tungsten, and tin.

14. The process of any one of claims 11 to 13 wherein the substrate is a photomask blank.

15. A photomask blank which is coated with the chemically amplified positive resist composition of any one of claims 1 to 10.
